(19) Europäisches Patentamt
European Patent Office
Office européen des brevets

(11) EP 3 116 032 A1

(12) EUROPEAN PATENT APPLICATION
published in accordance with Art. 153(4) EPC

(43) Date of publication:
**11.01.2017 Bulletin 2017/02**

(21) Application number: **15758546.4**

(22) Date of filing: **26.02.2015**

(51) Int Cl.:
***H01L 29/786*** *(2006.01)* ***H01L 21/312*** *(2006.01)*
***H01L 21/336*** *(2006.01)* ***H01L 51/05*** *(2006.01)*
***H01L 51/30*** *(2006.01)*

(86) International application number:
**PCT/JP2015/055709**

(87) International publication number:
**WO 2015/133377 (11.09.2015 Gazette 2015/36)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **03.03.2014 JP 2014040901**

(71) Applicant: **Fujifilm Corporation**
**Minato-ku**
**Tokyo 106-8620 (JP)**

(72) Inventors:
- **TAKIZAWA, Hiroo**
  **Ashigarakami-gun, Kanagawa 258-8577 (JP)**
- **YOSHIDA, Hayato**
  **Ashigarakami-gun, Kanagawa 258-8577 (JP)**
- **KIMURA, Keizo**
  **Ashigarakami-gun, Kanagawa 258-8577 (JP)**
- **YOKOI, Kazuhiro**
  **Ashigarakami-gun, Kanagawa 258-8577 (JP)**

(74) Representative: **Hoffmann Eitle**
**Patent- und Rechtsanwälte PartmbB**
**Arabellastraße 30**
**81925 München (DE)**

# (54) ORGANIC THIN-FILM TRANSISTOR

(57) An organic thin-film transistor having, on a substrate, a gate electrode, an organic semiconductor layer, a gate insulating layer provided between the gate electrode and the organic semiconductor layer, a source electrode and a drain electrode provided in contact with the organic semiconductor layer and coupled together through the organic semiconductor layer, the organic semiconductor layer being provided in contact with a layer formed by the mircrophase separation of a block copolymer.

FIG. 1A

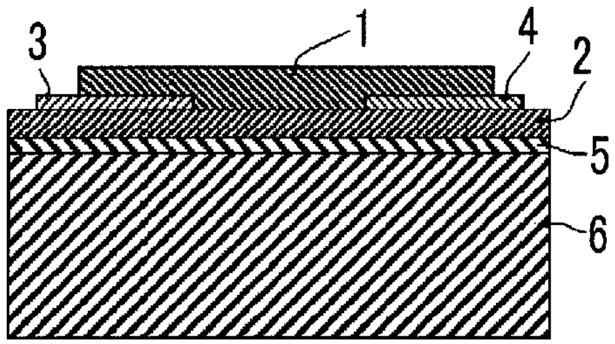


EP 3 116 032 A1

FIG. 1B

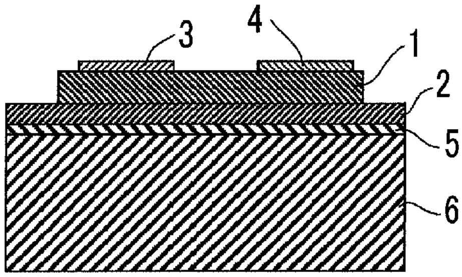


FIG. 1C

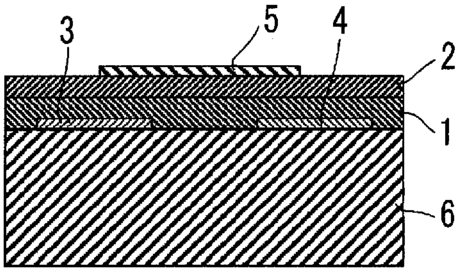


FIG. 1D

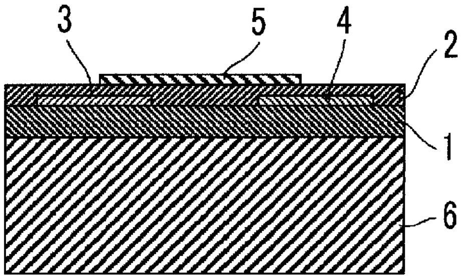

## Description

## BACKGROUND OF THE INVENTION

1. Field of the Invention

The present invention relates to an organic thin-film transistor.

2. Description of the Related Art

Most of display devices such as a liquid crystal display, an organic EL display, and an electrophoretic display have a thin-film transistor (hereinafter, also referred to as a "TFT") incorporated therein as a display switching device. A TFT has a structure, on a substrate, formed of a gate electrode, a semiconductor layer, and a gate insulating layer provided between the gate electrode and the semiconductor layer, and a source electrode and a drain electrode are further provided in contact with the semiconductor layer. The TFT is driven by applying a voltage to the gate electrode. By applying a voltage to the gate electrode, the amount of carriers formed of electrons or holes in a semiconductor is controlled so that the current flowing between the source electrode and the drain electrode is controlled.

In the related art, an inorganic semiconductor such as amorphous or polycrystalline thin-film silicon has been used for a semiconductor used for a TFT. However, in a case where a semiconductor layer of a TFT is formed of an inorganic semiconductor, a vacuum process or a high-temperature process carried out at 300°C or higher is required and thus improvement of productivity is restricted.

In contrast, a TFT using an organic semiconductor has become popular in recent years. Since an organic semiconductor layer can be formed using a method such as an ink-jet method, spin coating, or flexographic printing, the film-forming process can be efficiently performed at a low temperature such as room temperature, at a high speed, and at low cost.

For a gate insulating layer, silicon oxide obtained by thermally oxidizing silicon is used for most of TFTs in which an organic semiconductor is used for a semiconductor layer. In a case where a silicon oxide film is used, in order to bring out sufficient carrier conduction properties in an organic semiconductor that is formed on the silicon oxide film, the surface of the silicon oxide film is typically treated with hexamethyldisilazane (HMDS) or octadecyltrichlorosilane (OTS) so that the surface thereof is made water-repellent. Since hydroxyl groups on the surface of the silicon oxide film are quenched due to this surface treatment and a decrease in surface energy of the gate insulating film leads to improvement of the crystallinity of the semiconductor, carrier mobility is improved.

Moreover, it is known that a gate insulating layer may be made to have a phase-separated dielectric structure having a low dielectric constant polymer and a high dielectric constant polymer (JP2008-258610A).

## SUMMARY OF THE INVENTION

However, HMDS or OTS occasionally aggregates on the surface of a gate insulating film or polymerizes. In this case, crystal growth of a semiconductor is unlikely to occur and thus sufficient carrier mobility cannot be obtained.

Further, it is known to use polyimide, which is an organic polymer, for a gate insulating film. However, it is not easy to smooth the surface thereof and a sufficient carrier mobility has not been achieved.

Moreover, the compatibility of the gate insulating layer described in JP2008-258610A with the organic semiconductor layer is improved by performing phase separation on a polymer in a point shape or a rod shape, but it cannot be said that the carrier mobility is sufficient.

An object of the present invention is to provide a high-performance organic thin-film transistor which exhibits excellent carrier mobility and an excellent current amplification factor and is capable of more reliably performing a switching operation at a higher speed.

As a result of intensive research conducted by the present inventors in consideration of the above-described problems, it was found that crystal growth is promoted during the formation of an organic semiconductor layer and thus the crystal orientation is improved by providing the organic semiconductor layer in contact with a block copolymer layer having a microphase separation structure due to self-organization, in an organic thin-film transistor. In addition, it was also found that a TFT then exhibits an excellent carrier mobility and an excellent current amplification factor. The present invention was completed based on these findings.

The above-described objects are achieved by the following means.

[1] An organic thin-film transistor comprising, on a substrate, a gate electrode; an organic semiconductor layer; a gate insulating layer provided between the gate electrode and the organic semiconductor layer; and a source electrode and a drain electrode provided in contact with the organic semiconductor layer and connected to each

other through the organic semiconductor layer,
in which the organic semiconductor layer is provided in contact with a layer formed by microphase separation of a block copolymer.

[2] The organic thin-film transistor according to [1], in which the organic thin-film transistor has a bottom-gate form, and the layer formed by microphase separation of the block copolymer is provided between the gate insulating layer and the organic semiconductor layer.

[3] The organic thin-film transistor according to [1], in which the organic thin-film transistor has a bottom-gate form, and the gate insulating layer is the layer formed by microphase separation of the block copolymer.

[4] The organic thin-film transistor according to [2], in which the organic thin-film transistor has a bottom-gate form, and the gate insulating layer includes a random polymer having a monomer component which is the same as a monomer component constituting the block copolymer, as a constituent component.

[5] The organic thin-film transistor according to [4], in which the random polymer in the gate insulating layer has a cross-linked structure.

[6] The organic thin-film transistor according to [1], in which the organic thin-film transistor has a top-gate form, and the layer formed by microphase separation of the block copolymer is provided on the substrate.

[7] The organic thin-film transistor according to any one of [1], [2], and [6], in which an underlayer is provided on a side of the layer formed by microphase separation of the block copolymer opposite to a side where the organic semiconductor layer is provided.

[8] The organic thin-film transistor according to [7], in which the underlayer includes a random polymer having a monomer component which is the same as a monomer component constituting the block copolymer, as a constituent component.

[9] The organic thin-film transistor according to [8], in which the random polymer in the underlayer has a cross-linked structure.

[10] The organic thin-film transistor according to any one of [1] to [9], in which the microphase separation is lamellar phase separation.

[11] The organic thin-film transistor according to [10], in which the pitch size of the lamellar phase separation is 20 nm or less.

[12] The organic thin-film transistor according to any one of [1] to [11], in which the dispersity of the block copolymer is 1.20 or less.

[13] The organic thin-film transistor according to any one of [1] to [12], in which the number average molecular weight of the block copolymer is 25000 or less.

[14] The organic thin-film transistor according to any one of [1] to [12], in which the number average molecular weight of the block copolymer is 20000 or less.

[15] The organic thin-film transistor according to any one of [1] to [14], in which the block copolymer is at least one block copolymer selected from a styrene-(meth)acrylate ester block copolymer, a styrene-(meth)acrylate block copolymer, a styrene-dialkylsiloxane block copolymer, a styrene-alkylarylsiloxane block copolymer, a styrene-diarylsiloxane block copolymer, a styrene-silsesquioxane-substituted alkyl (meth)acrylate block copolymer, a (meth)acrylate ester-silsesquioxane-substituted alkyl (meth)acrylate block copolymer, a styrene-vinylpyridine block copolymer, a styrene-hydroxystyrene block copolymer, a styrene-ethylene oxide block copolymer, and a vinylnaphthalene-(meth)acrylate ester block copolymer.

[16] The organic thin-film transistor according to any one of [1] to [14], in which the block copolymer includes a block formed of a repeating unit represented by the following Formula (I) and a block formed of a repeating unit represented by the following Formula (II).

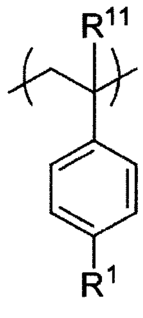

(I)

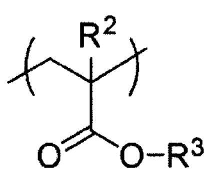

(II)

In Formula (I), $R^1$ represents a hydrogen atom, an alkyl group, an alkenyl group, an alkynyl group, a cycloalkyl

group, an aryl group, or an aralkyl group. $R^{11}$ represents a hydrogen atom or an alkyl group.

In Formula (II), $R^2$ represents a hydrogen atom, an alkyl group, or a cycloalkyl group. $R^3$ represents an alkyl group or a cycloalkyl group.

[17] The organic thin-film transistor according to [16], in which the block formed of the repeating unit represented by Formula (II) is a block formed of a repeating unit represented by any of the following Formulae (II-1), (II-2), and (II-3).

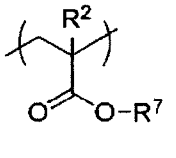

(II-1)

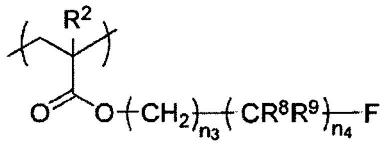

(II-2)

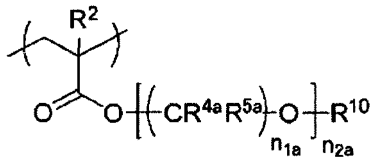

(II-3)

In Formulae (II-1), (II-2), and (III-3), $R^2$ has the same definition as that for $R^2$ in Formula (II). $R^{4a}$ and $R^{5a}$ represent a hydrogen atom or a methyl group. $R^7$ represents an unsubstituted alkyl group having 1 to 12 carbon atoms or an unsubstituted cycloalkyl group having 3 to 12 carbon atoms. $R^8$ and $R^9$ represent a hydrogen atom or a fluorine atom. In this case, at least one of $R^8$ or $R^9$ represents a fluorine atom. $R^{10}$ represents a hydrogen atom, an alkyl group, a cycloalkyl group, or an aryl group. $n_{1a}$ represents an integer of 2 to 4. $n_{2a}$ represents an integer of 1 to 6, $n_3$ represents 1 or 2, and $n_4$ represents an integer of 1 to 8.

[18] The organic thin-film transistor according to [16] or [17], in which an absolute value of a difference between an SP value of the repeating unit represented by Formula (I) and an SP value of the repeating unit represented by Formula (II) is in a range of 0.5 $MPa^{1/2}$ to 4.0 $MPa^{1/2}$.

[19] The organic thin-film transistor according to any one of [15] to [18], in which the block copolymer includes a crosslinkable group-containing monomer component, and the block copolymer in the microphase separation layer has a cross-linked structure.

In the present specification, when a plurality of substituents or linking groups (hereinafter, referred to as substituents or the like) shown by specific symbols are present or a plurality of substituents are defined simultaneously or alternatively, this means that the respective substituents may be the same as or different from each other. The same applies to the regulation of the number of substituents or the like. Moreover, in a case where there is a repetition of a plurality of partial structures which are displayed in the same manner in the formula, the respective partial structures or repeating units may be the same as or different from each other. In addition, even in a case where not specifically stated, when a plurality of substituents or the like are adjacent (particularly, neighboring) to each other, they may be condensed or linked to each other and form a ring.

In regard to compounds (including polymers) described in the present specification, the description includes salts thereof and ions thereof in addition to the compounds. Further, the description includes partially changed structures within the range in which desired effects are exhibited.

In the present specification, substituents (the same applies to linking groups) in which substitution or non-substitution is not specified may further include substituents within the range in which desired effects are exhibited. The same applies to compounds in which substitution or non-substitution is not specified.

For example, the term block copolymer includes an unsubstituted block copolymer and a block copolymer having a substituent. Here, a substituent may be included in the main chain that forms a molecular chain of a block copolymer or in a side chain branching from the main chain.

Accordingly, for example, α-methylstyrene is a main-chain methyl substituent of styrene, but a block copolymer which has styrene preferably includes a block copolymer having α-methylstyrene, based on the above-described viewpoint.

In addition, the numerical ranges shown using "to" in the present specification indicate ranges including the numerical values shown before and after "to" as the lower limits and the upper limits.

The organic thin-film transistor of the present invention shows excellent carrier mobility and an excellent current amplification factor and is capable of more reliably performing a switching operation at a higher speed.

The above-described and other features and advantages of the present invention will become apparent from the description below with reference to the accompanying drawings.

## BRIEF DESCRIPTION OF THE DRAWINGS

Figs. 1A to 1D are views schematically illustrating an organic thin-film transistor according to preferred embodiments of the present invention.

## DESCRIPTION OF THE PREFERRED EMBODIMENTS

Hereinafter, the present invention will be described in detail.

[Organic thin-film transistor]

Embodiments of an organic thin-film transistor of the present invention (hereinafter, also simply referred to as an "OTFT of the present invention) will be described in detail below.

The OTFT of the present invention includes, on a substrate, a gate electrode; an organic semiconductor layer; a gate insulating layer provided between the gate electrode and the organic semiconductor layer; and a source electrode and a drain electrode provided in contact with the organic semiconductor layer and connected to each other through the organic semiconductor layer. When a voltage is applied to the gate electrode, a channel of a current is formed on the interface between a semiconductor layer, positioned between the source electrode and the drain electrode, and a layer adjacent to the semiconductor layer. That is, the current flowing between the source electrode and the drain electrode is controlled according to the input voltage applied to the gate electrode.

The preferred embodiments of the OTFT according to the present invention will be described with reference to the accompanying drawings. The respective drawings illustrating the OTFT are schematic views for facilitating understanding the present invention, and the size or the relative magnitude relation of each member is occasionally changed for the sake of convenience. Each member is not illustrated in actual scale. Moreover, the present invention is not limited to the outer shapes or shapes illustrated in the figures except definitions described in the present invention. For example, in Figs. 1A and 1B, the gate electrode does not necessarily cover the entire substrate and the form in which the gate electrode is provided in the central portion of the substrate is also preferable as the OTFT of the present invention.

Figs. 1A to 1D are respectively longitudinal sectional views schematically illustrating the OTFT according to preferred exemplary embodiments of the present invention. In Figs. 1A to 1D, the reference numeral 1 indicates an organic semiconductor layer, the reference numeral 2 indicates a gate insulating layer, the reference numeral 3 indicates a source electrode, the reference numeral 4 indicates a drain electrode, the reference numeral 5 indicates a gate electrode, and the reference numeral 6 indicates a substrate.

Further, Fig. 1A illustrates a bottom-gate bottom-contact type OTFT, Fig. 1B illustrates a bottom-gate top-contact type OTFT, Fig. 1C illustrates a top-gate bottom-contact type OTFT, and Fig. 1D illustrates a top-gate top-contact type OTFT. The OTFT of the present invention has all of the above-described four types. Although not illustrated, an overcoat layer is formed on the uppermost portion (on the opposite side of the substrate 6) of the surface of each OTFT in some cases.

In the OTFT of the present invention, the organic semiconductor layer is provided in contact with a layer formed by microphase separation (hereinafter, also simply referred to as a "'microphase separation layer") of a block copolymer (not illustrated). The microphase separation is a phenomenon in which a block copolymer forms microscopic phase separation at several nanometers to several hundreds of nanometers and preferably several nanometers to several tens of nanometers due to a difference of properties of respective blocks constituting the block copolymer. The structure of the block copolymer will be described later.

In a case where the OTFT of the present invention is a bottom-gate type OTFT, the following embodiments (a) and (b) can be exemplified as the OTFT of the present invention and the following embodiment of (a) is more preferable.

(a) An embodiment in which a microphase separation layer is provided on the gate insulating layer 2 and an organic semiconductor layer is provided directly on the microphase separation layer:

In the case of (a), the microphase separation layer may be provided directly on the gate insulating layer 2 or may be provided in contact with an underlayer by providing the underlayer on the gate insulating layer 2. It is preferable that the underlayer contains a random polymer (hereinafter, referred to as a "random polymer A") having a monomer component, as a constituent component, which is the same as the monomer component constituting a block copolymer that forms the microphase separation layer placed thereon and more preferable that the underlayer is configured of the random polymer A. The molar ratio of respective monomer components in the random monomer A may be the same as or different from the molar ratio of the monomer components in the corresponding block copolymer.

Moreover, in the case where the microphase separation layer is provided directly on the gate insulating layer 2, it is preferable that the gate insulating layer 2 contains a random polymer (hereinafter, referred to as a "random polymer B") having a monomer component, as a constituent component, which is the same as the monomer component constituting the block copolymer that forms the microphase separation layer placed thereon and more preferable

that the gate insulating layer 2 is configured of the random polymer B. The molar ratio of respective monomer components in the random monomer B may be the same as or different from the molar ratio of the monomer components in the corresponding block copolymer.

In a case where the random polymers A and B have a crosslinkable group such as an epoxy group or an oxetane group as described below, a cross-linked structure is formed by heating the random polymers in the presence of an acid catalyst (for example, a thermal acid generator such as diphenyl iodonium hexafluorophosphate) or a curing agent (for example, a compound having two or more active hydrogen atoms such as a diamine, dicarboxylic acid, or bisphenol). When the random polymers A and B have a cross-linked structure, solvent resistance is improved. For this reason, even when the block copolymer is dissolved in a solvent and a layer containing the random polymer A or B is coated with the solution for film formation and a microphase separation layer is formed, the layer containing the random polymer A or B is unlikely to be affected by the solvent and thus the producibility or performance stability of the OTFT is further improved.

In the case where the random polymers A and B have a cross-linked structure, the amount of crosslinkable group-containing monomer components in the random polymers A and B is preferably in a range of 1% by mole to 20% by mole and more preferably in a range of 1% by mole to 10% by mole with respect to the molar amount of the total monomer components.

(b) An embodiment in which the gate insulating layer 2 is formed of the microphase separation layer and the organic semiconductor layer is provided directly on the microphase separation layer.

The layer thickness of the microphase separation layer is not particularly limited as long as the microphase separation occurs, and the thickness thereof is preferably in a range of 10 nm to 250 nm, more preferably in a range of 20 nm to 200 nm, and still more preferably in a range of 20 nm to 100 nm. Moreover, in a case where the underlayer is provided, the layer thickness of the underlayer is preferably in a range of 5 nm to 2000 nm and more preferably in a range of 10 nm to 1000 nm.

Further, in a case where the microphase separation is lamellar phase separation, the pitch of the lamellar phase separation is preferably in a range of 5 nm to 100 nm, more preferably in a range of 10 nm to 50 nm, and still more preferably in a range of 10 nm to 20 nm. When the pitch of the lamellar phase separation is small, the crystal grain size of the organic semiconductor provided thereon can be increased. Further, the crystal orientation can be also improved.

In the case where the OTFT of the present invention is a top-gate type OTFT, the microphase separation layer (not illustrated) is provided on the substrate 6 and the organic semiconductor layer is provided directly on the microphase separation layer. In this case, the microphase separation layer may be provided directly on the substrate 6 or may be provided in contact with an underlayer by providing the underlayer on the substrate 6. It is preferable that the underlayer contains a random polymer (hereinafter, referred to as a "random polymer C") having a monomer component, as a constituent component, which is the same as the monomer component constituting a block copolymer that forms the microphase separation layer placed thereon and more preferable that the underlayer is configured of the random polymer C. The molar ratio of respective monomer components in the random monomer C may be the same as or different from the molar ratio of the monomer components in the corresponding block copolymer.

It is also preferable that the random polymer C includes a crosslinkable group such as an epoxy group or an oxetane group. A preferred embodiment of a method of forming a cross-linked structure is the same as described in the section of the random polymers A and B.

The weight average molecular weight and the number average molecular weight of the random polymers A, B, and C are respectively preferably in a range of 3,000 to 1,000,000, more preferably in a range of 10,000 to 800,000, and still more preferably in a range of 20,000 to 600,000.

It is preferable that the microphase separation layer is a layer formed by lamellar phase separation of a block copolymer. The lamellar phase separation is a form in which a block copolymer is phase-separated into a line shape along the plane of a layer. The line shape may be linear or curved. A guide pattern is provided on a layer which becomes an underlayer of the microphase separation layer and the microphase separation layer can be formed on the layer for which the guide pattern is provided in order to obtain a desired lamellar phase separation structure. Examples of a method of forming the guide pattern include a rubbing treatment, a lithography method, a photopolymerization method or a photocrosslinking method using polarization or interference exposure, and a photoisomerization method, but the present invention is not limited thereto. From the viewpoint of simplifying the process, it is preferable the layer formed by microphase separation of a block copolymer of the present invention is formed without providing the guide pattern.

<Block copolymer>

A block copolymer constituting the microphase separation layer is described below.

A block copolymer may be formed of two kinds or three or more kinds of blocks. Plural kinds of blocks constituting a block copolymer are not particularly limited as long as the blocks are combined in a manner in which the lamellar

phase separation occurs, but it is preferable that the blocks in combination are incompatible with each other. For example, in a case where a block copolymer is formed of two kinds of blocks, the absolute value of a difference in the solubility parameter (SP value) between two kinds of blocks is preferably in a range of 0.5 $MPa^{1/2}$ to 4.0 $MPa^{1/2}$ and more preferably in a range of 0.5 $MPa^{1/2}$ to 3.0 $MPa^{1/2}$.

The "solubility parameter (SP value)" in the present specification can be acquired by a Hansen method. The Hansen method is a known method of calculating the SP value in the related art, and the SP value is written using a multidimensional vector formed of a dispersion term, a polar term, and a hydrogen bond term. The SP value of Hansen can be predicted by a method described in Int. J. Thermophys, 2008, 29, pp. 568 to 585 and the SP value described in the present specification is a value predicted by a method described in this literature.

In the present specification, the SP value of a specific block of a block copolymer is set as an SP value of a repeating unit constituting the specific block (in other words, a homopolymer formed of only a specific repeating unit, in this case, a crosslinkable group described below may be introduced to some of monomer components). For example, the SP value of a repeating unit (styrene unit) of polystyrene is 20.8 $MPa^{1|2}$ and the SP value of a repeating unit (methyl methacrylate unit) of polymethylmethacrylate is 20.5 $MPa^{1/2}$, and thus the absolute value of a difference in the SP values between blocks of a copolymer formed by bonding two blocks of polystyrene and polymethylmethacrylate is 0.3 $MPa^{1/2}$.

Further, in a case where a specific block includes a monomer component having a crosslinkable group described below when the SP value of the specific block is calculated, a monomer unit having this crosslinkable group is treated as non-existent. That is, in a case where a specific block includes a monomer unit having a crosslinkable group, the SP value of the specific block is calculated using the specific block as a block formed of a repeating unit configured of monomer units from which monomer units having a crosslinkable group are removed.

The mass ratio of respective blocks constituting a block copolymer is not particularly limited, but the ratio between the number average molecular weights of respective blocks in the block copolymer formed of two kinds of blocks is preferably in a range of 25:75 to 75:25, more preferably in a range of 40:60 to 60:40, and still more preferably in a range of 45:55 to 55:45. In this manner, the lamellar phase separation structure which is a preferred form of phase separation can be more reliably and efficiently formed.

In the block copolymer used in the present invention, it is also preferable that a crosslinkable group is introduced to some of monomer components constituting the block copolymer. The crosslinkable group is not particularly limited as long as a cross-linked structure can be introduced to the block copolymer, and a group selected from an epoxy group and an oxetane group can be suitably used. In this case, a cross-linked structure is formed by heating the block copolymers in the presence of preferably an acid catalyst (for example, a thermal acid generator such as diphenyl iodonium hexafluorophosphate) or a curing agent (for example, a compound having two or more active hydrogen atoms such as a diamine, dicarboxylic acid, or bisphenol). Therefore, a cross-linked structure can be formed at the same time when the block copolymer is heated for microphase separation.

Since the solvent resistance is improved when the block copolymer, which forms the microphase separation layer, has a cross-linked structure, the block copolymer is unlikely to be affected by a solvent constituting a coating solution when coated with an organic semiconductor layer for film formation and thus the producibility or performance stability of the OTFT is further improved.

In the case where the block copolymer forming the microphase separation layer has a cross-linked structure, the amount of crosslinkable group-containing monomer components is preferably in a range of 1% by mole to 20% by mole and more preferably in a range of 1% by mole to 10% by mole with respect to the molar amount of the total monomer components constituting the block copolymer.

Examples of the block copolymer used in the present invention include a block copolymer obtained by bonding a block formed of a repeating unit having styrene or a styrene derivative as a monomer component to a block formed of a repeating unit having (meth)acrylic acid ester as a monomer component; a block copolymer obtained by bonding a block formed of a repeating unit having styrene or a styrene derivative as a monomer component to a block formed of polysiloxane or a polysiloxane derivative; and a block copolymer obtained by bonding a block formed of polyalkylene oxide to a block formed of a repeating unit having (meth)acrylic acid ester as a monomer component.

It is preferable that the (meth)acrylic acid ester serving as a monomer component of the block copolymer of the present invention is selected from (meth)acrylic acid alkyl ester and (meth)acrylic acid hydroxyalkyl ester. The number of carbon atoms of an alkyl group of the (meth)acrylic acid alkyl ester is preferably in a range of 1 to 10. The alkyl group may be linear, branched, or cyclic. Further, the number of carbon atoms of a hydroxyalkyl group of the (meth)acrylic acid hydroxyalkyl ester is preferably in a range of 1 to 10.

Specific examples of the (meth)acrylic acid ester include methyl (meth)acrylate, ethyl (meth)acrylate, propyl (meth)acrylate, cyclohexyl (meth)acrylate, octyl (meth)acrylate, nonyl (meth)acrylate, hydroxyethyl (meth)acrylate, hydroxypropyl (meth)acrylate, benzyl (meth)acrylate, anthracenyl (meth)acrylate, glycidyl (meth)acrylate, 3,4-epoxycyclohexylmethyl (meth)acrylate, and 3-(trimethoxysilyl)propyl (meth)acrylate.

Examples of the styrene derivative include 2-methyl styrene, 3-methyl styrene, 4-methyl styrene, 4-t-butylstyrene, 4-n-octylstyrene, 2,4,6-trimethylstyrene, 4-methoxystyrene, 4-t-butoxystyrene, 4-hydroxystyrene, 4-nitrostyrene,

3-nitrostyrene, 4-chlorostyrene, 4-fluorostyrene, 4-acetoxy vinyl styrene, 4-vinyl benzyl chloride, 1-vinyl naphthalene, 4-vinyl biphenyl, 9-vinyl anthracene, and α-methyl styrene.

Examples of the polysiloxane derivative include dimethyl polysiloxane, diethyl polysiloxane, diphenyl polysiloxane, and methyl phenyl polysiloxane.

Examples of the polyalkylene oxide include polyethylene oxide, polypropylene oxide, polyisopropyl oxide, and polybutylene oxide.

Preferred examples of the block copolymer used in the present invention include block copolymers described below.

Preferred examples thereof include a styrene-alkyl (meth)acrylate block copolymer (the number of carbon atoms of an alkyl group of alkyl (meth)acrylate is preferably in a range of 1 to 12, more preferably in a range of 1 to 8, and still more preferably in a range of 1 to 4); a styrene-(meth)acrylic acid block copolymer; a styrene-dialkylsiloxane block copolymer (the number of carbon atoms of an alkyl group of dialkylsiloxane is preferably in a range of 1 to 12, more preferably in a range of 1 to 8, and still more preferably in a range of I to 4); a styrene-alkylarylsiloxane block copolymer (the number of carbon atoms of an alkyl group of alkylarylsiloxane is preferably in a range of 1 to 12, more preferably in a range of 1 to 8, and still more preferably in a range of 1 to 4, and the number of carbon atoms of an aryl group of polyalkylarylsiloxane is preferably in a range of 6 to 20, more preferably in a range of 6 to 15, and still more preferably in a range of 6 to 12, and a phenyl group is even still more preferable); a styrene-diarylsiloxane block copolymer (the number of carbon atoms of an aryl group of diarylsiloxane is preferably in a range of 6 to 20, more preferably in a range of 6 to 15, and still more preferably in a range of 6 to 12, and a phenyl group is even still more preferable); a styrene-POSS-substituted alkyl (meth)acrylate block copolymer (the number of carbon atoms of an alkyl group of POSS-substituted alkyl (meth)acrylate is preferably in a range of 1 to 12, more preferably in a range of 1 to 8, and still more preferably in a range of 1 to 4); an alkyl (meth)acrylate-POSS-substituted alkyl (meth)acrylate block copolymer (the number of carbon atoms of an alkyl group of alkyl (meth)acrylate and POSS-substituted alkyl (meth)acrylate is preferably in a range of 1 to 12, more preferably in a range of 1 to 8, and still more preferably in a range of 1 to 4);
a styrene-vinyl pyridine block copolymer;
a styrene-hydroxystyrene block copolymer;
a styrene-ethylene oxide block copolymer; and
a vinyl naphthalene-alkyl (meth)acrylate block copolymer.

The "POSS" indicates silsesquioxane. In other words, it is preferable that the block copolymer used in the present invention is a copolymer having a silsesquioxane structure described in JP2012-036078A.

Further, the respective block copolymers described as the preferred examples above include those having the above-described crosslinkable groups (preferably an epoxy group or an oxetane group) in some of monomer components constituting the blocks thereof.

The block copolymers are commercially available (products manufactured by Polymer Source Inc.) or may be synthesized by a known method using radical polymerization or anionic polymerization.

The weight average molecular weight (Mw) of the block copolymer used in the present invention is preferably in a range of 3000 to 300000, more preferably in a range of 5000 to 100000, and still more preferably in a range of 8000 to 70000.

Moreover, the number average molecular weight (Mn) of the block copolymer used in the present invention is preferably 100000 or less, more preferably 50000 or less, still more preferably 25000 or less, and even still more preferably 20000 or less. The pitch of the lamellar phase separation can be made small as the Mn of the block copolymer becomes smaller. The crystal grain size of the organic semiconductor provided on the lamellar phase separation layer can be increased as the pitch of the lamellar phase separation layer becomes smaller, and thus the crystal orientation is improved. Therefore, the carrier mobility of the OTFT can be further improved. In addition, the Mn of the block copolymer used in the present invention is preferably 3000 or greater, more preferably 5000 or greater, and still more preferably 6000 or greater.

The dispersity (Mw/Mn) of the block copolymer used in the present invention is preferably in a range of 1.0 to 1.5, more preferably 1.2 or less, still more preferably in a range of 1.0 to 1.2, and even still more preferably in a range of 1.0 to 1.15. From the viewpoint of easily forming the phase separation structure, the dispersity of the block copolymer used in the present invention is 1.15 or less and more preferably 1.10 or less.

In the present specification, the Mw and Mn can be acquired using HLC-8120 (manufactured by TOSOH CORPORATION), TSK gel Multipore HXL-M (manufactured by TOSOH CORPORATION, 7.8 mmHD x 30.0 cm) as a column, and tetrahydrofuran (THF) or N-methyl-2-pyrrolidone (NMP) as an eluent. Moreover, the Mw and Mn are values in terms of polystyrene.

In order to lower the dispersity (that is, monodisperse) of the block copolymer, it is preferable to use known living anionic polymerization or living radical polymerization. Between them, it is preferable to use living anionic polymerization. Further, as described in JP2009-67999A, it is preferable to perform the living anionic polymerization using a microreactor synthesis device (flow reaction system).

It is preferable that the block copolymer used in the present invention has a structure having a block formed of a repeating unit represented by the following Formula (I) and a block formed of a repeating unit represented by the following Formula (II).

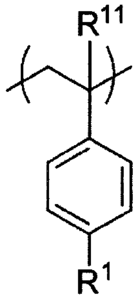

(I)

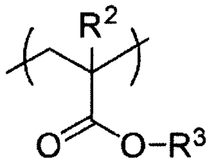

(II)

In Formula (I), $R^1$ represents a hydrogen atom, an alkyl group, an alkenyl group, an alkynyl group, a cycloalkyl group, an aryl group, or an aralkyl group. $R^1$ may be bonded to a carbon atom adjacent to the carbon atom, to which $R^1$ is bonded, to be condensed with a benzene ring.

The above-described alkyl group, alkenyl group, alkynyl group, cycloalkyl group, aryl group, or aralkyl group as $R^1$ may further include a substituent. Examples of the substituent include an alkoxy group (preferably an alkoxy group having 1 to 10 carbon atoms, more preferably an alkoxy group having 1 to 5 carbon atoms, and still more preferably an ethoxy group or a methoxy group), a hydroxyl group, a halogen atom (such as a fluorine atom or a chlorine atom), a nitro group, an acyl group (preferably an acyl group having 2 to 10 carbon atoms, more preferably an acyl group having 2 to 5 carbon atoms, and still more preferably an acyl group having 2 or 3 carbon atoms), an acyloxy group (preferably an acyloxy group having 2 to 10 carbon atoms, more preferably an acyloxy group having 2 to 5 carbon atoms, and still more preferably an acyloxy group having 2 or 3 carbon atoms), an acylamino group (preferably an acylamino group having 2 to 10 carbon atoms, more preferably an acylamino group having 2 to 5 carbon atoms, and still more preferably an acylamino group having 2 or 3 carbon atoms), a sulfonylamino group, a dialkylamino group (preferably a dialkylamino group having 2 to 20 carbon atoms, more preferably a dialkylamino group having 2 to 10 carbon atoms, and still more preferably a diethylamino group or a dimethylamino group), an alkylthio group (preferably an alkylthio group having 1 to 10 carbon atoms, more preferably an alkylthio group having 1 to 5 carbon atoms, and still more preferably an ethylthio group or a methylthio group), an arylthio group (preferably an arylthio group having 6 to 20 carbon atoms, more preferably an arylthio group having 6 to 15 carbon atoms, and still more preferably a phenylthio group or a naphthyl group), an aralkylthio group (preferably an aralkyl group having 7 to 20 carbon atoms and more preferably an aralkyl group having 7 to 15 carbon atoms), a thienylcarbonyloxy group, a thienylmethylcarbonyloxy group, and a heterocyclic residue such as a pyrrolidone residue. The expression "$R^1$ has the above-described substituent" includes both cases where some of a plurality of $R^1$'s in repeating units have the above-described substituent and all of the plurality of $R^1$'s have the above-described substituent. Moreover, the plurality of $R^1$'s may have substituents different from each other.

In a case where $R^1$ represents an alkyl group, the number of carbon atoms thereof is preferably in a range of 1 to 12, more preferably in a range of 2 to 9, and still more preferably in a range of 4 to 6. In the case where $R^1$ represents an alkyl group, an unsubstituted alkyl group is preferable. The alkyl group may be linear or branched.

In a case where $R^1$ represents an alkenyl group or an alkynyl group, the number of carbon atoms thereof is preferably in a range of 2 to 12, more preferably in a range of 2 to 9, and still more preferably in a range of 4 to 6.

In a case where $R^1$ represents a cycloalkyl group, the number of carbon atoms thereof is preferably in a range of 3 to 12, more preferably in a range of 3 to 9, and still more preferably in a range of 3 to 6. In the case where $R^1$ represents a cycloalkyl group, an unsubstituted cycloalkyl group is preferable.

In a case where $R^1$ represents an aryl group, the number of carbon atoms thereof is preferably in a range of 6 to 12 and more preferably in a range of 6 to 9. In the case where $R^1$ represents an aryl group, an unsubstituted aryl group is preferable.

In a case where R1 represents an aralkyl group, the number of carbon atoms thereof is preferably in a range of 7 to 12 and more preferably in a range of 7 to 9.

When the number of carbon atoms in $R^1$ is in the above-described range, the hydrophobicity of a repeating unit represented by Formula (I) is further increased. Accordingly, the phase separation between the block formed of a repeating unit represented by Formula (I) and the block formed of a repeating unit represented by Formula (II) can be further improved.

In the case where $R^1$ is bonded to a carbon atom (that is, a carbon atom positioned in an ortho position with

respect to the carbon atom to which $R^1$ is bonded) adjacent to the carbon atom, to which $R^1$ is bonded, to be condensed with a benzene ring in Formula (I), it is preferable that a ring structure including $R^1$ condensed with the benzene ring in Formula (I) is a benzene ring (that is, it is preferable that a naphthalene ring is formed as a whole condensed ring structure).

$R^{11}$ in Formula (1) represents a hydrogen atom or an alkyl group. It is preferable that $R^{11}$ represents a hydrogen atom or a methyl group.

When $R^{11}$ represents a hydrogen atom, it is preferable that $R^1$ represents any of an alkyl group, an alkenyl group, an alkynyl group, a cycloalkyl group, an aryl group, or an aralkyl group, more preferable that $R^1$ represents an alkyl group or an aryl group, still more preferable that $R^1$ represents an alkyl group, and even still more preferable that $R^1$ represents a t-butyl group.

When $R^{11}$ represents an alkyl group, it is preferable that $R^1$ represents a hydrogen atom or an alkyl group and preferable that $R^1$ represents a hydrogen atom.

In Formula (II), $R^2$ represents a hydrogen atom, an alkyl group, or a cycloalkyl group.

The alkyl group and the cycloalkyl group as $R^2$ may further include a substituent. Specific examples of the substituent include an alkoxy group (preferably an alkoxy group having 1 to 10 carbon atoms, more preferably an alkoxy group having 1 to 5 carbon atoms, and still more preferably an ethoxy group or a methoxy group), a hydroxyl group, a halogen atom (such as a fluorine atom or a chlorine atom), a nitro group, an acyl group (preferably an acyl group having 2 to 10 carbon atoms, more preferably an acyl group having 2 to 5 carbon atoms, and still more preferably an acyl group having 2 or 3 carbon atoms), an acyloxy group (preferably an acyloxy group having 2 to 10 carbon atoms, more preferably an acyloxy group having 2 to 5 carbon atoms, and still more preferably an acyloxy group having 2 or 3 carbon atoms), an acylamino group (preferably an acylamino group having 2 to 10 carbon atoms, more preferably an acylamino group having 2 to 5 carbon atoms, and still more preferably an acylamino group having 2 or 3 carbon atoms), a sulfonylamino group, a dialkylamino group (preferably a dialkylamino group having 2 to 20 carbon atoms, more preferably a dialkylamino group having 2 to 10 carbon atoms, and still more preferably a diethylamino group or a dimethylamino group), an alkylthio group (preferably an alkylthio group having 1 to 10 carbon atoms, more preferably an alkylthio group having 1 to 5 carbon atoms, and still more preferably an ethylthio group or a methylthio group), an arylthio group (preferably an arylthio group having 6 to 20 carbon atoms, more preferably an arylthio group having 6 to 15 carbon atoms, and still more preferably a phenylthio group or a naphthyl group), an aralkylthio group (preferably an aralkyl group having 7 to 20 carbon atoms and more preferably an aralkyl group having 7 to 15 carbon atoms), a thienylcarbonyloxy group, a thienylmethylcarbonyloxy group, and a heterocyclic residue such as a pyrrolidone residue. The expression "$R^2$ has the above-described substituent" includes both cases where some of a plurality of $R^2$'s in repeating units have the above-described substituent and all of the plurality of $R^2$'s have the above-described substituent. Moreover, the plurality of $R^2$'s may have substituents different from each other.

It is preferable that the alkyl group and the cycloalkyl group as $R^2$ are unsubstituted.

From the viewpoints of raising the glass transition point (Tg) of the block copolymer and stably maintaining the phase separation structure of the block copolymer that has once been formed, it is preferable that $R^2$ represents an alkyl group (preferably an alkyl group having 1 to 12 carbon atoms, more preferably an alkyl group having 1 to 8 carbon atoms, and still more preferably an alkyl group having 1 to 4 carbon atoms) or a cycloalkyl group (preferably a cycloalkyl group having 3 to 12 carbon atoms and more preferably a cycloalkyl group having 3 to 8 carbon atoms), more preferable that $R^2$ represents an alkyl group having 1 to 4 carbon atoms, and still more preferable that $R^2$ represents a methyl group.

In Formula (II), $R^3$ represents an alkyl group or a cycloalkyl group.

The alkyl group and the cycloalkyl group as $R^3$ may further include a substituent. Specific examples of the substituent include an alkoxy group (preferably an alkoxy group having 1 to 10 carbon atoms, more preferably an alkoxy group having 1 to 5 carbon atoms, and still more preferably an ethoxy group or a methoxy group), a hydroxyl group, a halogen atom (such as a fluorine atom or a chlorine atom), a nitro group, an acyl group (preferably an acyl group having 2 to 10 carbon atoms, more preferably an acyl group having 2 to 5 carbon atoms, and still more preferably an acyl group having 2 or 3 carbon atoms), an acyloxy group (preferably an acyloxy group having 2 to 10 carbon atoms, more preferably an acyloxy group having 2 to 5 carbon atoms, and still more preferably an acyloxy group having 2 or 3 carbon atoms), an acylamino group (preferably an acylamino group having 2 to 10 carbon atoms, more preferably an acylamino group having 2 to 5 carbon atoms, and still more preferably an acylamino group having 2 or 3 carbon atoms), a sulfonylamino group, a dialkylamino group (preferably a dialkylamino group having 2 to 20 carbon atoms, more preferably a dialkylamino group having 2 to 10 carbon atoms, and still more preferably a diethylamino group or a dimethylamino group), an alkylthio group (preferably an alkylthio group having 1 to 10 carbon atoms, more preferably an alkylthio group having 1 to 5 carbon atoms, and still more preferably an ethylthio group or a methylthio group), an arylthio group (preferably an arylthio group having 6 to 20 carbon atoms, more preferably an arylthio group having 6 to 15 carbon atoms, and still more preferably a phenylthio group or a naphthyl group), an aralkylthio group (preferably an aralkyl group having 7 to 20 carbon atoms and more preferably an aralkyl group having 7 to 15 carbon atoms), a thienylcarbonyloxy group, a thienylmethylcarbonyloxy group, a heterocyclic residue such as a pyrrolidone residue, an epoxy group, and an oxetane group.

The expression "$R^3$ has the above-described substituent" includes both cases where some of a plurality of $R^3$'s

in repeating units have the above-described substituent and all of the plurality of $R^3$'s have the above-described substituent. Moreover, the plurality of $R^3$'s may have substituents different from each other. In the case where $R^3$ includes a substituent, it is preferable that the substituent is a halogen atom or a group having an oxygen atom or a sulfur atom (such as an alkoxy group or an alkylthio group).

In a case where $R^3$ represents an alkyl group, the number of carbon atoms thereof is preferably in a range of 1 to 12, more preferably in a range of 1 to 8, and still more preferably in a range of 1 to 4, and a methyl group or an ethyl group is even still more preferable.

Further, it is preferable that $R^3$ represents an alkyl group substituted with halogen and particularly preferable that $R^3$ represents an alkyl group substituted with a fluorine atom. In this case, $R^3$ is represented by the following Formula (II-2).

Moreover, in a case where $R^3$ represents a cycloalkyl group, the number of carbon atoms thereof is preferably in a range of 3 to 12 and more preferably in a range of 3 to 8.

It is preferable that the block formed of a repeating unit represented by Formula (II) is a block formed of a repeating unit represented by any of the following Formulae (II-1), (II-2), and (II-3) and more preferable that the block formed of a repeating unit represented by Formula (II) is a block formed of a repeating unit represented by the following Formula (II-2) or (II-3).

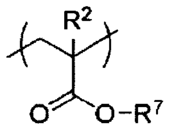

(II-1)

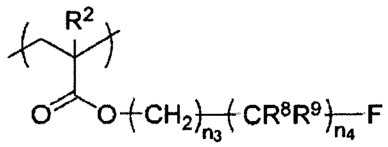

(II-2)

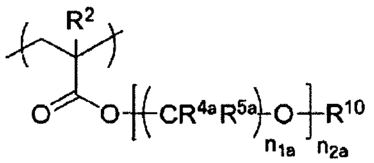

(II-3)

In Formulae (II-1), (II-2), and (II-3), $R^2$ has the same definition as that for $R^2$ in Formula (II), and the preferable form thereof is also the same as described above.

In Formula (II-1), $R^7$ represent an unsubstituted alkyl group having 1 to 12 carbon atoms or an unsubstituted cycloalkyl group having 3 to 12 carbon atoms. In the case where $R^7$ represents an unsubstituted alkyl group, the number of carbon atoms thereof is preferably in a range of 1 to 8 and more preferably in a range of 1 to 4. It is preferable that $R^7$ represents a methyl group or an ethyl group. In addition, in the case where $R^7$ represents an unsubstituted cycloalkyl group, the number of carbon atoms thereof is preferably in a range of 4 to 10 and more preferably in a range of 5 to 8. It is more preferable that $R^7$ represents a cyclohexyl group.

In Formula (II-2), $R^8$ and $R^9$ represent a hydrogen atom or a fluorine atom. In this case, at least one of $R^8$ or $R^9$ represents a fluorine atom. It is more preferable that both of $R^8$ and $R^9$ represent a fluorine atom.

In Formula (II-2), n3 represents 1 or 2 and preferably 1. n4 represents an integer of 1 to 8. n4 represents more preferably an integer of 1 to 6, still more preferably an integer of 1 to 4, and even still more preferably 1 or 2.

In Formula (II-3), $R^{4a}$ and $R^{5a}$ represent a hydrogen atom or a methyl group. From the viewpoint of improving the phase separation between the block formed of a repeating unit represented by Formula (I) and the block formed of a repeating unit represented by Formula (II-3), it is preferable that $R^{4a}$ and $R^{5a}$ represent a hydrogen atom.

In Formula (II-3), $R^{10}$ represents a hydrogen atom, an alkyl group, a cycloalkyl group, or an aryl group.

n1a represents an integer of 2 to 4. n2a represents an integer of 1 to 6.

In Formula (11-3), the alkyl group and the cycloalkyl group as $R^{10}$ may include a substituent. Preferred examples of the substituent include an alkoxy group (preferably an alkoxy group having 1 to 10 carbon atoms, more preferably an alkoxy group having 1 to 5 carbon atoms, and still more preferably an ethoxy group or a methoxy group), a hydroxyl group, a halogen atom (such as a fluorine atom or a chlorine atom), a nitro group, an acyl group (preferably an acyl group having 2 to 10 carbon atoms, more preferably an acyl group having 2 to 5 carbon atoms, and still more preferably an acyl group having 2 or 3 carbon atoms), an acyloxy group (preferably an acyloxy group having 2 to 10 carbon atoms, more preferably an acyloxy group having 2 to 5 carbon atoms, and still more preferably an acyloxy group having 2 or 3 carbon atoms), an acylamino group (preferably an acylamino group having 2 to 10 carbon atoms, more preferably an acylamino group having 2 to 5 carbon atoms, and still more preferably an acylamino group having 2 or 3 carbon atoms), a sulfonylamino group, a dialkylamino group (preferably a dialkylamino group having 2 to 20 carbon atoms, more preferably a dialkylamino group having 2 to 10 carbon atoms, and still more preferably a diethylamino group or a dimethylamino group), an alkylthio group (preferably an alkylthio group having 1 to 10 carbon atoms, more preferably an alkylthio group having 1 to 5 carbon atoms, and still more preferably an ethylthio group or a methylthio group), an arylthio group (preferably an arylthio group having 6 to 20 carbon atoms, more preferably an arylthio group having 6 to 15 carbon atoms, and still more preferably a phenylthio group or a naphthyl group), an aralkylthio group (preferably an aralkyl group having 7 to 20 carbon atoms and more preferably an aralkyl group having 7 to 15 carbon atoms), a thienylcarbonyloxy

group, a thienylmethylcarbonyloxy group, a heterocyclic residue such as a pyrrolidone residue, an epoxy group, and an oxetane group.

The expression "$R^{10}$ has the above-described substituent" includes both cases where some of a plurality of $R^{10}$'s in repeating units have the above-described substituent and all of the plurality of $R^{10}$'s have the above-described substituent. Moreover, the plurality of $R^{10}$'s may have substituents different from each other.

In a case where $R^{10}$ represents an alkyl group, the number of carbon atoms thereof is preferably in a range of 1 to 12, more preferably in a range of 1 to 8, and still more preferably in a range of 1 to 4. In the case where $R^{10}$ represents an alkyl group, it is more preferable that $R^{10}$ represents an ethyl group or a methyl group.

In a case where $R^{10}$ represents a cycloalkyl group, the number of carbon atoms thereof is preferably in a range of 3 to 12 and more preferably in a range of 3 to 8. In the case where $R^{10}$ represents a cycloalkyl group, it is more preferable that $R^{10}$ represents a cyclohexyl group.

In a case where the block copolymer used in the present invention has a block formed of a repeating unit represented by Formula (I) and a block formed of a repeating unit represented by the following Formula (II), the block copolymer used in the present invention may include another repeating unit which is not represented by Formula (I) or (II), but it is preferable that the block copolymer used in the present invention has a structure formed by bonding the block formed of a repeating unit represented by Formula (I) to the block formed of a repeating unit represented by the following Formula (II).

The ratio (Formula (I):Formula (II)) of the number average molecular weight of the block formed of a repeating unit represented by Formula (I) to the number average molecular weight of the block formed of a repeating unit represented by Formula (II) is preferably in a range of 25:75 to 75:25, more preferably in a range of 40:60 to 60:40, and still more preferably in a range of 45:55 to 55:45. In this manner, the lamellar phase separation structure which is a preferred form of phase separation can be more reliably and efficiently formed.

Specific examples of the repeating unit represented by Formula (I) are described below, but the present invention is not limited thereto.

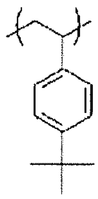
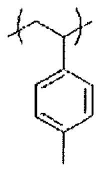
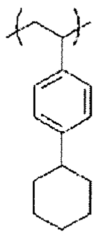
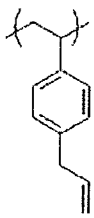
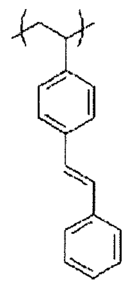
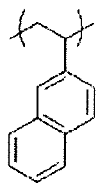
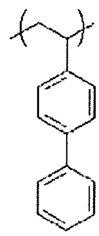

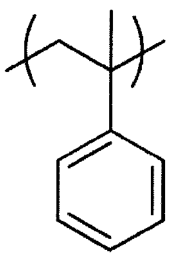

Specific examples of the repeating unit represented by Formula (II) are described below, but the present invention is not limited thereto. In the examples described below, Me represents methyl.

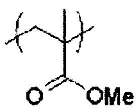
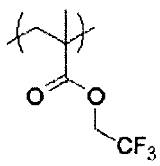
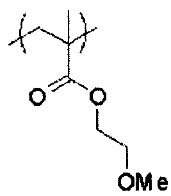
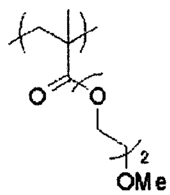
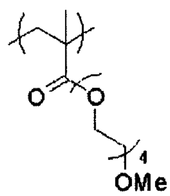
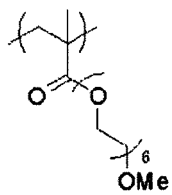

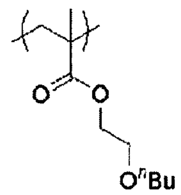
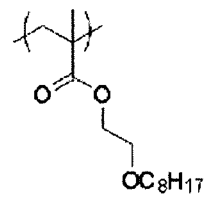
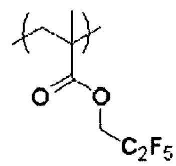
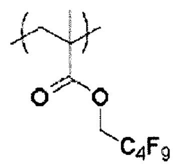
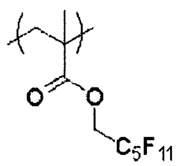
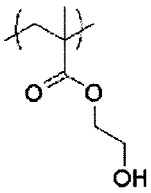

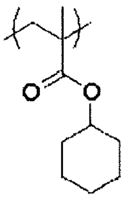
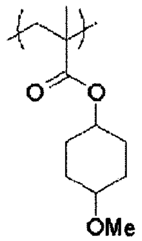
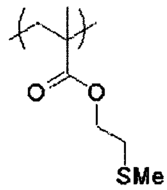

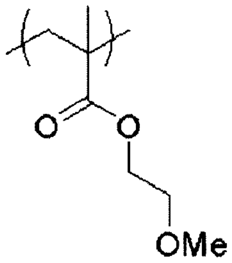
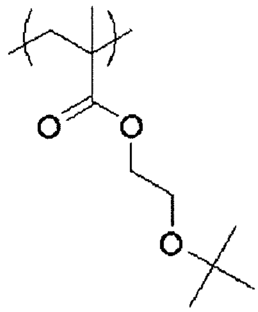
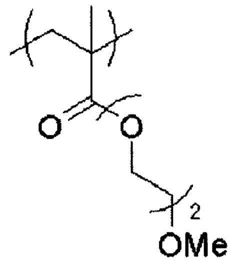
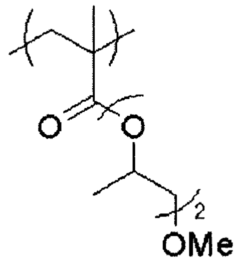

The absolute value of a difference between the SP value (SP value of the block formed of the repeating unit represented by Formula (I)) of the repeating unit represented by Formula (I) and the SP value (SP value of the block formed of the repeating unit represented by Formula (II)) of the repeating unit represented by Formula (II) is preferably in a range of 0.5 $MPa^{1/2}$ to 4.0 $MPa^{1/2}$.

Further, the absolute value of a difference between the SP value (SP value of the block formed of the repeating unit represented by Formula (III)) of the repeating unit represented by Formula (III) and the SP value (SP value of the block formed of the repeating unit represented by Formula (IV)) of the repeating unit represented by Formula (IV) is preferably in a range of 0.5 $MPa^{1/2}$ to 4.0 $MPa^{1/2}$.

When the difference between the solubility parameters (SP value) of the respective repeating units is in the above-described range, the phase separation of the block copolymer can be performed with higher quality and more efficiently.

Form the viewpoint of forming the lamellar phase separation layer using a block polymer having a lower molecular weight, that is, forming the lamellar phase separation layer at a finer pitch (the pitch size is proportional to 2/3rd power of the degree of polymerization), the absolute value of the difference between the solubility parameter (SP value) of the repeating unit represented by Formula (I) and the solubility parameter (SP value) of the repeating unit represented by Formula (II) is preferably in a range of 0.5 $MPa^{1/2}$ to 3.5 $MPa^{1/2}$ and more preferably in a range of 0.5 $MPa^{1/2}$ to 3.0 $MPa^{1/2}$.

Specific examples of a combination of repeating units of a block copolymer formed by bonding the block formed of the repeating unit represented by Formula (I) to the block formed of the repeating unit represented by Formula (II) are described below, but the present invention is not limited thereto. In the examples described below, the ratio (a, b) between repeating units indicates a mass ratio. Further, Me represents a methyl group and Ph represents a phenyl group. ΔSP indicates an absolute value of a difference in the SP value between blocks of respective repeating units.

BP−1

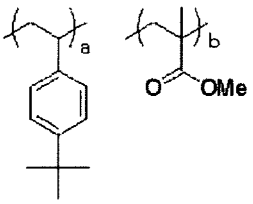

⊿SP=1. 3

(BP-1A): a=47wt%, b=53wt%, Mn=19700, Mw/Mn=1.05
(BP-1B): a=66wt%, b=34wt%, Mn=15400, Mw/Mn=1.06

BP−2

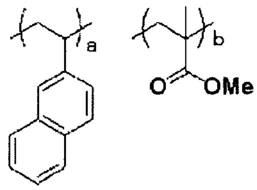

⊿SP=1. 5

(BP-2A): a=52wt%, b=48wt%, Mn=17200, Mw/Mn=1.15
(BP-2B): a=70wt%, b=30wt%, Mn=17900, Mw/Mn=1.17

BP−3

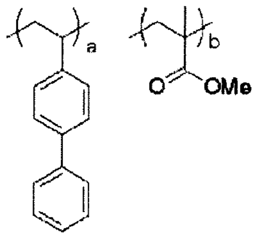

⊿SP=1. 8

(BP-3A): a=52wt%, b=48wt%, Mn=17900, Mw/Mn=1.08
(BP-3B): a=69wt%, b=31wt%, Mn=18500, Mw/Mn=1.09

BP−5

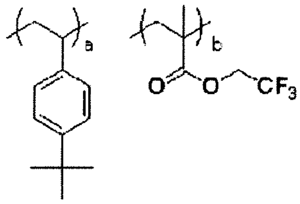

⊿SP=1. 3

(BP-5A): a=51wt%, b=49wt%, Mn=17600, Mw/Mn=1.11
(BP-5A'): a=50wt%, b=50wt%, Mn=16300, Mw/Mn=1.07
(BP-5B): a=68wt%, b=32wt%, Mn=15600, Mw/Mn=1.12
(BP-5B'): a=69wt%, b=31wt%, Mn=17200, Mw/Mn=1.09
(BP-5C): a=51wt%, b=49wt%, Mn=30200, Mw/Mn=1.06
(BP-5D): a=53wt%, b=47wt%, Mn=22200, Mw/Mn=1.08
(BP-5E): a=72wt%, b=28wt%, Mn=28800, Mw/Mn=1.05
(BP-5F): a=70wt%, b=30wt%, Mn=24400, Mw/Mn=1.06

BP−6

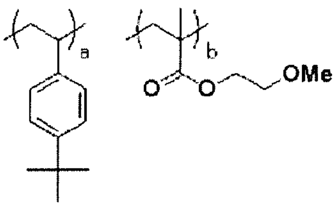

⊿SP=2. 2

(BP-6A): a=48wt%, b=52wt%, Mn=18000, Mw/Mn=1.08
(BP-6B): a=75wt%, b=25wt%, Mn=18300, Mw/Mn=1.08
(BP-6C): a=49wt%, b=51wt%, Mn=28900, Mw/Mn=1.05
(BP-6D): a=51wt%, b=49wt%, Mn=23700, Mw/Mn=1.07
(BP-6E): a=73wt%, b=27wt%, Mn=25100, Mw/Mn=1.05
(BP-6F): a=70wt%, b=30wt%, Mn=22600, Mw/Mn=1.06

BP−7

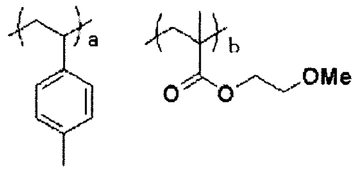

⊿SP=1. 0

(BP-7A): a=52wt%, b=48wt%, Mn=18500, Mw/Mn=1.08
(BP-7B): a=72wt%, b=28wt%, Mn=16800, Mw/Mn=1.10

**BP−8**

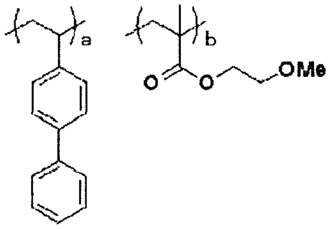

ΔSP=0. 9

(BP-8A): a=52wt%, b=48wt%, Mn=16400, Mw/Mn=1.06
(BP-8B): a=73wt%, b=27wt%, Mn=17700, Mw/Mn=1.09

**BP−9**

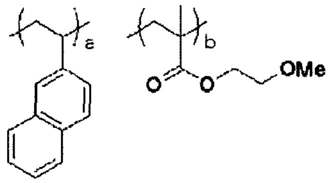

ΔSP=0. 6

(BP-9A): a=50wt%, b=50wt%, Mn=17900, Mw/Mn=1.10
(BP-9B): a=70wt%, b=30wt%, Mn=18900, Mw/Mn=1.13

**BP−10**

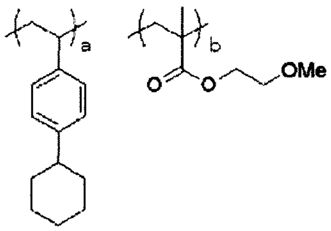

ΔSP=1. 5

(BP-10A): a=51wt%, b=49wt%, Mn=18800, Mw/Mn=1.10
(BP-10B): a=69wt%, b=31wt%, Mn=19800, Mw/Mn=1.11

**BP−11**

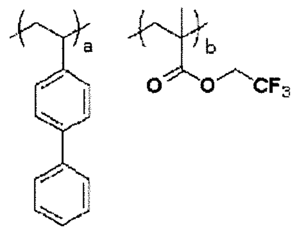

ΔSP=1. 8

(BP-11A): a=46wt%, b=54wt%, Mn=17800, Mw/Mn=1.07
(BP-11B): a=70wt%, b=30wt%, Mn=19100, Mw/Mn=1.06

**BP−12**

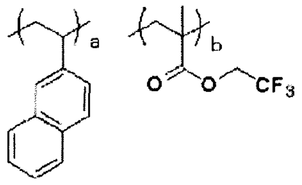

ΔSP=1. 5

(BP-12A): a=47wt%, b=53wt%, Mn=19100, Mw/Mn=1.13
(BP-12B): a=67wt%, b=33wt%, Mn=18600, Mw/Mn=1.12

**BP−13**

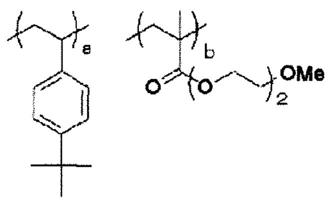

ΔSP=2. 3

(BP-13A): a=53wt%, b=47wt%, Mn=19500, Mw/Mn=1.07
(BP-13B): a=71wt%, b=29wt%, Mn=18000, Mw/Mn=1.10

**BP−14**

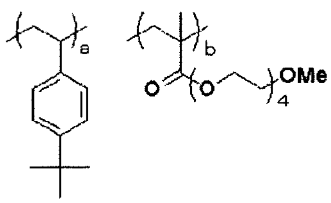

ΔSP=2. 6

(BP-14A): a=49wt%, b=51wt%, Mn=17400, Mw/Mn=1.09
(BP-14B): a=67wt%, b=33wt%, Mn=17100, Mw/Mn=1.13

**BP−15**

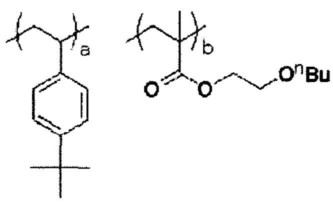

ΔSP=0. 6

(BP-15A): a=52wt%, b=48wt%, Mn=18700, Mw/Mn=1.11
(BP-15B): a=73wt%, b=27wt%, Mn=19300, Mw/Mn=1.10

BP-16

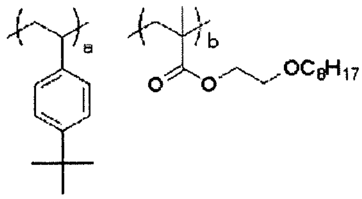

ΔSP=0.5

(BP-16A): a=47wt%, b=53wt%, Mn=19300, Mw/Mn=1.10
(BP-16B): a=66wt%, b=34wt%, Mn=18900, Mw/Mn=1.09

BP-17

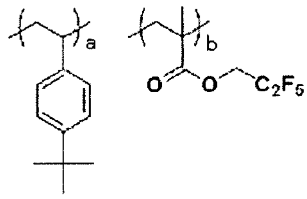

ΔSP=0.5

(BP-17A): a=50wt%, b=50wt%, Mn=17200, Mw/Mn=1.08
(BP-17B): a=70wt%, b=30wt%, Mn=16500, Mw/Mn=1.07

BP-18

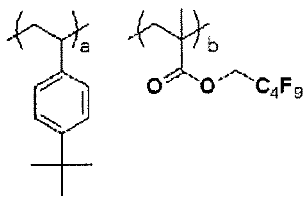

ΔSP=1.1

(BP-18A): a=48wt%, b=52wt%, Mn=19000, Mw/Mn=1.10
(BP-18B): a=71wt%, b=29wt%, Mn=17000, Mw/Mn=1.08

BP-19

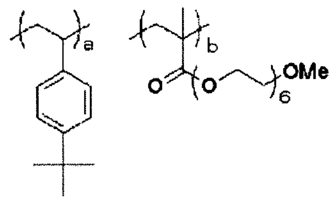

ΔSP=3.1

(BP-19A): a=50wt%, b=50wt%, Mn=17700, Mw/Mn=1.09
(BP-19B): a=70wt%, b=30wt%, Mn=17900, Mw/Mn=1.08

BP-20

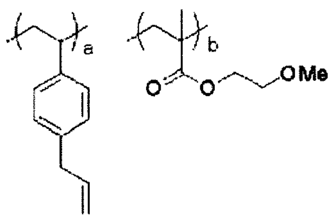

ΔSP=1.5

(BP-20A): a=48wt%, b=52wt%, Mn=16900, Mw/Mn=1.14
(BP-20B): a=71wt%, b=29wt%, Mn=17500, Mw/Mn=1.12

BP-21

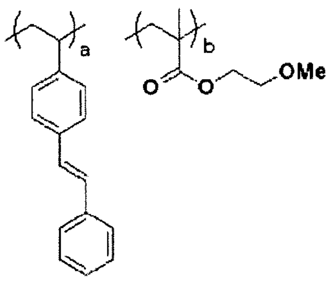

ΔSP=0.8

(BP-21A): a=51wt%, b=49wt%, Mn=18800, Mw/Mn=1.07
(BP-21B): a=67wt%, b=33wt%, Mn=17400, Mw/Mn=1.08

BP-22

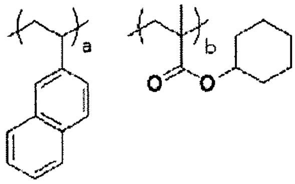

ΔSP=3.2

(BP-22A): a=50wt%, b=50wt%, Mn=19200, Mw/Mn=1.14
(BP-22B): a=73wt%, b=27wt%, Mn=18000, Mw/Mn=1.16

BP-23

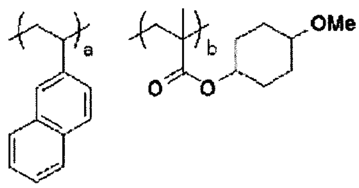

ΔSP=2.7

(BP-23A): a=46wt%, b=54wt%, Mn=17000, Mw/Mn=1.14
(BP-23B): a=72wt%, b=28wt%, Mn=18300, Mw/Mn=1.13

**BP−24**

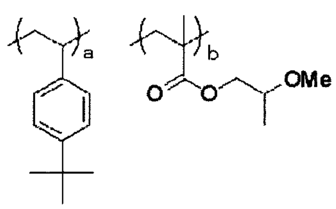

ΔSP=1. 5

(BP-24A): a=49wt%, b=51wt%, Mn=17700, Mw/Mn=1.08
(BP-24B): a=70wt%, b=30wt%, Mn=18300, Mw/Mn=1.06

**BP−25**

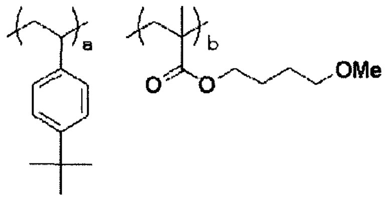

ΔSP=1. 6

(BP-25A): a=50wt%, b=50wt%, Mn=16500, Mw/Mn=1.09
(BP-25B): a=66wt%, b=34wt%, Mn=17100, Mw/Mn=1.08

**BP−26**

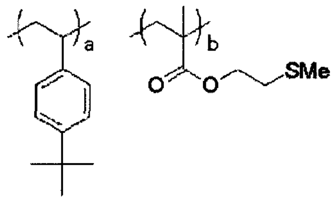

ΔSP=2. 4

(BP-26A): a=48wt%, b=52wt%, Mn=17700, Mw/Mn=1.11
(BP-26B): a=71wt%, b=29wt%, Mn=18800, Mw/Mn=1.09

[0077]

BP−4

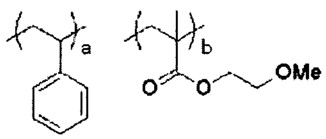

ΔSP=0. 6

(BP-4A): a=45wt%, b=55wt%, Mn=18000 Mw/Mn=1.07
(BP-4B): a=72wt%, b=28wt%, Mn=19700, Mw/Mn=1.16

BP−27

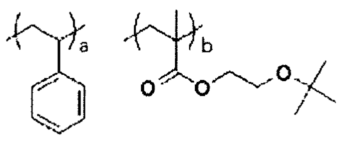

ΔSP=0. 7

(BP-27A): a=47wt%, b=53wt%, Mn=19300, Mw/Mn=1.07
(BP-27B): a=66wt%, b=34wt%, Mn=16700, Mw/Mn=1.07

BP−28

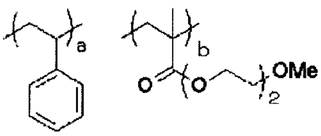

ΔSP=0. 7

(BP-28A): a=52wt%, b=48wt%, Mn=18000, Mw/Mn=1.08
(BP-28B): a=71wt%, b=29wt%, Mn=19100, Mw/Mn=1.09

BP−29

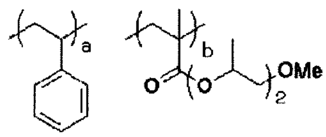

ΔSP=1. 5

(BP-29A): a=50wt%, b=50wt%, Mn=17100, Mw/Mn=1.06
(BP-29B): a=68wt%, b=32wt%, Mn=18900, Mw/Mn=1.07

**ABP−1**

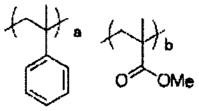

(ABP-1A): a=70wt%, b=30wt%, Mn=48000, Mw/Mn=1.07
(ABP-1B): a=50wt%, b=50wt%, Mn=45000, Mw/Mn=1.07

**ABP−2**

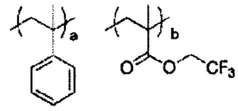

(ABP-2A): a=70wt%, b=30wt%, Mn=17000, Mw/Mn=1.07
(ABP-2B): a=50wt%, b=50wt%, Mn=18000, Mw/Mn=1.06

ABP−3

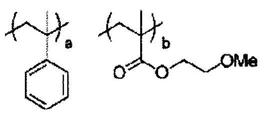

(ABP-3A): a=70wt%, b=30wt%, Mn=19500, Mw/Mn=1.08
(ABP-3B): a=50wt%, b=50wt%, Mn=18500, Mw/Mn=1.07

ABP−4

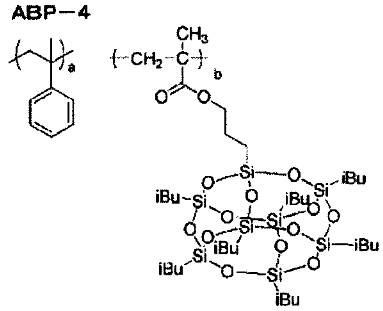

(ABP-4A): a=70wt%, b=30wt%, Mn=29000 Mw/Mn=1.20
(ABP-4B): a=50wt%, b=50wt%, Mn=28000, Mw/Mn=1.18

Next, a method of forming a layer formed by microphase separation of a block copolymer will be described below.

In the OTFT of the present invention, the layer formed by microphase separation of a block copolymer is formed by coating the OTFT with a solution containing the block copolymer for film formation, applying a heat treatment to the film, and self-organizing the block copolymer.

An organic solvent is preferable as a solvent of the solution containing the block copolymer, and examples thereof include lactones such as γ-butyrolactone; ketones such as acetone, methyl ethyl ketone, cyclohexanone, methyl-n-pentyl ketone, methyl isopentyl ketone, and 2-heptanone; polyhydric alcohols such as ethylene glycol, diethylene glycol, propylene glycol, and dipropylene glycol; derivatives [among these, propylene glycol monomethyl ether acetate (PGMEA) and propylene glycol monomethyl ether (PGME) are preferable] of polyhydric alcohols such as a compound having an ester bond such as ethylene glycol monoacetate, diethylene glycol monoacetate, propylene glycol monoacetate, or dipropylene glycol monoacetate and a compound having an ether bond such as monophenyl ether or monoalkyl ether such as monomethyl ether, monoethyl ether, monopropyl ether, or monobutyl ether of a compound having the above-described polyhydric alcohols or the above-described ester bond; cyclic ethers such as siloxane; esters such as methyl lactate, ethyl lactate (EL), methyl acetate, ethyl acetate, butyl acetate, methyl pyruvate, ethyl pyruvate, methyl methoxy propionate, and ethyl ethoxy propionate; and aromatic organic solvents such as anisole, ethyl benzyl ether, cresyl methyl ether, diphenyl ether, dibenzyl ether, phenetole, butyl phenyl ether, ethyl benzene, diethyl benzene, pentyl benzene, isopropyl benzene, toluene, xylene, cymene, and mesitylene. Further, the above-described organic solvents may be used in combination of two or more kinds thereof.

In the solution containing the above-described block copolymer, the concentration of the block copolymer is typically in a range of 1.0% by mass to 10% by mass, preferably in a range of 1.5% by mass to 6.0% by mass, and more preferably in a range of 1.5% by mass to 5.5% by mass.

A substrate 10 is typically coated with the solution containing the block copolymer using a spinner or a coater. In this manner, a layer containing a block copolymer can be formed. By heating the layer containing the block copolymer, microphase separation of the block copolymer becomes possible. It is preferable that the layer is heated at a glass transition temperature or higher. Further, it is preferable that the layer is heated at a thermal decomposition temperature or lower of the block copolymer. The heating temperature thereof is preferably in a range of 50°C to 250°C, more preferably in a range of 60°C to 200°C, and still more preferably in a range of 100°C to 180°C. In addition, the heating time thereof is preferably in a range of 1 second to 10 hours and more preferably in a range of 1 minute to 2 hours.

It is preferable that the lamellar phase separation of the block copolymer is carried out through the microphase separation. When the composition of a block unit in the block copolymer is set to be in the above-described preferable range, the lamellar phase separation can be carried out.

Hereinafter, the configuration and the material of the TFT of the present invention will be described.

[Substrate]

A substrate which is capable of supporting the OTFT and a display panel or the like prepared on the OTFT can be used. The substrate is not particularly limited as long as the substrate has a sheet shape and the surface thereof is insulating and flat.

An inorganic material may be used as the material of the substrate. Examples of the substrate formed of an inorganic material include various glass substrates such as soda-lime glass and quartz glass, various glass substrates having an insulating film formed on the surface thereof, a quartz substrate having an insulating film formed on the surface thereof, a silicon substrate having an insulating film formed on the surface thereof, a sapphire substrate, metal substrates made of various alloys or various metals such as stainless steel, aluminum, and nickel, metal foil, and paper.

In a case where the substrate is formed of a semiconductive material or a conductive material such as a stainless sheet, aluminum foil, copper foil, or a silicon wafer, the surface thereof is typically coated with or overlapped with an

insulating polymer material or a metal oxide for use.

Moreover, an organic material may also be used as the material of the substrate. Examples thereof include a plastic substrate (also referred to as a plastic film or a plastic sheet) which has flexibility and is formed of an organic polymer such as polymethylmethacrylate (PMMA), polyvinyl alcohol (PVA), polyvinyl phenyl (PVP), polyether sulfone (PES), polyimide, polyamide, polyacetal, polycarbonate (PC), polyethylene terephthalate (PET), polyethylene naphthalene (PEN), polyethyl ether ketone, polyolefin, or polycycloolefin. Further, a material formed from mica can be also exemplified.

When such a plastic substrate or the like having flexibility is used, incorporation or integration of the OTFT into/with a display device or an electronic device having a curved shape becomes possible.

Since an organic material forming the substrate is unlikely to be softened at the time of lamination on another layer or being heated, it is preferable that the glass transition point thereof is high, for example, 40°C or higher. Moreover, in terms that dimensional change resulting from a heat treatment at the time of production is unlikely to occur and stability of transistor performance is excellent, it is preferable that the linear expansion coefficient is small. For example, a material having a linear expansion coefficient of $25\times10^{-5}$ cm/cm·°C or less is preferable and a material having a linear expansion coefficient of $10\times10^{-5}$ cm/cm·°C or less is more preferable.

Further, as the organic material constituting the substrate, a material having resistance to a solvent used when the OTFT is produced is preferable and a material having excellent adhesion to a gate insulating layer and an electrode is preferable.

Moreover, it is preferable to use a plastic substrate formed of an organic polymer having excellent gas barrier properties.

It is also preferable that a dense silicon oxide film or the like is provided on at least one surface of the substrate or an inorganic material is deposited or laminated on at least one surface of the substrate.

Other examples of the substrate include conductive substrates (for example, a substrate formed of a metal such gold or aluminum, a substrate formed of highly oriented graphite, or stainless steel substrate).

A buffer layer used to improve the adhesion or flatness, a functional film such as a barrier film used to improve gas barrier properties, or a surface treatment layer such as an easily adhesive layer may be formed on the surface of the substrate or the substrate may be subjected to a surface treatment such as a corona treatment, a plasma treatment, or UV/ozone treatment.

The thickness of the substrate is preferably 10 mm or less, more preferably 2 mm or less, and particularly preferably 1 mm or less. Further, the thickness thereof is preferably 0.01 mm or greater and more preferably 0.05 mm or greater. Particularly, in a case of a plastic substrate, the thickness thereof is preferably in a range of 0.05 mm to 0.1 mm. Moreover, in a case of a substrate formed of an inorganic material, the thickness thereof is preferably in a range of 0.1 mm to 10 mm.

[Gate electrode]

A known electrode of the related art being used as a gate electrode of an OTFT can be used as the gate electrode. A conductive material (also referred to as an electrode material) constituting the gate electrode is not particularly limited. Examples thereof include metals such as platinum, gold, silver, aluminum, chromium, nickel, copper, molybdenum, titanium, magnesium, calcium, barium, sodium, palladium, iron, and manganese; conductive metal oxides such as $InO_2$, $SnO_2$, indium tin oxide (ITO), fluorine-doped tin oxide (FTO), aluminum-doped zinc oxide (AZO), and gallium-doped zinc oxide (GZO); conductive polymers such as polyaniline, polypyrrole, polythiophene, polyacetylene, and poly(3,4-ethylenedioxythiophene)/polystyrene sulfonic acid (PEDOT/PSS); and conductive composite materials obtained by dispersing the above-described conductive polymer to which a dopant, for example, an acid such as hydrochloric acid, sulfuric acid, or sulfonic acid, Lewis acid such as $PF_6$, $AsF_5$, or $FeCl_3$, a halogen atom such as iodine, or a metal atom such as sodium or potassium is added, carbon black, graphite powder, or metal fine particles therein. These materials may be used alone or in combination of optional two or more kinds thereof at an optional ratio.

In addition, the gate electrode may be configured of a single layer or two or more layers being laminated, formed of the above-described conductive materials.

A method of forming the gate electrode is not limited. Examples thereof include a method of patterning a film, formed using a physical vapor deposition (PVD) method such as a vacuum vapor deposition method, a chemical vapor deposition method (CVD method), a sputtering method, a printing method (coating method), a transfer method, a sol-gel method, or a plating method, in a desired shape as needed.

According to the coating method, a film is formed or an electrode is directly formed by preparing, applying, drying, baking, photocuring, or aging a solution, paste, or a dispersion liquid of the above-described material.

Moreover, from the viewpoints of capability of desired patterning, simplifying the processes, cost reduction, and speeding up, it is preferable to use ink jet printing, screen printing, (inversion) offset printing, relief printing, intaglio printing, planographic printing, thermal transfer printing, or a microcontact printing method.

In a case where a spin coating method, a die coating method, a micro gravure coating method, or a dip coating method is employed, patterning can be carried out by combining any of these method and the following photolithographic method.

As the photolithographic method, a method of combining patterning of a photoresist, etching, for example, wet etching using an etching solution or dry etching using a reactive plasma, and a lift-off method may be exemplified.

As another patterning method, a method of irradiating the above-described materials with energy rays such as laser or electron beams and polishing the materials so that the conductivity of the material is changed may be exemplified.

In addition, a method of transferring a composition for a gate electrode which is printed on a support other than a substrate onto an underlayer such as the substrate may be exemplified.

The thickness of the gate electrode is optional, but is preferably 1 nm or greater and particularly preferably 10 nm or greater. Further, the thickness thereof is preferably 500 nm or less and particularly preferably 200 nm or less.

[Gate insulating layer]

The gate insulating layer can be formed according to the following embodiment other than the embodiment in which the gate insulating layer is formed of the above-described microphase separation layer.

The gate insulating layer is not particularly limited as long as the layer has insulating properties and the gate insulating layer may be formed of a single layer or multiple layers.

It is preferable that the gate insulating layer is formed of an insulating material, and preferred examples of the insulating material include an organic polymer and an inorganic oxide.

The organic polymer and the inorganic oxide are not particularly limited as long as the organic polymer and the inorganic oxide have insulating properties, and it is preferable that the organic polymer and the inorganic oxide are formed of a thin film having a thickness of 1 $\mu$m or less.

The organic polymer and the inorganic oxide may be used alone or in combination of two or more kinds thereof and the organic polymer may be combined with the inorganic oxide.

The organic polymer is not particularly limited, and examples thereof include polyvinyl phenol, polystyrene (PS), poly(meth)acrylate represented by polymethyl methacrylate, polyvinyl alcohol, polyvinyl chloride (PVC), polyvinylidene fluoride (PVDF), polytetrafluoroethylene (PTFE), a cyclic fluoroalkyl polymer represented by CYTOP, polycycloolefin, polyester, polyether sulfone, polyether ketone, polyimide, an epoxy resin, polyorganosiloxane represented by polydimethylsiloxane (PDMS), polysilsesquioxane, and butadiene rubber. Further, other examples thereof include thermosetting resins such as a phenolic resin, a novolac resin, a cinnamate resin, an acrylic resin, and a polyparaxylylene resin.

The organic polymer can be combined with a compound including a reactive substituent such as an alkoxysilyl group, a vinyl group, an acryloyloxy group, an epoxy group, or a methylol group.

In a case where the gate insulating layer is formed using an organic polymer, it is also preferable that the organic polymer is cross-linked and cured for the purpose of increasing the solvent resistance or insulation resistance of the gate insulating layer. It is preferable that the crosslinking is performed by generating an acid or a radical using light or heat or both of these.

In a case where the crosslinking is performed by generating a radical, as a radical generator that generates a radical using light or heat, for example, a thermal polymerization initiator (H1) and a photopolymerization initiator (H2) described in the paragraphs [0182] to [0186] of JP2013-214649A, a photo-radical generator described in the paragraphs [0046] to [0051] of JP2011-186069A, and a photo-radical polymerization initiator described in the paragraphs [0042] to [0056] of JP2010-285518A can be preferably used, and it is preferable that the contents of which are incorporated in the specification of the present application.

Moreover, it is preferable that "a compound (G) which has a number average molecular weight (Mn) of 140 to 5000, includes a crosslinkable functional group, and does not include a fluorine atom" described in the paragraphs [0167] to [0177] of JP2013-214649A is preferably used and the contents of which are incorporated in the specification of the present application.

In a case where the crosslinking is performed by generating an acid, as a photoacid generator that generates an acid using light, for example, a photocationic polymerization initiator described in the paragraphs [0033] and [0034] of JP2010-285518A, and an acid generator, particularly sulfonium salts and iodonium salts described in the paragraphs [0120] to [0136] of JP2012-163946A can be preferably used, and it is preferable that the contents of which are incorporated in the specification of the present application.

As a thermal acid generator (catalyst) that generates an acid using heat, for example, a thermal cationic polymerization initiator and particularly onium salts described in the paragraphs [0035] to [0038] of JP2010-285518A, and a catalyst and particularly sulfonic acids and sulfonic acid amine salts described in the paragraphs [0034] and [0035] of JP2005-354012A can be preferably used, and it is preferable that the contents of which are incorporated in the specification of the present application.

Moreover, a crosslinking agent and particularly a difunctional or higher functional epoxy compound and an

oxetane compound described in the paragraphs [0032] and [0033] of JP2005-354012A, a crosslinking agent and particularly a compound which includes two or more crosslinking group and in which at least one of the crosslinking groups is a methylol group or an NH group described in the paragraphs [0046] to [0062] of JP2006-303465A, and a hydroxymethyl group or a compound having two or more alkoxymethyl groups in a molecule described in the paragraphs [0137] to [0145] of JP2012-163946A are preferably used, and it is preferable that the contents of which are incorporated in the specification of the present application.

As a method of forming the gate insulating layer with an organic polymer, a method of applying and curing an organic polymer may be exemplified. The coating method is not particularly limited, and the above-described various printing methods are exemplified. Among those, a wet coating method such as a micro gravure coating method, a dip coating method, screen coating printing, a die coating method, or a spin coating method is preferable.

The inorganic oxide is not particularly limited, and examples thereof include oxides such as silicon oxide, silicon nitride ($SiN_Y$), hafnium oxide, titanium oxide, tantalum oxide, aluminum oxide, niobium oxide, zirconium oxide, copper oxide, and nickel oxide; perovskites such as $SrTiO_3$, $CaTiO_3$, $BaTiO_3$, $MgTiO_3$, and $SrNb_2O_6$; and a composite oxide or a mixture of these. Here, as the silicon oxide, in addition to silicon oxide ($SiO_x$), BPSG, PSG, BSG, AsSG, PbSG, silicon oxynitride (SiON), spin on glass (SOG), and $SiO_2$-base materials having a low dielectric constant (for example, polyaryl ether, a cycloperfluorocarbon polymer, benzocyclobutene, a cyclic fluorine resin, polytetrafluoroethylene, fluorinated aryl ether, fluorinated polyimide, amorphous carbon, and organic SOG) are included.

As a method forming the gate insulating layer with an inorganic oxide, a vacuum film formation method such as a vacuum vapor deposition method, a sputtering method, ion plating, or a CVD method can be used, and assist may be performed using a plasma, an ion gun, or a radical gun using optional gas during the film formation.

Moreover, the gate insulating layer may be formed by reacting a precursor corresponding to each metal oxide, specifically, a metal halide or a metal alkoxide such as a chloride or a bromide, or a metal hydroxide with an acid such as hydrochloric acid, sulfuric acid, or nitric acid, or a base such as sodium hydroxide or potassium hydroxide in alcohol or water for hydrolysis. In a case of using such a solution-based process, the above-described wet coating method can be used.

The gate insulating layer can be also provided using a method obtained by combining any of a lift-off method, a sol-gel method, an electrodeposition method, and a shadow mask method with a patterning method, if necessary, other than the above-described methods.

The gate insulating layer may be subjected to a surface treatment such as a corona treatment, a plasma treatment, or a UV/ozone treatment. In this case, it is preferable not to make the surface rough due to the surface treatment. An arithmetic mean roughness Ra or a root mean square roughness $R_{MS}$ of the surface of the gate insulating layer is preferably 0.5 nm or less.

[Organic semiconductor layer]

An organic semiconductor layer is a layer which exhibits properties of a semiconductor and on which carriers can be accumulated.

The organic semiconductor layer may contain an organic semiconductor.

The organic semiconductor is not particularly limited, and examples thereof include an organic polymer, a derivative thereof, and a low molecular weight compound.

In the present invention, the low molecular weight compound indicates a compound other than an organic polymer and a derivative thereof, that is, a compound that does not have a repeating unit. As long as the low molecular weight compound is such a compound, the molecular weight thereof is not particularly limited. The molecular weight of the low molecular weight compound is preferably in a range of 300 to 2000 and more preferably in a range of 400 to 1000.

As the low molecular weight compound, a condensed polycyclic aromatic compound may be exemplified. Examples thereof include acene such as naphthacene, pentacene(2,3,6,7-dibenzoanthracene), hexacene, heptacene, dibenzopentacene, or tetrabenzopentacene, anthradithiophene, pyrene, benzopyrene, dibenzopyrene, chrysene, perylene, coronene, terrylene, ovalene, quaterrylene, circumanthracene, a derivative in which some of these carbon atoms are substituted with atoms such as N, S, and O, a derivative (a dioxa anthanthrene-based compound including perixanthenoxanthene and a derivative thereof, triphenodioxazine, triphenodithiazine, or hexacene-6,15-quinone) in which at least one hydrogen atom bonded to the carbon atom is substituted with a functional group such as a carbonyl group, and a derivative in which the hydrogen atom is substituted with another functional group.

Further, other examples thereof include metal phthalocyanine represented by copper phthalocyanine, tetrathiapentalene and a derivative thereof, naphthalene tetracarboxylic acid diimide such as naphthalene-1,4,5,8-tetracarboxylic acid diimide, N,N'-bis(4-trifluoromethylbenzyl)naphthalene-1 ,4,5,8-tetracarboxylic acid diimide, N,N'-bis(1H,1H-perfluorooctyl), N,N'-bis(1H,1H-perfluorobutyl), a N,N'-dioctylnaphthalene-1,4,5,8-tetracarboxylic acid diimide derivative, or naphthalene-2,3,6,7-tetracarboxylic acid diimide, condensed ring tetracarboxylic acid diimide, for example, anthracene tetracarboxylic acid diimide such as anthracene-2,3,6,7-tetracarboxylic acid diimide, fullerene such as C60, C70, C76,

C78, or C84 and a derivative of these, a carbon nanotube such as SWNT, and dyes such as a merocyanine dye and a hemicyanine dye and a derivative of these.

Moreover, polyanthracene, triphenylene, and quinacridone are also exemplified.

In addition, examples of the low molecular weight compound include 4,4'-biphenyl dithiol (BPDT), 4,4'-diisocyanobiphenyl, 4,4'-diisocyano-p-terphenyl, 2,5-bis(5'-thioacetyl-2'-thiophenyl)thiophene, 2,5-bis(5'-thioacetoxyl-2'-thiophenyl)thiophene, 4,4'-diisocyanophenyl, benzidine(biphenyl-4,4'-diamine), tetracyanoquinodimethane (TCNQ), tetrathiafulvalene (TTF) and a derivative thereof, a tetrathiafulvalene (TTF)-TCNQ complex, a bisethylene tetrathiafulvalene (BEDTTTF)-perchloric acid complex, a BEDTTTF-iodine complex, a charge transfer complex represented by a TCNQ-iodine complex, biphenyl-4,4'-dicarboxylic acid, 1,4-di(4-thiophenylacetylenyl)-2-ethylbenene, 1,4-di(4-isocyanophenylacetylenyl)-2-ethylbenzene, 1,4-di(4-thiophenylethynyl)-2-ethylbenzene, 2,2"-dihydroxy-1,1':4',1"-terphenyl, 4,4'-biphenyl diethanal, 4,4'-biphenyl diol, 4,4'-biphenyl diisocyanate, 1,4-diacetynylbenzene, diethylbiphenyl-4,4'-dicarboxylate, benzo[1,2-c;3,4-c';5,6-c"]tris[1,2]dithiol-1,4,7-trithione, α-sexithiophene, tetrathiatetracene, tetraselenotetracene, tetratellurium tetracene, poly(3-alkylthiophene), poly(3-thiophene-β-ethanesulfonic acid), poly(N-alkylpyrrole)poly(3-alkylpyrrole), poly(3,4-dialkylpyrrole), poly(2,2'-thienylpyrrole), and poly(dibenzothiophene sulfide).

It is preferable that the organic semiconductor is a low molecular weight compound. Among examples thereof, a condensed polycyclic aromatic compound is preferable. The condensed polycyclic aromatic compound is highly effective in improving carrier mobility and durability and exhibits an excellent effect of decreasing the threshold voltage.

As the condensed polycyclic aromatic compound, acene represented by any of Formulae (A1) to (A4) and a compound represented by any of the following Formulae (C) to (T) are preferable, and a compound represented by any of the following Formulae (C) to (T) is more preferable.

The acene which is preferable as the condensed polycyclic aromatic compound is represented by the following Formula (A1) or (A2).

Formula (A1)

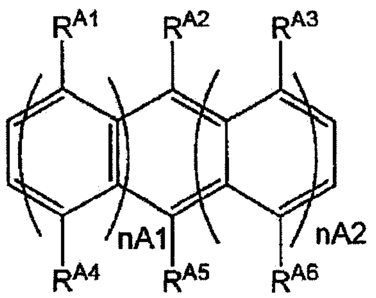

Formula (A2)

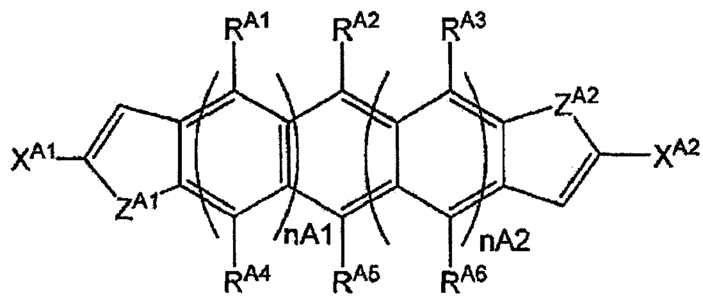

In Formulae, $R^{A1}$ to $R^{A6}$ and $X^{A1}$ and $X^{A2}$ represent a hydrogen atom or a substituent. $Z^{A1}$ and $Z^{A2}$ represent S, O, Se, or Te.

nA1 and nA2 represent an integer of 0 to 3. In this case, nA1 and nA2 do not represent 0 at the same time.

The substituent respectively represented by $R^{A1}$ to $R^{A6}$ and $X^{A1}$ and $X^{A2}$ is not particularly limited, and examples thereof include an alkyl group (such as methyl, ethyl, propyl, isopropyl, tert-butyl, pentyl, tert-pentyl, hexyl, octyl, tert-octyl, dodecyl, tridecyl, tetradecyl, or pentadecyl), a cycloalkyl group (such as cyclopentyl or cyclohexyl), an alkenyl group (such as vinyl, allyl, 1-propenyl, 2-butenyl, 1,3-butadienyl, 2-pentenyl, or isopropenyl), an alkynyl group (such as ethynyl or propargyl), an aromatic hydrocarbon group (also referred to as an aromatic carbocyclic group or an aryl group, and examples thereof include phenyl, p-chlorophenyl, mesityl, tolyl, xylyl, naphthyl, anthryl, azulenyl, acenaphthenyl, fluorenyl, phenanthryl, indenyl, pyrenyl, and biphenylyl), an aromatic heterocyclic group (also referred to as a heteroaryl group, and examples thereof include a pyridyl group, a pyrimidinyl group, a furyl group, a pyrrolyl group, an imidazolyl group, a benzoimidazolyl group, a pyrazolyl group, a pyrazinyl group, a triazolyl group (such as a 1,2,4-triazol-1-yl group or a 1,2,3-triazol-l-yl group), an oxazolyl group, a benzoxazolyl group, a thiazolyl group, an isoxazolyl group, an isothiazolyl group, a furazanyl group, a thienyl group, a quinolyl group, a benzofuryl group, a dibenzofuryl group, a benzothienyl group, a dibenzothienyl group, an indolyl group, a carbazolyl group, a carbolinyl group, a diazacarbazolyl group (a group in which one carbon atom constituting a carboline ring of a carbolinyl group is replaced with a nitrogen atom), a quinoxalinyl group, a pyridazinyl group, a triazinyl group, a triazinyl group, a quinazolinyl group, and a phthalazinyl group), a heterocyclic group (also referred to as a heteroaryl ring group, and examples thereof include a pyrrolidyl group, an imidazolidyl group, a morpholyl group, and an oxazolidyl group), an alkoxy group (such as methoxy, ethoxy, propyloxy, pentyloxy, hexyloxy, octyloxy, or dodecyloxy), a cycloalkoxy group (such as cyclopentyloxy or cyclohexyloxy), an aryloxy group (such as phenoxy or naphthyloxy), an alkylthio group (such as methylthio, ethylthio, propylthio, pentylthio,hexylthio,

octylthio, or dodecylthio), a cycloalkylthio group (such as cyclopentylthio or cyclohexylthio), an arylthio group (such as phenylthio or naphthylthio), an alkoxycarbonyl group (such as methyloxycarbonyl, ethyloxycarbonyl, butyloxycarbonyl, octyloxycarbonyl, or dodecyloxycarbonyl), an aryloxycarbonyl group (such as phenyloxycarbonyl or naphthyloxycarbonyl), a sulfamoyl group (such as aminosulfonyl, methylaminosulfonyl, dimethylaminosulfonyl, butylaminosulfonyl, hexylaminosulfonyl, cyclohexylaminosulfonyl, octylaminosulfonyl, dodecylaminosulfonyl, phenylaminosulfonyl, naphthylaminosulfonyl, or 2-pyridylaminosulfonyl), an acyl group (such as acetyl, ethylcarbonyl, propylcarbonyl, pentylcarbonyl, cyclohexylcarbonyl, octylcarbonyl, 2-ethylhexylcarbonyl, dodecylcarbonyl, phenylcarbonyl, naphthylcarbonyl, or pyridylcarbonyl), an acyloxy group (such as acetyloxy, ethylcarbonyloxy, butylcarbonyloxy, octylcarbonyloxy, or dodecylcarbonyloxy, phenylcarbonyloxy), an amide group (such as methylcarbonylamino, ethylcarbonylamino, dimethylcarbonylamino, propylcarbonylamino, pentylcarbonylamino, cyclohexylcarbonylamino, 2-ethylhexylcarbonylamino, octylcarbonylamino, dodecylcarbonylamino, phenylcarbonylamino, or naphthylcarbonylamino), a carbamoyl group (such as aminocarbonyl, methylaminocarbonyl, dimethylaminocarbonyl, propylaminocarbonyl, pentylaminocarbonyl, cyclohexylaminocarbonyl, octylaminocarbonyl, 2-ethylhexylaminocarbonyl, dodecylaminocarbonyl, phenylaminocarbonyl, naphthylaminocarbonyl, naphthylaminocarbonyl, or 2-pyridylaminocarbonyl), an ureido group (such as methylureido, ethylureido, pentylureido, cyclohexylureido, octylureido, dodecylureido, phenylureido, naphthylureido, or 2-pyridylaminoureido), a sulfinyl group (such as methylsulfinyl, ethylsulfinyl, butylsulfinyl, cyclohexylsulfinyl, 2-ethylhexylsulfinyl, dodecylsulfinyl, phenylsulfinyl, naphthylsulfinyl, or 2-pyridylsulfinyl), an alkylsulfonyl group (such as methylsulfonyl, ethylsulfonyl, butylsulfonyl, cyclohexylsulfonyl, 2-ethylhexylsulfonyl, or dodecylsulfonyl), an arylsulfonyl group (such as phenylsulfonyl, naphthylsulfonyl, or 2-pyridylsulfonyl), an amino group (such as amino, ethylamino, dimethylamino, butylamino, cyclopentylamino, 2-ethylhexylamino, dodecylamino, anilino, naphthylamino, or 2-pyridylamino), a halogen atom (such as a fluorine atom, a chlorine atom, or a bromine atom), a fluorinated hydrocarbon group (such as fluoromethyl, trifluoromethyl, pentafluoroethyl, or pentafluorophenyl), a cyano group, a nitro group, a hydroxyl group, a mercapto group, a silyl group (such as trimethylsilyl, triisopropylsilyl, triphenylsilyl, or phenyldiethylsilyl), and a group (in this case, $X^A$ represents Ge or Sn) represented by the following Formula (SG1).

These substituents may further include a plurality of substituents. As the plurality of substituents which may be included in these substituents, substituents represented by $R^{A1}$ to $R^{A6}$ are exemplified.

Among the above-described examples of acene, one represented by the following Formula (A3) or (A4) is preferable.

Formula (A3)

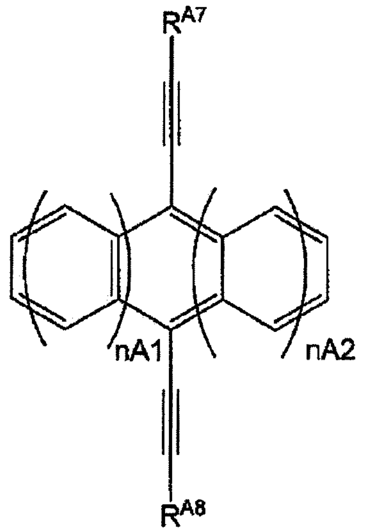

Formula (A4)

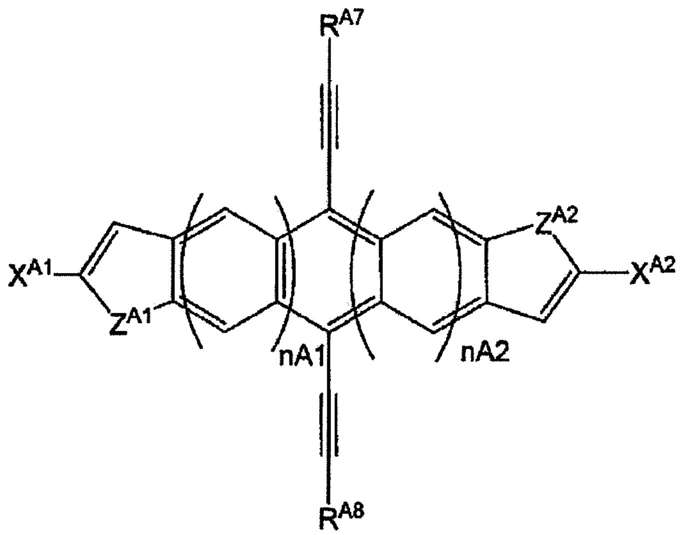

In the formulae, $R^{A7}$, $R^{A8}$, $X^{A1}$, and $X^{A2}$ represent a hydrogen atom or a substituent. $R^{A7}$, $R^{A8}$, $X^{A1}$, and $X^{A2}$ may be the same as or different from each other. Preferred examples of the substituents represented by $R^{A7}$ and $R^{A8}$ include those exemplified as the substituents which may be employed as $R^{A1}$ to $R^{A6}$ in Formulae (A1) and (A2).

$Z^{A1}$ and $Z^{A2}$ represent S, O, Se, or Te.

nA1 and nA2 represent an integer of 0 to 3. In this case, nA1 and nA2 do not represent 0 at the same time.

In Formula (A3) or (A4), it is preferable that $R^{A7}$ and $R^{A8}$ are represented by the following Formula (SG1).

Formula (SG1)

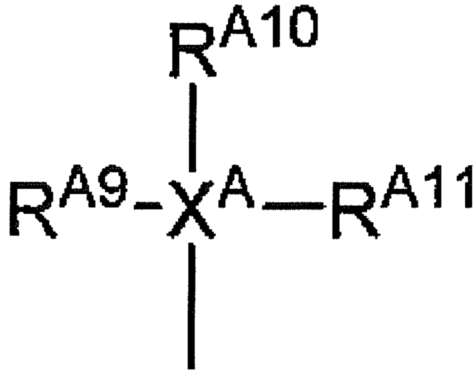

In the formula, $R^{A9}$ to $R^{A11}$ represent a substituent. $X^A$ represents Si, Ge, or Sn. Preferred examples of the substituents represented by $R^{A9}$ and $R^{A11}$ include those exemplified as the substituents which may be employed as $R^{A1}$ to $R^{A6}$ in Formulae (A1) and (A2).

Hereinafter, specific examples of acene or an acene derivative represented by Formula (A1) to (A4) will be described, but the present invention is not limited to those.

Compound A1

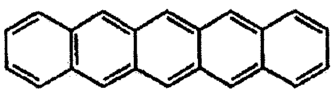

Compound A2

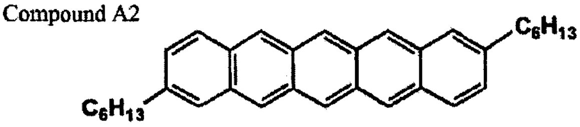

Compound A3

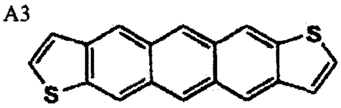

Compound A4

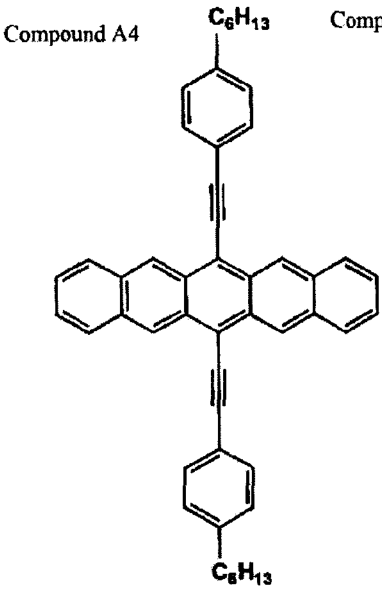

Compound A5

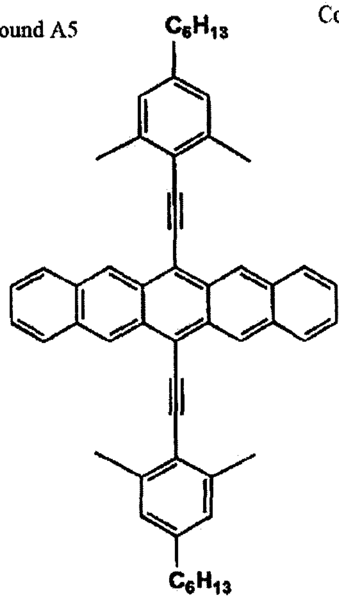

Compound A6

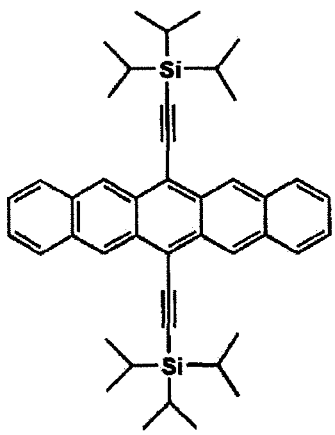

Compound A7

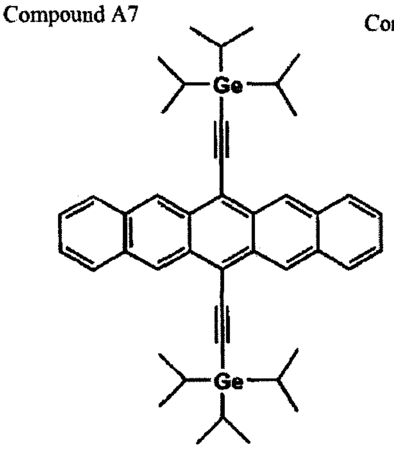

Compound A8

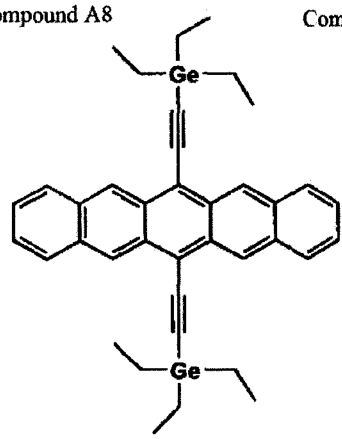

Compound A9

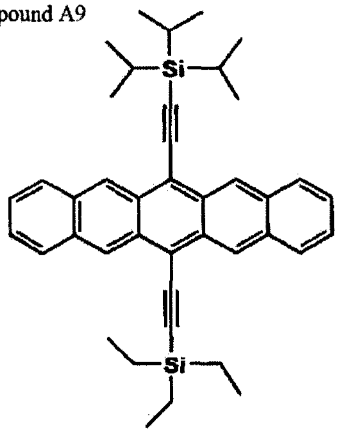

Compound A10

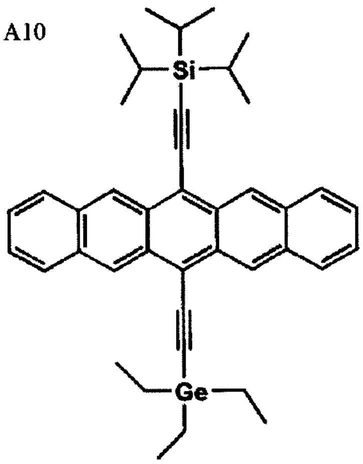

Compound A11

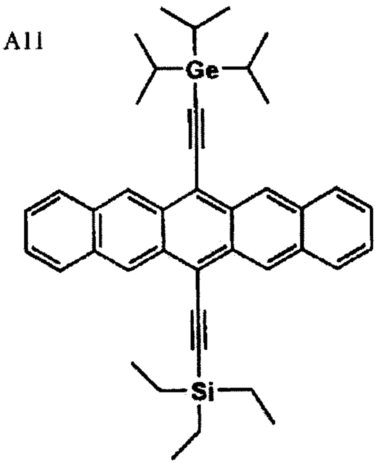

Compound A12

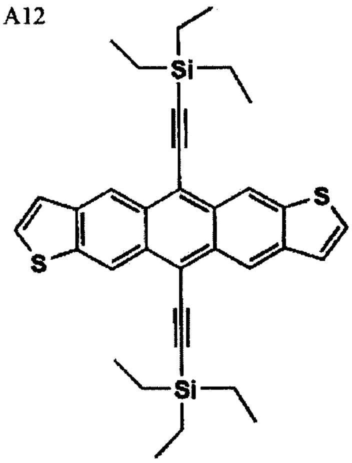

Compound A13

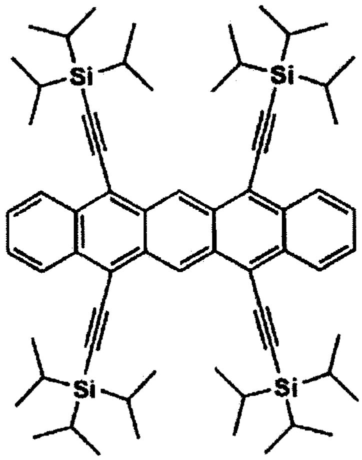

Compound A14

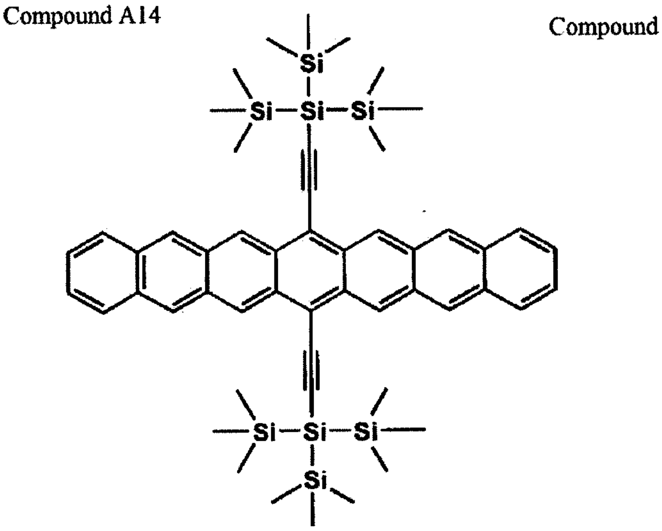

Compound A15

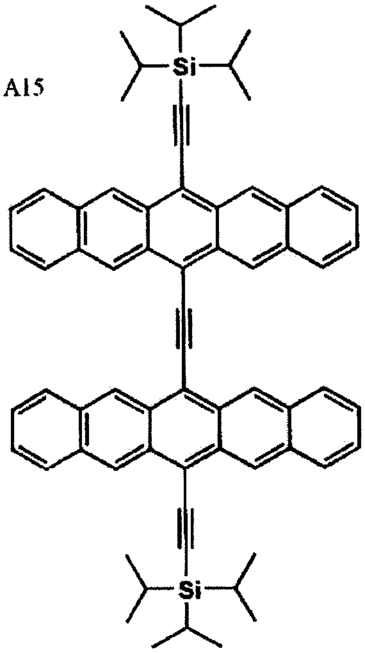

Compound A16

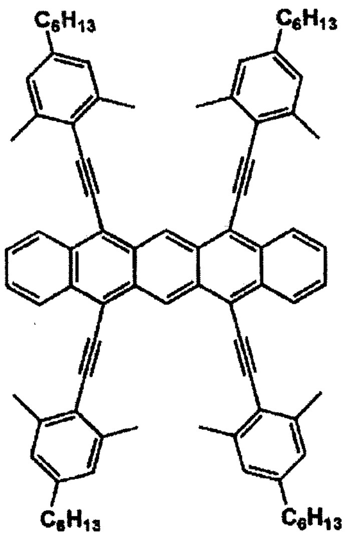

Compound A17

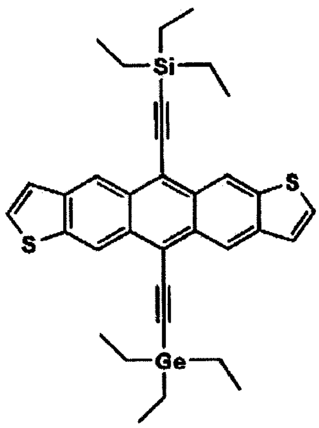

Compound A18

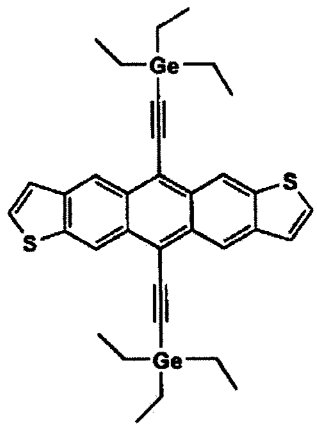

Compound A19

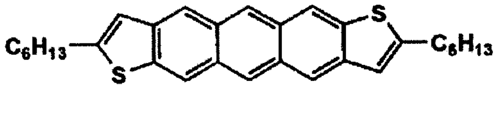

Compound A20

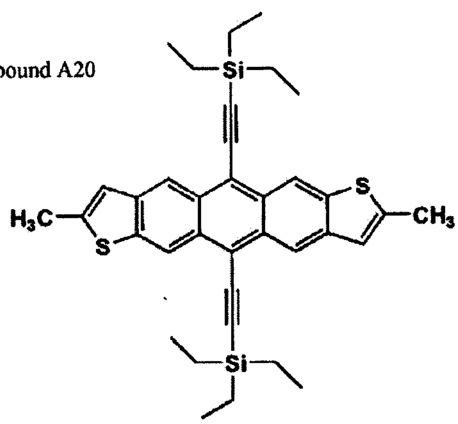

Compound A21

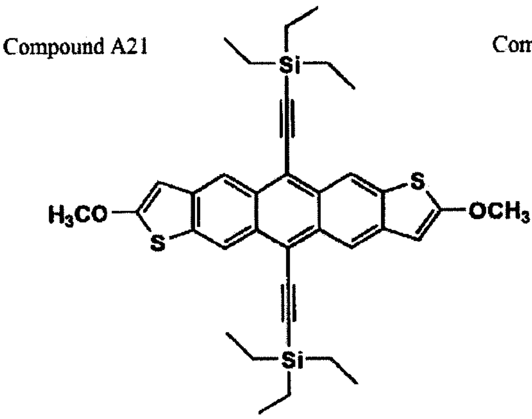

Compound A22

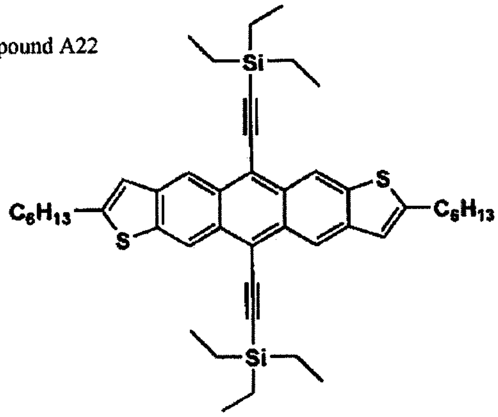

Compound A23

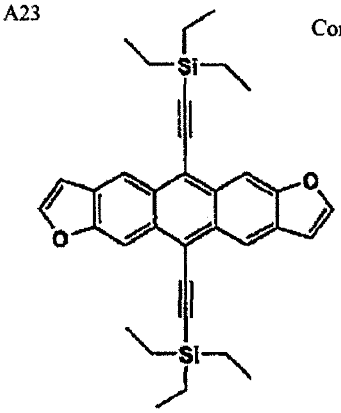

Compound A24

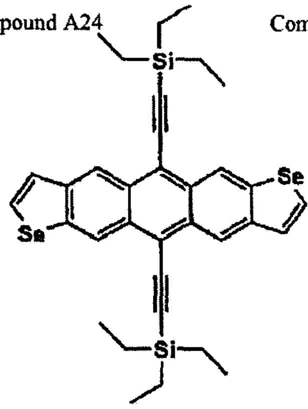

Compound A25

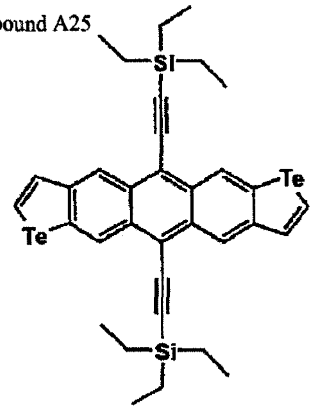

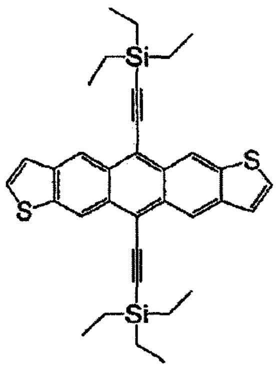

Compound A26

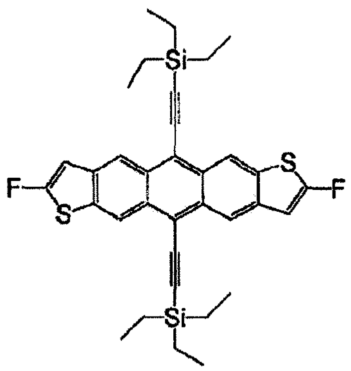

Compound A27

As the condensed polycyclic aromatic compound, compounds represented by the following Formulae (C) to (T) are also preferable.

Formula (C)

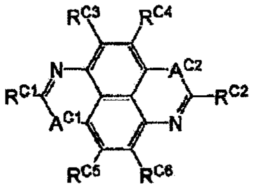

Formula (D)

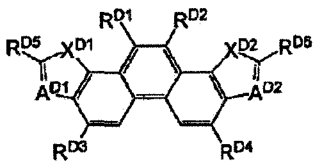

Formula (E)

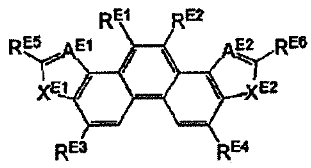

Formula (F)

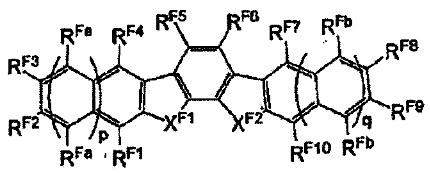

Formula (G)

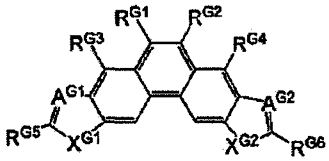

Formula (H)

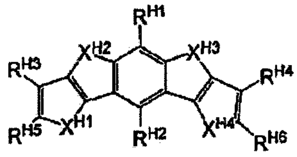

Formula (J)

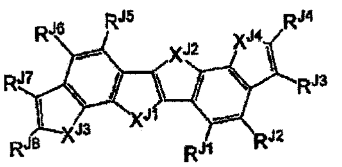

Formula (K)

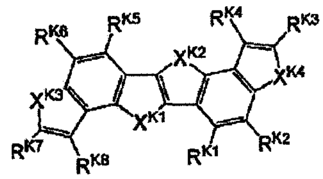

Formula (L)

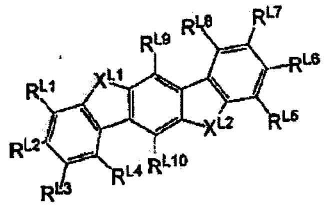

Formula (M)

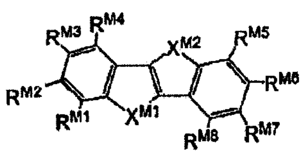

Formula (N)

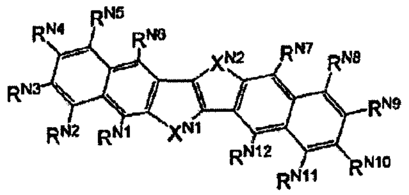

Formula (P)

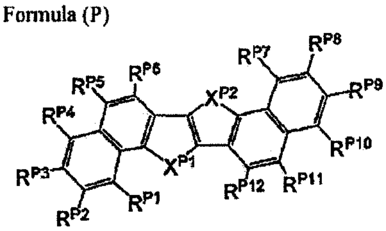

Formula (Q)

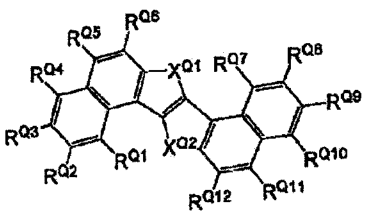

Formula (R)

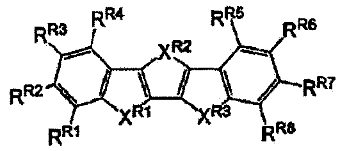

Formula (S)

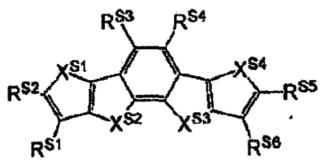

Formula (T)

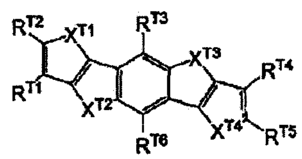

In Formula (C), $A^{C1}$ and $A^{C2}$ represent an oxygen atom, a sulfur atom, or a selenium atom. It is preferable that both of $A^{C1}$ and $A^{C2}$ represent an oxygen atom or a sulfur atom and more preferable that $A^{C1}$ and $A^{C2}$ represent a sulfur atom. $R^{C1}$ to $R^{C6}$ represent a hydrogen atom or a substituent. At least one of $R^{C1}$, ..., or $R^{C6}$ represents a substituent represented by the following Formula (W).

In Formula (D), $X^{D1}$ and $X^{D2}$ represent $NR^{D9}$, an oxygen atom, or a sulfur atom. $A^{D1}$ represents $CR^{D7}$ or a N atom, $A^{D2}$ represents $CR^{D8}$ or a N atom, $R^{D9}$ represents a hydrogen atom, an alkyl group, an alkenyl group, an alkynyl group, or an acyl group. $R^{D1}$ to $R^{D8}$ represent a hydrogen atom or a substituent, and at least one of $R^{D1}$, ..., or $R^{D8}$ represents a substituent represented by the following Formula (W).

In Formula (E), $X^{E1}$ and $X^{E2}$ represent an oxygen atom, a sulfur atom, or $NR^{E7}$ . $A^{E1}$ and $A^{E2}$ represent $CR^{E8}$ or a nitrogen atom. $R^{E1}$ to $R^{E8}$ represent a hydrogen atom or a substituent. At least one of $R^{E1}$ ..., or $R^{E8}$ represents a substituent represented by the following Formula (W).

In Formula (F), $X^{F1}$ and $X^{F2}$ represent an oxygen atom, a sulfur atom, or a selenium atom. It is preferable that $X^{F1}$ and $X^{F2}$ represent an oxygen atom or a sulfur atom and more preferable that $X^{F1}$ and $X^{F2}$ represent a sulfur atom. $R^{F1}$ to $R^{F10}$, $R^{Fa}$, and $R^{Fb}$ represent a hydrogen atom or a substituent. At least one of $R^{F1}$ to $R^{F10}$ $R^{Fa}$, or $R^{Fb}$ represents

a substituent represented by Formula (W). p and q represent an integer of 0 to 2.

In Formula (G), $X^{G1}$ and $X^{G2}$ represent $NR^{G9}$, an oxygen atom, or a sulfur atom. $A^{G1}$ represents $CR^{07}$ or a N atom. $A^{G2}$ represents $CR^{G8}$ or a N atom. $R^{G9}$ represents a hydrogen atom, an alkyl group, an alkenyl group, an alkynyl group, an acyl group, an aryl group, or a heteroaryl group. $R^{G1}$ to $R^{G8}$ represent a hydrogen atom or a substituent. At least one of $RG^1$, ..., or $R^{G8}$ represents a substituent represented by the following Formula (W).

In Formula (H), $X^{H1}$ and $X^{H4}$ represent $NR^{H7}$, an oxygen atom, or a sulfur atom. It is preferable that $X^{H1}$ to $X^{H4}$ represent a sulfur atom. $R^{H7}$ represents a hydrogen atom, an alkyl group, an alkenyl group, an alkynyl group, an acyl group, an aryl group, or a heteroaryl group. $R^{H1}$ to $R^{H6}$ represent a hydrogen atom or a substituent. At least one of $R^{H1}$, ..., or $R^{H6}$ represents a substituent represented by the following Formula (W).

In Formula (J), $X^{J1}$ and $X^{J2}$ represent an oxygen atom, a sulfur atom, a selenium atom, or $NR^{J9}$. $X^{J3}$ and $X^{J4}$ represent an oxygen atom, a sulfur atom, or a selenium atom. It is preferable that $X^{J1}$, $X^{J2}$, $X^{J3}$ , and $X^{J4}$ represent a sulfur atom. $R^{J1}$ to $R^{J9}$ represent a hydrogen atom or a substituent. At least one of $R^{J1}$, ..., or $R^{J9}$ represents a substituent represented by the following Formula (W).

In Formula (K), $X^{K1}$ and $X^{K2}$ represent an oxygen atom, a sulfur atom, a selenium atom, or $NR^{K9}$. $X^{K3}$ and $X^{K4}$ represent an oxygen atom, a sulfur atom, or a selenium atom. It is preferable that $X^{K1}$, $X^{K2}$, $X^{K3}$, and $X^{K4}$ represent a sulfur atom. $R^{K1}$ to $R^{K9}$ represent a hydrogen atom or a substituent. At least one of $R^{K1}$, ..., or $R^{K9}$ represents a substituent represented by the following Formula (W).

In Formula (L), $X^{L1}$ and $X^{L2}$ represent an oxygen atom, a sulfur atom, or $NR^{L11}$. It is preferable that $X^{L1}$ and $X^{L2}$ represent an oxygen atom or a sulfur atom. $R^{L1}$ to $R^{L11}$ represent a hydrogen atom or a substituent, and at least one of $R^{L1}$, ..., or $R^{L11}$ represents a substituent represented by the following Formula (W).

In Formula (M), $X^{M1}$ and $C^{M2}$ represent an oxygen atom, a sulfur atom, a selenium atom, or $NR^{M9}$. It is preferable that $X^{M1}$ and $X^{M2}$ represent a sulfur atom. $R^{M1}$ to $R^{M9}$ represent a hydrogen atom or a substituent. At least one of $R^{M1}$, ..., or $R^{M9}$ represents a substituent represented by the following Formula (W).

In Formula (N), $X^{N1}$ and $X^{N2}$ represent an oxygen atom, a sulfur atom, a selenium atom, or $NR^{N13}$. It is preferable that $X^{N1}$ and $X^{N2}$ represent a sulfur atom. $R^{N1}$ to $R^{N13}$ represent a hydrogen atom or a substituent. At least one of $R^{N1}$, ..., or $R^{N13}$ represents a substituent represented by the following Formula (W).

In Formula (P), $X^{P1}$ and $X^{P2}$ represent an oxygen atom, a sulfur atom, a selenium atom, or $NR^{P13}$. It is preferable that $X^{P1}$ and $X^{P2}$ represent a sulfur atom. $R^{P1}$ to $R^{P13}$ represent a hydrogen atom or a substituent. At least one of $R^{P1}$, ..., or $R^{P13}$ represents a substituent represented by the following Formula (W).

In Formula (Q), $X^{Q1}$ and $X^{Q2}$ represent an oxygen atom, a sulfur atom, a selenium atom, or $NR^{Q13}$. It is preferable that $X^{Q1}$ and $X^{Q2}$ represent a sulfur atom. $R^{Q1}$ to $R^{Q13}$ represent a hydrogen atom or a substituent. At least one of $R^{Q1}$, ..., or $R^{Q13}$ represents a substituent represented by the following Formula (W).

In Formula (R), $X^{R1}$, $X^{R2}$, and $X^{R3}$ represent an oxygen atom, a sulfur atom, a selenium atom, or $NR^{R9}$. It is preferable that $X^{R1}$, $X^{R2}$, and $X^{R3}$ represent a sulfur atom. $R^{R1}$ to $R^{R9}$ represent a hydrogen atom or a substituent. At least one of $R^{R1}$, ..., or $R^{R9}$ represents a substituent represented by the following Formula (W).

In Formula (S), $X^{S1}$, $X^{S2}$, $X^{S3}$, and $X^{S4}$ represent an oxygen atom, a sulfur atom, a selenium atom, or $NR^{S7}$. It is preferable that $X^{S1}$, $X^{S2}$, $X^{S3}$, and $X^{S4}$ represent a sulfur atom. $R^{S1}$ to $R^{S7}$ represent a hydrogen atom or a substituent. At least one of $R^{S1}$, ..., or $R^{S7}$ represents a substituent represented by the following Formula (W).

In Formula (T), $X^{T1}$, $X^{T2}$, $X^{T3}$, and $X^{T4}$ represent an oxygen atom, a sulfur atom, a selenium atom, or $NR^{T7}$. It is preferable that $X^{T1}$, $X^{T2}$, $X^{T3}$, and $X^{T4}$ represent a sulfur atom. $R^{T1}$ to $R^{T7}$ represent a hydrogen atom or a substituent. At least one of $R^{T1}$, ..., or $R^{T7}$ represents a substituent represented by the following Formula (W).

Hereinafter, in Formulae (C) to (T), $R^{C1}$ to $R^{C6}$, $R^{D1}$ to $R^{D8}$, $R^{E1}$ to $R^{E8}$, $R^{F1}$ to $R^{F10}$, $R^{Fa}$ and $F^{Fb}$, $R^{G1}$ to $R^{G8}$, $R^{H1}$ to $R^{H6}$, $R^{J1}$ to $R^{J9}$, $R^{K1}$ to $R^{K9}$, $R^{L1}$ to $R^{L11}$, $R^{M1}$ to $R^{M9}$, $R^{N1}$ to $R^{113}$, $R^{P1}$ to $R^{P13}$, $R^{Q1}$ to $R^{Q13}$, $R^{R1}$ to $R^{R9}$, $R^{S1}$ to $R^{S7,}$ and $R^{T1}$ to $R^{T7}$ (hereinafter, referred to as substituents $R^C$ to $R^T$) which represent a hydrogen atom or a substituent.

Examples of the substituent which may be employed by the substituents $R^C$ to $R^T$ include a halogen atom, an alkyl group (an alkyl group having 1 to 40 carbon atoms such as methyl, ethyl, propyl, butyl, pentyl, hexyl, heptyl, octyl, nonyl, decyl, undecyl, dodecyl, tridecyl, tetradecyl, or pentadecyl, and in this case, 2,6-dimethyloctyl, 2-decyltetradecyl, 2-hexyldodecyl, 2-ethyloctyl, 2-decyltetradecyl, 2-butyldecyl, 1-octylnonyl, 2-ethyloctyl, 2-octyltetradecyl, 2-ethylhexyl, cycloalkyl, bicycloalkyl, and tricycloalkyl are included), an alkenyl group (such as 1-pentenyl, cycloalkenyl, or bicycloalkenyl), an alkynyl group (such as 1-pentynyl, trimethylsilylethynyl, triethylsilylethynyl, tri-i-propylsilylethynyl, or 2-p-propylphenylethynyl), an aryl group (for example, an aryl group having 6 to 20 carbon atoms such as phenyl, naphthyl, p-pentylphenyl, 3,4-dipentylphenyl, p-heptoxyphenyl, or 3,4-diheptoxyphenyl), a heterocyclic group (such as a 2-hexylfuranyl group), a cyano group, a hydroxy group, a nitro group, an acyl group (such as hexanoyl or benzoyl), an alkoxy group (such as buthoxy), an aryloxy group, a silyloxy group, a heterocyclic oxy group, an acyloxy group, a carbamoyloxy group, an amino group (such as an anilino group), an acylamino group, an aminocarbonylamino group (such as an ureido group), an alkoxy aryloxycarbonylamino group, an alkyl arylsulfonylamino group, a mercapto group, an alkyl arylthio group (such as methylthio or octylthio), a heterocyclic thio group, a sulfamoyl group, a sulfo group, an alkyl arylsulfinyl group, an alkyl arylsulfonyl group, an alkyl aryloxycarbonyl group, a carbamoyl group, an aryl heterocyclic

azo group, an imido group, a phosphino group, a phosphinyl group, a phosphinyloxy group, a phosphinylamino group, a phosphono group, a silyl group (such as a ditrimethylsiloxymethylbutoxy group), a hydrazino group, an ureido group, a boronic acid group ($-B(OH)_2$), a phosphate group ($-OPO(OH)_2$), a sulfato group($-OSO_3H$ and other known substituents.

These substituents may further include the above-described substituents.

Among these, as the substituents which may be employed by the substituents $R^7$ to $R^T$, an alkyl group, an aryl group, an alkenyl group, an alkynyl group, a heterocyclic group, an alkoxy group, an alkylthio group, and a group represented by the following Formula (W) are preferable, an alkyl group having 1 to 12 carbon atoms, an aryl group having 6 to 20 carbon atoms, an alkenyl group having 2 to 12 carbon atoms, an alkynyl group having 2 to 12 carbon atoms, an alkoxy group having 1 to 11 carbon atoms, a heterocyclic group having 5 to 12 carbon atoms, an alkylthio group having 1 to 12 carbon atoms, and a group represented by the following Formula (W) are more preferable, a group represented by the following Formula (W) is particularly preferable, and a group represented by the following Formula (W) is more particularly preferable.

The alkyl group, the alkenyl group, the alkynyl group, the acyl group, and the aryl group as $R^{D9}$, $R^{G9}$, and $R^{H7}$ described above respectively have the same definitions as those for the alkyl group, the alkenyl group, the alkynyl group, the acyl group, and the aryl group described in the section of the substituents which may be employed by the substituents $R^C$ to $R^T$.

Moreover, the heteroaryl group has the same definition as that for the heteroaryl group described in the section of the substituents of $R^{A1}$ to $R^{A6}$.

Formula (W) describes a group represented by $-L-R^W$.

In Formula (W), L represents a divalent linking group represented by any of the following Formulae (L-1) to (L-25) or a divalent linking group in which two or more (preferably 2 to 10, more preferably 2 to 6, and still more preferably 2 or 3) linking groups represented by any of Formulae (L-1) to (L25) are bonded to each other. $R^W$ represents a substituted or unsubstituted alkyl group, a cyano group, a vinyl group, an ethynyl group, an oxyethylene group, an oligooxyethylene group in which a repeating number v of oxyethylene units is 2 or greater, a siloxane group, an oligosiloxane group having 2 or more silicon atoms, or a substituted or unsubstituted trialkylsilyl group.

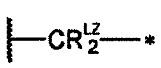 (L-1)

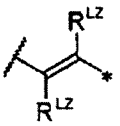 (L-2)

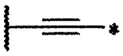 (L-3)

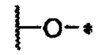 (L-4)

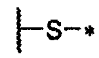 (L-5)

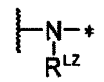 (L-6)

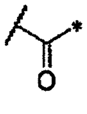 (L-7)

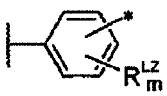 (L-13)

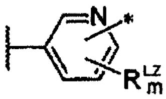 (L-14)

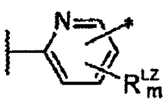 (L-15)

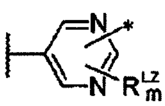 (L-16)

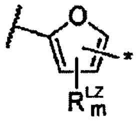 (L-17)

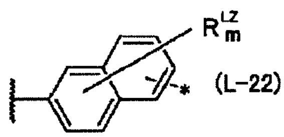 (L-22)

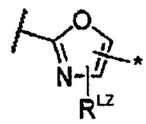 (L-23)

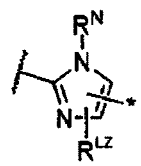 (L-24)

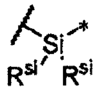 (L-25)

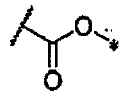
(L-8)

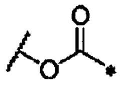
(L-9)

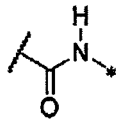
(L-10)

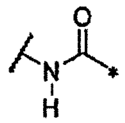
(L-11)

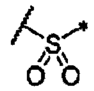
(L-12)

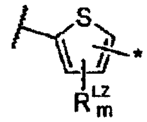
(L-18)

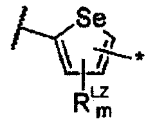
(L-19)

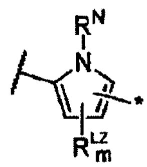
(L-20)

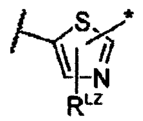
(L-21)

In Formulae (L-1) to (L-25), each wavy line represents a binding position with respect to a ring forming each skeleton represented by any of Formulae (C) to (T). Moreover, in the present specification, in a case where L represents a divalent linking group in which two or more divalent linking groups represented by any of Formulae (L-1) to (L25) are bonded to each other, each wavy line may represent a binding position with a ring forming each skeleton represented by any of Formulae (C) to (T) or a binding position with respect to any of the divalent linking groups represented by Formulae (L-1) to (L25).

The symbol "*" represents a binding position with respect to $R^W$ or a binding position with respect to a wavy line represented by any of Formula (L-1) to (L-25).

m in Formula (L-13) represents 4, m's in Formulae (L-14) and (L-15) represent 3, m's in Formulae (L-16) to (L-20) represent 2, and m in Formula (L-22) represents 6.

$R^{LZ}$'s in Formulae (L-1), (L-2), (L-6), (L-13) to (L-19), and (L-21) to (L-24) each independently represent a hydrogen atom or a substituent, and $R^{LZ}$'s in Formulae (L-1) and (L-2) may be respectively bonded to $R^W$ adjacent to L and form a condensed ring.

$R^N$'s represent a hydrogen atom or a substituent and $R^{si}$'s each independently represent a hydrogen atom, an alkyl group, an alkenyl group, or an alkynyl group.

It is more preferable that the divalent linking groups represented by Formulae (L-17) to (L21), (L-23), and (L-24) are divalent linking groups represented by the following Formulae (L-17A) to (L-21 A), (L-23A), and (L-24A).

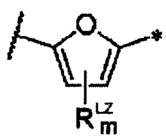
(L-17A)

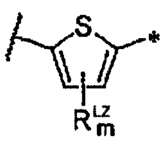
(L-18A)

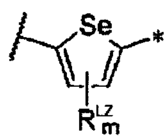
(L-19A)

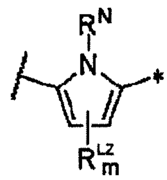
(L-20A)

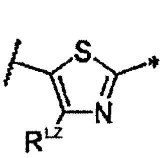
(L-21A)

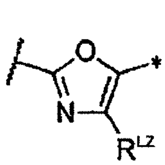
(L-23A)

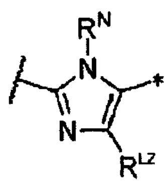
(L-24A)

Here, in a case where a substituted or unsubstituted alkyl group, a cyano group, an oxyethylene group, an

oligooxyethylene group in which the repeating number v of oxyethylene units is 2 or greater, a siloxane group, an oligosiloxane group having 2 or more silicon atoms, or a substituted or unsubstituted trialkylsilyl group is present at the terminal of a substituent, this substituent can be interpreted as $-R^W$ alone in Formula (W) or as $-L-R^W$ in Formula (W). In the present invention, in a case where a substituted or unsubstituted alkyl group having N carbon atoms in the main chain is present at the terminal of a substituent, this substituent is determined to be interpreted not as $-R^W$ alone but as $-L-R^W$ in Formula (W), including as many linking groups as possible from the terminal of the substituent. Specifically, this substituent is interpreted as a substituent in which "one (L-1) corresponding to L in Formula (W)" is bonded to "a substituted or unsubstituted alkyl group having N-1 carbon atoms in the main chain corresponding to $R^W$ in Formula (W)." For example, in a case where an n-octyl group which is an alkyl group having 8 carbon atoms is present at the terminal of a substituent, this substituent is interpreted as a substituent in which one (L-1) having two $R^{LZ}$'s representing a hydrogen atom is bonded to an n-heptyl group having 7 carbon atoms. Further, in a case where a substituent represented by Formula (W) is an alkoxy group having 8 carbon atoms, this substituent is interpreted as a substituent in which one linking group represented by -O- of Formula (L-4), one linking group represented by (L-1) in which two $R^{LZ}$'s represent a hydrogen atom, and an n-heptyl group having 7 carbon atoms are bonded to each other.

Meanwhile, in the present invention, in a case where an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group is present at the terminal of a substituent, this substituent is interpreted as $R^W$ alone in Formula (W), including linking groups as many as possible from the terminal of the substituent. For example, in a case where a $-(OCH_2CH_2)-(OCH_2CH_2)-(OCH_2CH_2)-OCH_3$ group is present at the terminal of a substituent, this substituent is interpreted as an oligooxyethylene group alone in which the repeating number v of oxyethylene units is 3.

In a case where a linking group to which a divalent linking group in which L is represented by any of Formulae (L-1) to (L-25) is formed, the number of bonds of the divalent linking group represented by any of Formulae (L-1) to (L-25) is preferably in a range of 2 to 4 and more preferably 2 or 3.

Examples of the substituent $R^{LZ}$ in Formulae (L-1), (L-2), (L-6), and (L-13) to (L-24) include those exemplified as the substituents which may be employed by the substituents $R^C$ to $R^T$ of Formulae (C) to (T). Among these, it is preferable that the substituent $R^{LZ}$ in Formula (L-6) represents an alkyl group. In the case where $R^{LZ}$ in Formula (L-6) represents an alkyl group, the number of carbon atoms of the alkyl group is preferably in a range of 1 to 9, more preferably in a range of 4 to 9 from the viewpoints of chemical stability and carrier transportability, and still more preferably in a range of 5 to 9. In the case where $R^{LZ}$ in (L-6) is an alkyl group, it is preferable that the alkyl group is a linear alkyl group from the viewpoint of improving the carrier transportability.

Examples of $R^N$ include those exemplified as the substituents which may be employed by the substituents $R^C$ to $R^T$. Among these, it is preferable that $R^N$ represents a hydrogen atom or a methyl group.

It is preferable that $R^{si}$ represents an alkyl group. The alkyl group which may be employed by $R^{si}$ is not particularly limited, but the preferable range of the alkyl group which may be employed by $R^{si}$ is the same as the preferable range of an alkyl group which may be employed by a silyl group in a case where $R^W$ represents a silyl group. The alkenyl group which may be employed as $R^{si}$ is not particularly limited, but a substituted or unsubstituted alkenyl group is preferable and a branched alkenyl group is more preferable as the alkenyl group. The number of carbon atoms thereof is preferably 2 or 3. The alkynyl group which may be employed as $R^{si}$ is not particularly limited, but a substituted or unsubstituted alkynyl group is preferable and a branched alkynyl group is more preferable as the alkynyl group. The number of carbon atoms thereof is preferably 2 or 3.

It is preferable that L represents a divalent linking group represented by any of Formulae (L-1) to (L-5), (L-13), (L-17), and (L-18) or a divalent linking group in which two or more divalent linking groups represented by any of Formulae (L-1) to (L-5), (L-13), (L-17), and (L-18) are bonded to each other, more preferable that L represents a divalent linking group represented by any of Formulae (L-1), (L-3), (L-13), and (L-18) or a divalent linking group in which two or more divalent linking groups represented by any of Formulae (L-1), (L-3), (L-13), and (L-18) are bonded to each other, and particularly preferable that L represents a divalent linking group represented by any of Formulae (L-1), (L-3), (L-13), and (L-18) or a divalent linking group in which a divalent linking group represented by any one of Formulae (L-3), (L-13), and (L-18) is bonded to a divalent linking group represented by Formula (L-1). In the divalent linking group in which a divalent linking group represented by any one of Formulae (L-3), (L-13), and (L-18) is bonded to a divalent linking group represented by Formula (L-1), it is preferable that the divalent linking group represented by Formula (L-1) is bonded to the $R^W$ side.

From the viewpoints of chemical stability and carrier transportability, it is particularly preferable that L represents a divalent linking group which has a divalent linking group represented by Formula (L-1), more particularly preferable that L represents a divalent linking group represented by Formula (L-1), still more particularly preferable that L represents a divalent linking group represented by Formula (L-18) or (L-1), the divalent linking group is bonded to $R^W$ through (L-1), and $R^W$ represents a substituted or unsubstituted alkyl group, and even still more particularly preferable that L represents a divalent linking group represented by Formula (L-18A) or (L-1), the divalent linking group is bonded to $R^W$

through (L-1), and $R^W$ represents a substituted or unsubstituted alkyl group.

In Formula (W), it is preferable that $R^W$ represents a substituted or unsubstituted alkyl group. In Formula (W), in a case where L adjacent to $R^W$ represents a divalent linking group represented by Formula (L-1), it is preferable that $R^W$ represents a substituted or unsubstituted alkyl group, an oxyethylene group, an oligooxyethylene group in which the repeating number of oxyethylene units is 2 or greater, a siloxane group, or an oligosiloxane group having 2 or more silicon atoms and more preferable that $R^W$ represents a substituted or unsubstituted alkyl group.

In Formula (W), in a case where L adjacent to $R^W$ represents a divalent linking group represented by any of Formulae (L-2) and (L-4) to (L-25), it is more preferable that $R^W$ represents a substituted or unsubstituted alkyl group.

In Formula (W), in a case where L adjacent to $R^W$ represents a divalent linking group represented by Formula (L-3), it is preferable that $R^W$ represents a substituted or unsubstituted alkyl group or a substituted or unsubstituted silyl group.

In a case where $R^W$ represents a substituted or unsubstituted alkyl group, the number of carbon atoms is preferably in a range of 4 to 17, more preferably in a range of 6 to 14 from the viewpoints of chemical stability and carrier transportability, and still more preferably in a range of 6 to 12. From the viewpoints of improving linearity of a molecule and carrier transportability, it is preferable that $R^W$ represents a long-chain alkyl group, particularly a long-chain linear alkyl group, within the above-described range.

In a case where $R^W$ represents an alkyl group, the alkyl group may be linear, branched, or cyclic, but it is preferable that the alkyl group is linear from the viewpoints of improving the linearity of a molecule and the carrier transportability.

As a combination of $R^W$ and L of Formula (W), from the viewpoint of improving the carrier mobility, it is preferable that L in Formulae (C) to (T) represents a divalent linking group represented by Formula (L-1) and $R^W$ represents a linear alkyl group having 4 to 17 carbon atoms or L represents a divalent linking group in which a divalent linking group represented by any one of Formulae (L-3), (L-13), or (L-18) is bonded to a divalent linking group represented by Formula (L-1) and $R^W$ represents a linear alkyl group.

In the case where L represents a divalent linking group represented by Formula (L-1) and $R^W$ represents a linear alkyl group having 4 to 17 carbon atoms, it is more preferable that $R^W$ represents a linear alkyl group having 6 to 14 carbon atoms from the viewpoint of improving the carrier mobility and particularly preferable that $R^W$ represents a linear alkyl group having 6 to 12 carbon atoms.

In the case where L represents a divalent linking group in which a divalent linking group represented by any one of Formulae (L-3), (L-13), and (L-18) is bonded to a divalent linking group represented by Formula (L-1) and $R^W$ represents a linear alkyl group, it is more preferable that $R^W$ represents a linear alkyl group having 4 to 17 carbon atoms, more preferable that $R^W$ represents a linear alkyl group having 6 to 14 carbon atoms from the viewpoints of the chemical stability and carrier mobility, and particularly preferable that $R^W$ represents a linear alkyl group having 6 to 12 carbon atoms from the viewpoint of improving the carrier mobility.

Meanwhile, from the viewpoint of improving solubility in an organic solvent, it is preferable that $R^W$ represents a branched alkyl group.

In a case where $R^W$ represents an alkyl group having a substituent, a halogen atom may be exemplified as the substituent and a fluorine atom is preferable. Moreover, in a case where $R^W$ represents an alkyl group having a fluorine atom, all hydrogen atom of the alkyl group may be substituted with fluorine atoms to form a perfluoroalkyl group. In this case, it is preferable that $R^W$ represents an unsubstituted alkyl group.

In a case where $R^W$ represents an ethyleneoxy group or an oligoethyleneoxy group, in the present specification, the "oligooxyethylene group" represented by $R^W$ indicates a group represented by $-(OCH_2CH_2)_vOY$ (the repeating number v of oxyethylene units is an integer of 2 or greater and Y at the terminal represents a hydrogen atom or a substituent). Further, in a case where Y at the terminal of the oligooxyethylene group represents a hydrogen atom, this becomes a hydroxy group. The repeating number v of the oxyethylene units is preferably in a range of 2 to 4 and more preferably 2 or 3. It is preferable that the hydroxy group at the terminal of the oligooxyethylene group is sealed, that is, Y represents a substituent. In this case, it is preferable that the hydroxy group is sealed by an alkyl group having 1 to 3 carbon atoms, that is, Y represents an alkyl group having 1 to 3 carbon atoms, more preferable that Y represents a methyl group or an ethyl group, and particularly preferable that Y represents a methyl group.

In a case where $R^W$ represents a siloxane group or an oligosiloxane group, the repeating number of siloxane units is preferably 2 to 4 and more preferably 2 or 3. Further, it is preferable that a hydrogen atom or an alkyl group is bonded to a Si atom. In a case where an alkyl group is bonded to a Si atom, the number of carbon atoms of the alkyl group is preferably in a range of 1 to 3, and it is preferable that a methyl group or an ethyl group is bonded to the Si atom. The same alkyl groups may be bonded to a Si atom or alkyl groups which are different from each other or hydrogen atoms may be bonded thereto. In addition, all siloxane units constituting an oligosiloxane group may be the same as or different from each other, but it is preferable that all siloxane units are the same as each other.

In a case where L adjacent to $R^W$ represents a divalent linking group represented by Formula (L-3), it is also preferable that $R^W$ represents a substituted or unsubstituted silyl group. In the case where $R^W$ represents a substituted

or unsubstituted silyl group, it is preferable that $R^W$ represents a substituted silyl group. The substituted of the silyl group is not particularly limited, but a substituted or unsubstituted alkyl group is preferable and a branched alkyl group is more preferable as the substituent. In the case where $R^W$ represents a trialkylsilyl group, the number of carbon atoms of an alkyl group bonded to a Si atom is preferably in a range of 1 to 3, and it is preferable that a methyl group, an ethyl group, or an isopropyl group is bonded to a Si atom. Alkyl groups which are the same as or different from each other may be bonded to a Si atom. In a case where $R^W$ represents a trialkylsilyl group having other substituents in addition to an alkyl group, the substituents are not particularly limited.

In Formula (W), the total number of carbon atoms included in L and $R^W$ is preferably in a range of 5 to 18. When the total number of carbon atoms included in L and $R^W$ is greater than or equal to the lower limit of the above-described range, the carrier mobility is increased and the driving voltage is lowered. The total number of carbon atoms included in L and $R^W$ is less than or equal to the upper limit of the above-described range, the solubility in an organic solvent is increased.

The total number of carbon atoms included in L and $R^W$ is preferably in a range of 5 to 14, more preferably in a range of 6 to 14, particularly preferably in a range of 6 to 12, and more particularly preferably in a range of 8 to 12.

Among the substituents $R^C$ to $R^T$ in respective compounds represented by Formulae (C) to (T), the number of groups represented by Formula (W) is preferably in a range of 1 to 4 from the viewpoints of improving the carrier mobility and the solubility in an organic solvent, more preferably 1 or 2, and particularly preferably 2.

Among the substituents the $R^C$ to $R^T$, the positions of groups represented by Formula (W) are not particularly limited.

In the compound represented by Formula (C), a group in which any of $R^{C1}$, $R^{C2}$, $R^{C3}$, and $R^{C6}$ is represented by Formula (W) is preferable and a group in which both of $R^{C1}$ and $R^{C2}$ or both of $R^{C3}$ and $R^{C6}$ are represented by Formula (W) is more preferable.

In the compound represented by Formula (D), a group in which $R^{D6}$ is represented by Formula (W) is preferable and a group in which both of $R^{D5}$ and $R^{D6}$ are represented by Formula (W) is more preferable.

In the compound represented by Formula (E), a group in which $R^{E6}$ is represented by Formula (W) is preferable and a group in which both of $R^{E5}$ and $R^{E6}$ are represented by Formula (W) is more preferable. Further, in a case of a substituent other than the group in which both of $R^{E5}$ and $R^{E6}$ are represented by Formula (W), a group in which two $R^{E7}$'s are represented by Formula (W) is also preferable.

In the compound represented by Formula (F), a substituent in which at least one of $R^{F2}$, $R^{F3}$, $R^{F8}$, or $R^{F9}$ is represented by Formula (W) is preferable.

In the compound represented by Formula (G), a group in which $R^{G5}$ or $R^{G6}$ is represented by Formula (W) is preferable from the viewpoints of improving the carrier mobility and the solubility in an organic solvent.

In the compound represented by Formula (H), a group in which $R^{H4}$ or $R^{H6}$ is represented by Formula (W) is preferable and a group in which $R^{H4}$ or $R^{H6}$ and $R^{H3}$ or $R^{H5}$ are represented by Formula (W) is more preferable.

In the compound represented by Formula (J), a group in which $R^{J8}$ is represented by Formula (W) is preferable and a group in which both of $R^{J8}$ and $R^{J4}$ are represented by Formula (W) is more preferable.

In the compound represented by Formula (K), a group in which $R^{K7}$ is represented by Formula (W) is preferable and a group in which both of $R^{K7}$ and $R^{K3}$ are represented by Formula (W) is more preferable.

In the compound represented by Formula (L), a group in which at least one of $R^{L2}$, $R^{L3}$, $R^{L6}$, or $R^{L7}$ is represented by Formula (W) is more preferable.

In the compound represented by Formula (M), a group in which $R^{M2}$ is represented by Formula (W) is preferable and a group in which both of $R^{M2}$ and $R^{M6}$ are represented by Formula (W) is more preferable.

In the compound represented by Formula (N), a group in which $R^{N3}$ is represented by Formula (W) is preferable and a group in which both of $R^{N3}$ and $R^{N9}$ are represented by Formula (W) is more preferable.

In the compound represented by Formula (P), a group in which $R^{P2}$ or $R^{P3}$ is represented by Formula (W) is preferable and a group in which both of $R^{P2}$ and $R^{P8}$ or both of $R^{P3}$ and $R^{P9}$ are represented by Formula (W) is more preferable.

In the compound represented by Formula (Q), a group in which $R^{Q3}$ is represented by Formula (W) is preferable and a group in which both of $R^{Q3}$ and $R^{Q9}$ are represented by Formula (W) is more preferable.

In the compound represented by Formula (R), a group in which $R^{R2}$ is represented by Formula (W) is preferable and a group in which both of $R^{R2}$ and $R^{R7}$ are represented by Formula (W) is more preferable.

In the compound represented by Formula (S), a group in which $R^{S2}$ is represented by Formula (W) is preferable and a group in which both of $R^{S2}$ and $R^{S5}$ are represented by Formula (W) is more preferable.

In the compound represented by Formula (T), a group in which $R^{T2}$ is represented by Formula (W) is preferable and a group in which both of $R^{T2}$ and $R^{T5}$ are represented by Formula (W) is more preferable.

Among the substituents $R^C$ to $R^T$, the number of substituents other than the groups represented by Formula (W) is preferably in a range of 0 to 4 and more preferably in a range of 0 to 2.

Hereinafter, specific examples of respective compounds represented by Formulae (C) to (T) will be described,

but the compounds which can be used in the present invention should not be limitatively interpreted by these specific examples.

Specific examples of compounds C represented by Formula (C) are described.

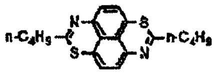

Compound C1

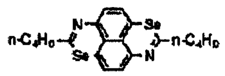

Compound C2

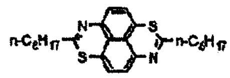

Compound C3

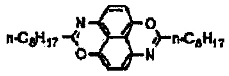

Compound C4

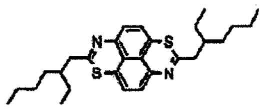

Compound C5

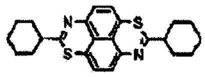

Compound C6

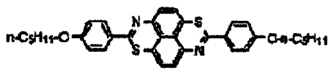

Compound C7

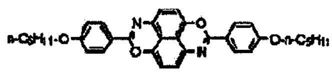

Compound C8

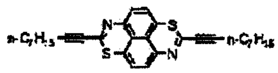

Compound C9

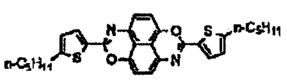

Compound C10

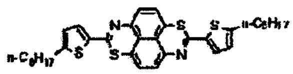

Compound C11

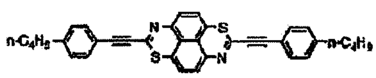

Compound C12

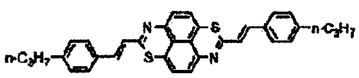

Compound C13

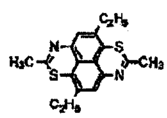

Compound C14

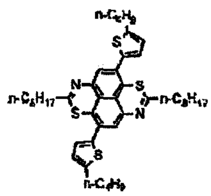

Compound C15

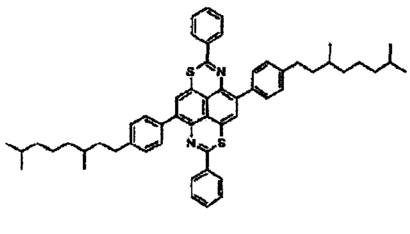

Compound C16

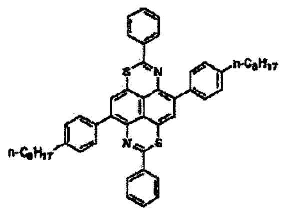

Compound C17

The molecular weight of a compound represented by Formula (C) is preferably 3000 or less, more preferably 2000 or less, still more preferably 1000 or less, and particularly preferably 850 or less. When the molecular weight is in the above-described range, the solubility in a solvent can be improved.

Meanwhile, from the viewpoint of stable film quality of a thin film, the molecular weight thereof is preferably 300 or greater, more preferably 350 or greater, and still more preferably 400 or greater.

Specific examples of compounds D represented by Formula (D) are described.

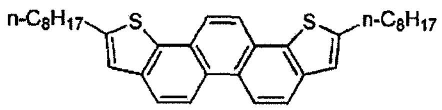

Compound D1

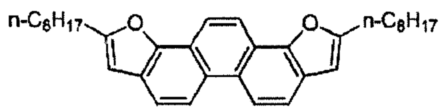

Compound D2

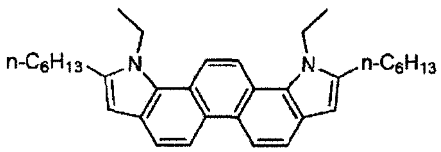

Compound D3

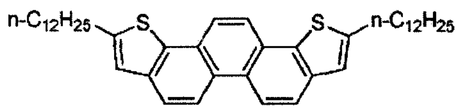

Compound D4

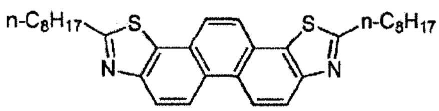

Compound D5

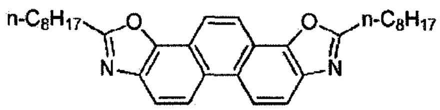

Compound D6

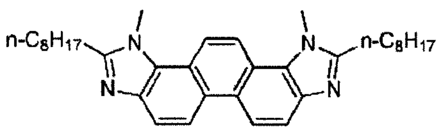

Compound D7

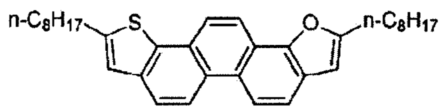

Compound D8

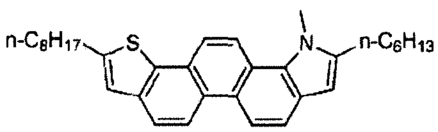

Compound D9

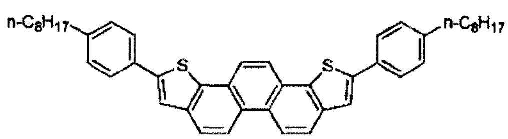

Compound D10

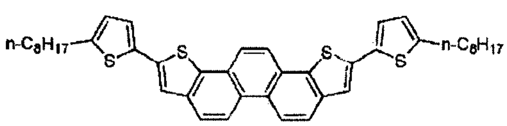

Compound D11

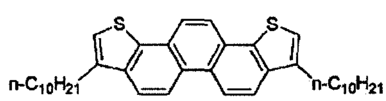

Compound D12

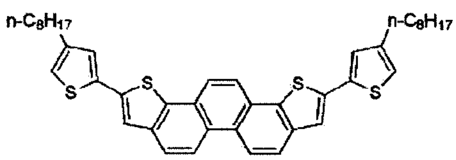

Compound D13

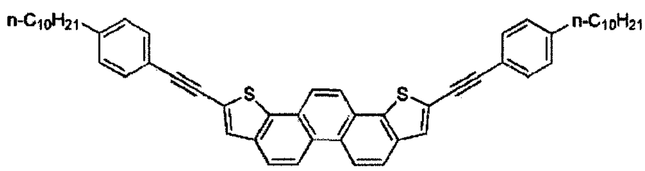

Compound D14

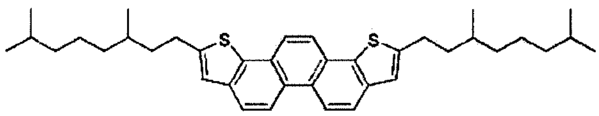

Compound D15

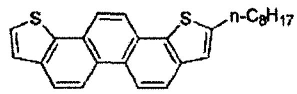

Compound D16

From the viewpoint of improving the solubility in a solvent, it is preferable that the upper limit of the molecular weight of a compound represented by Formula (D) is the same as that of the compound represented by Formula (C). Meanwhile, from the viewpoint of stable film quality of a thin film, the molecular weight thereof is preferably 400 or greater, more preferably 450 or greater, and still more preferably 500 or greater.

Specific examples of a compound E represented by Formula (E), a compound F represented by Formula (F), a compound G represented by Formula (G), and a compound H represented by Formula (H) are respectively described in order.

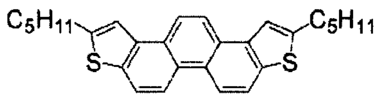

Compound E1

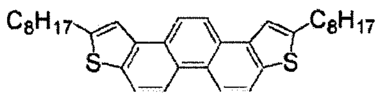

Compound E2

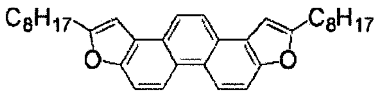

Compound E3

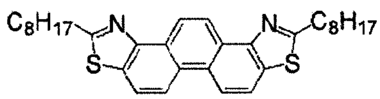

Compound E4

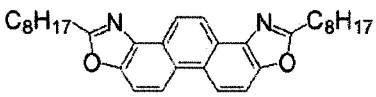

Compound E5

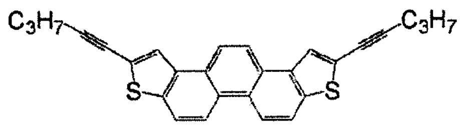

Compound E6

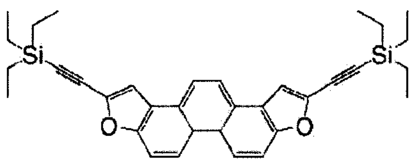

Compound E7

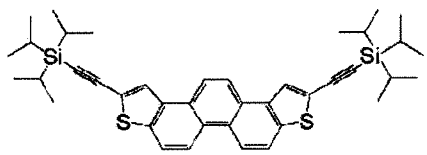

Compound E8

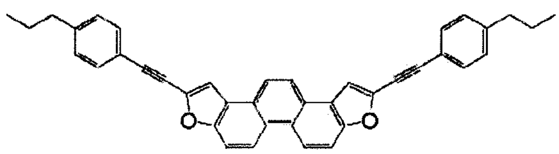

Compound E9

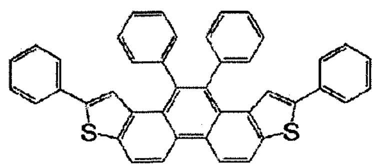

Compound E10

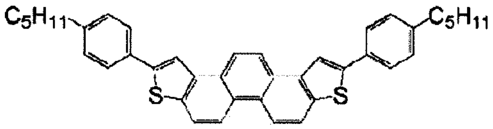

Compound E11

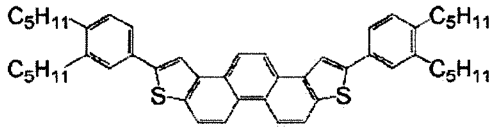

Compound E12

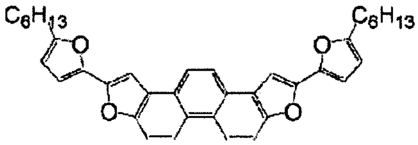

Compound E13

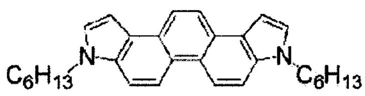

Compound E14

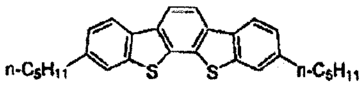

Compound F1

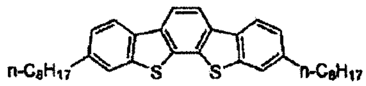

Compound F2

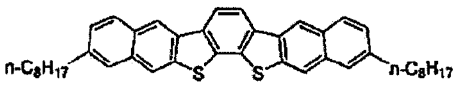

Compound F3

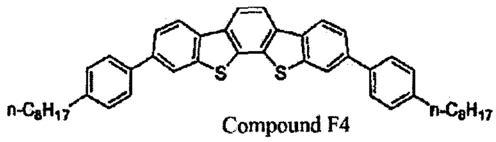

Compound F4

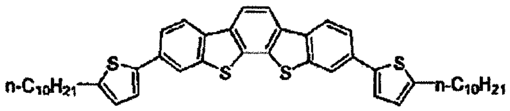

Compound F5

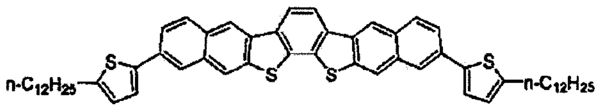

Compound F6

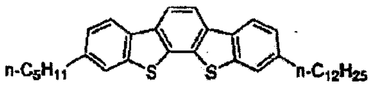

Compound F7

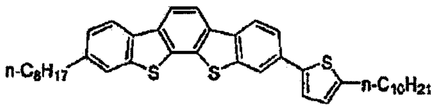

Compound F8

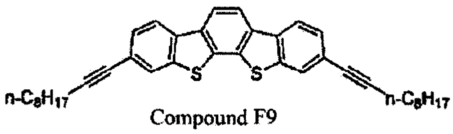

Compound F9

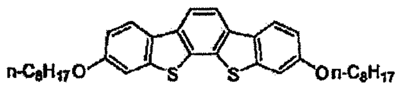

Compound F10

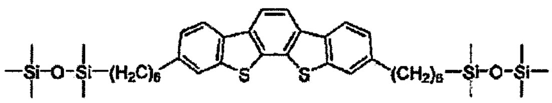

Compound F11

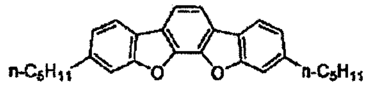

Compound F12

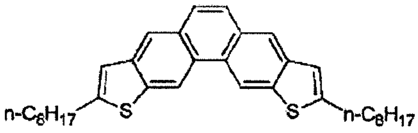

Compound G1

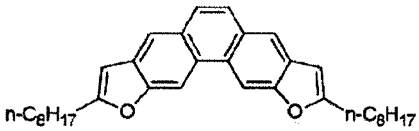

Compound G2

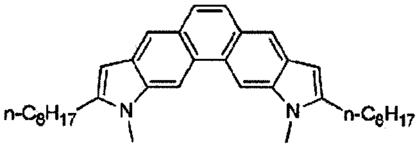

Compound G3

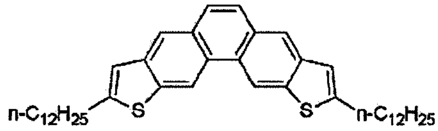

Compound G4

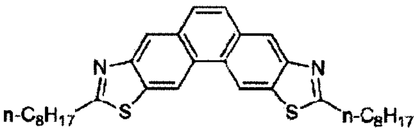

Compound G5

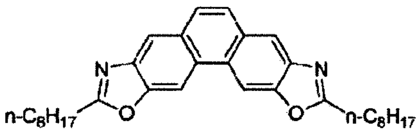

Compound G6

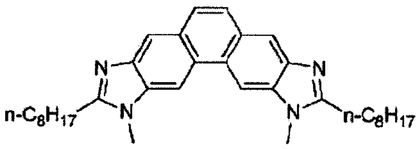

Compound G7

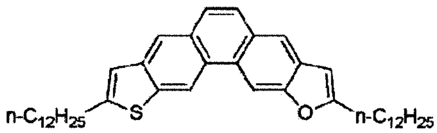

Compound G8

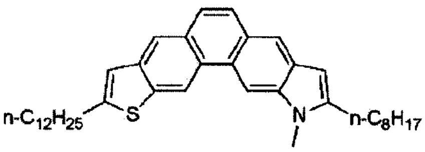

Compound G9

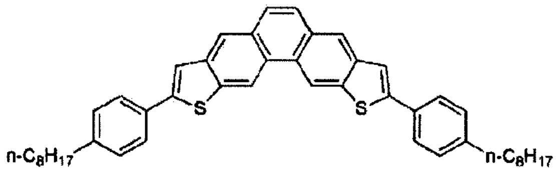

Compound G10

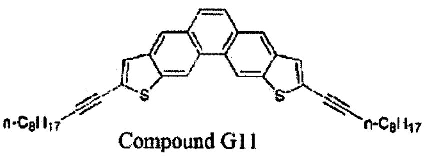

Compound G11

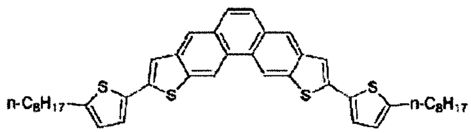

Compound G12

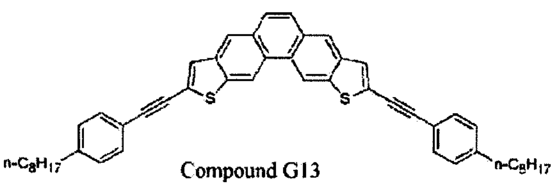

Compound G13

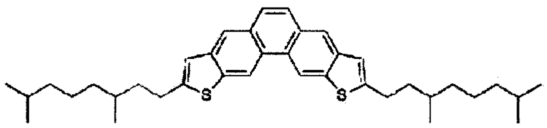

Compound G14

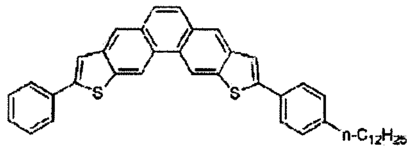

Compound G15

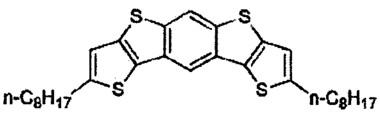

Compound H1

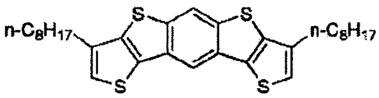

Compound H2

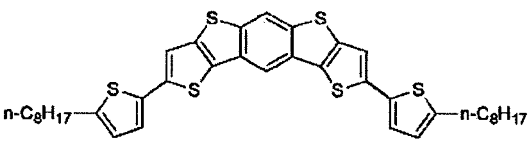

Compound H3

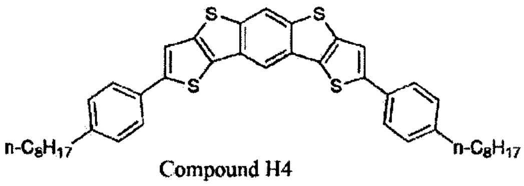

Compound H4

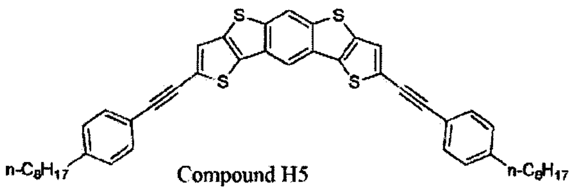

Compound H5

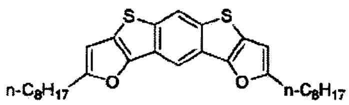

Compound H6

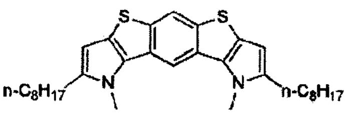

Compound H7

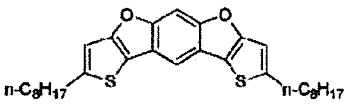

Compound H8

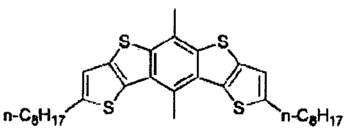

Compound H9

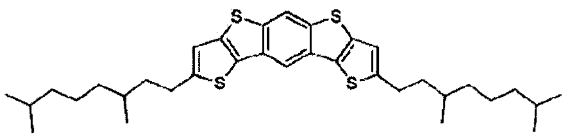

Compound H10

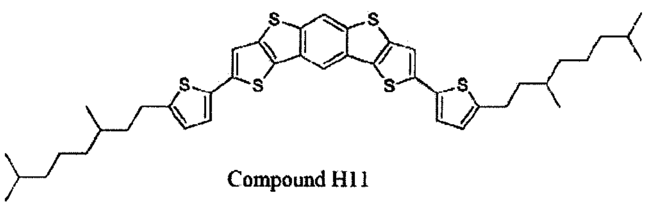

Compound H11

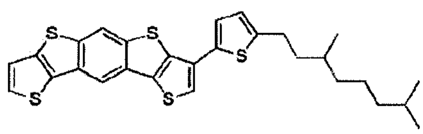

Compound H12

From the viewpoint of improving the solubility in a solvent, it is preferable that the upper limits of the molecular weights of the compounds E, F, G, and H are respectively the same as that of the compound C represented by Formula (C). Meanwhile, from the viewpoint of stable film quality of a thin film, the lower limits of the molecular weights thereof are respectively the same as that of the compound represented by Formula (D).

Specific examples of a compound J represented by Formula (J) and a compound K represented by Formula (K) are described.

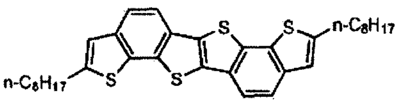

Compound J1

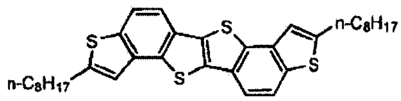

Compound K1

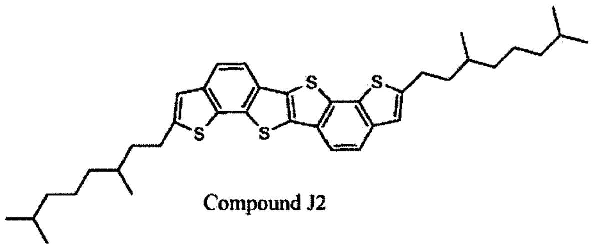

Compound J2

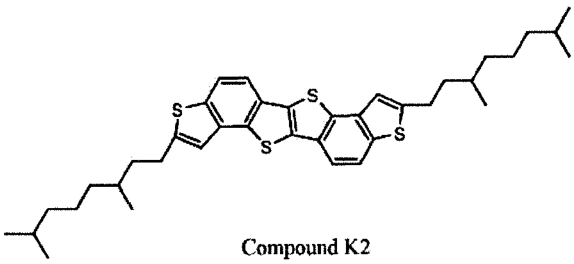

Compound K2

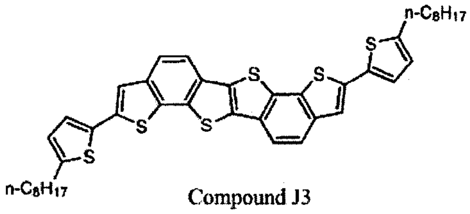

Compound J3

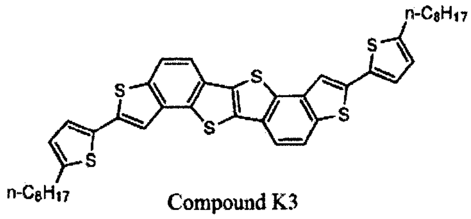

Compound K3

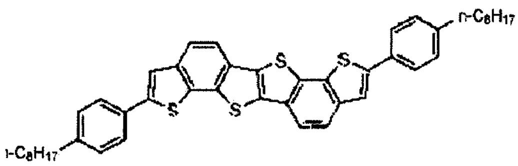

Compound J4

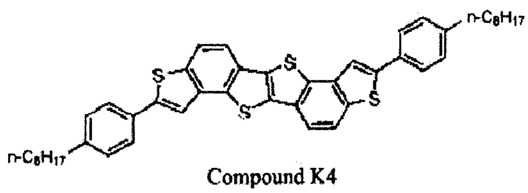

Compound K4

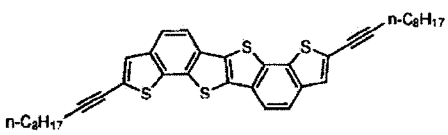

Compound J5

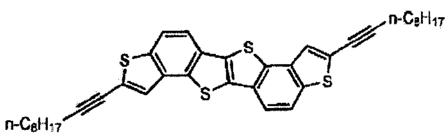

Compound K5

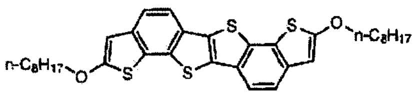

Compound J6

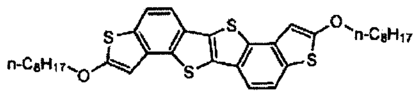

Compound K6

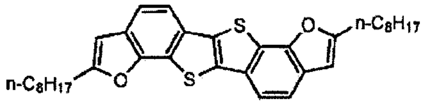

Compound J7

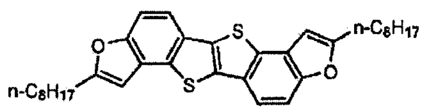

Compound K7

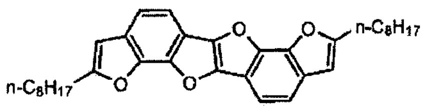

Compound J8

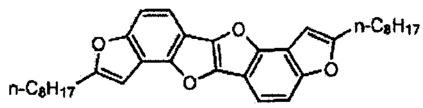

Compound K8

From the viewpoint of improving the solubility in a solvent, it is preferable that the upper limits of the molecular weights of the compounds J and K are respectively the same as that of the compound C represented by Formula (C). Meanwhile, from the viewpoint of stable film quality of a thin film, the lower limits of the molecular weights thereof are respectively the same as that of the compound represented by Formula (D).

Specific examples of a compound L represented by Formula (L), a compound M represented by Formula (M), a compound N represented by Formula (N), a compound P represented by Formula (P), and a compound Q represented by Formula (Q) are respectively described in order.

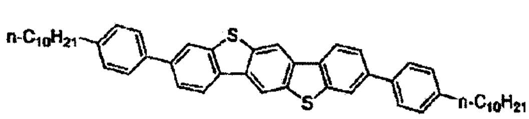

Compound L1

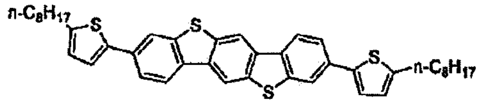

Compound L2

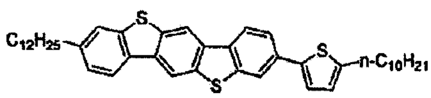

Compound L3

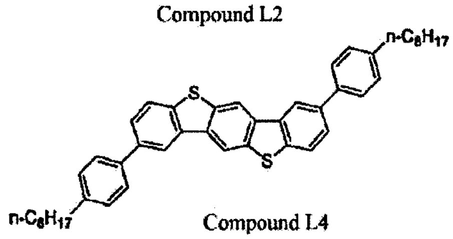

Compound L4

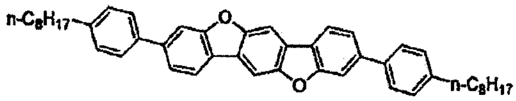

Compound L5

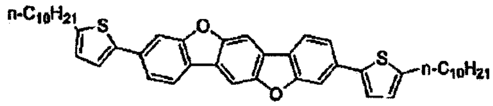

Compound L6

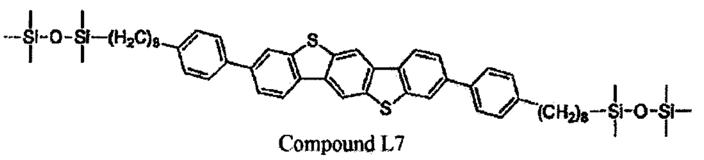

Compound L7

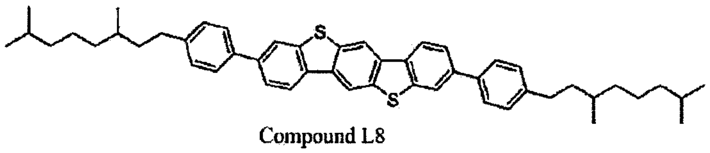

Compound L8

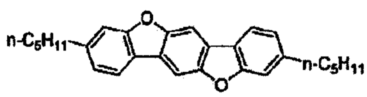

Compound L9

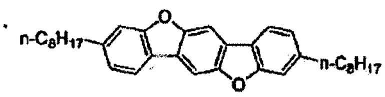

Compound L10

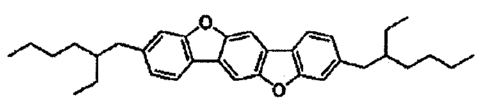

Compound L11

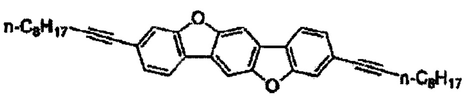

Compound L12

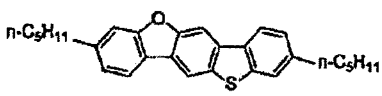

Compound L13

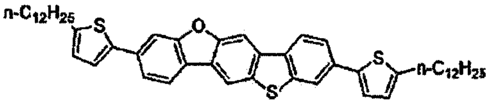

Compound L14

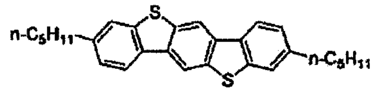

Compound L15

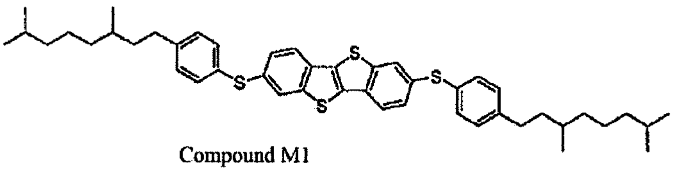

Compound M1

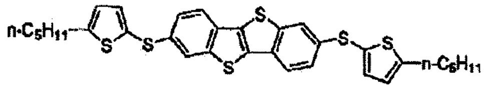

Compound M2

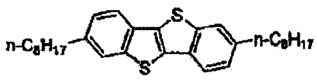

Compound M3
(C8BTBT)

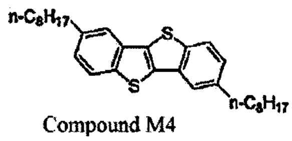

Compound M4

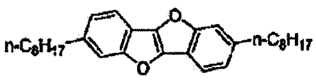

Compound M5

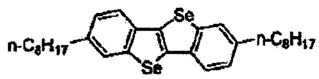

Compound M6

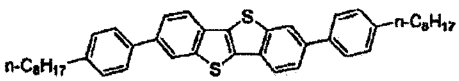

Compound M7

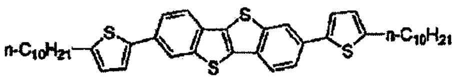

Compound M8

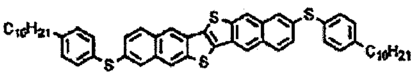

Compound N1

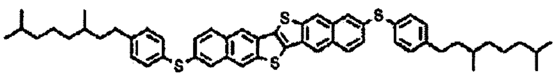

Compound N2

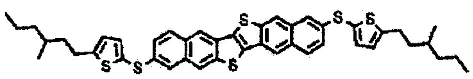

Compound N3

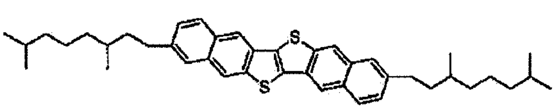

Compound N4

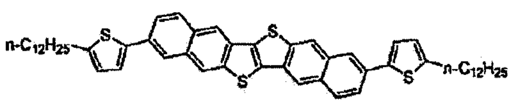

Compound N5

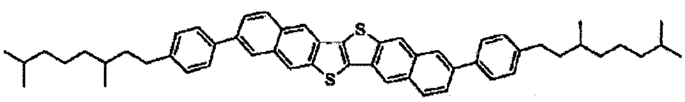

Compound N6

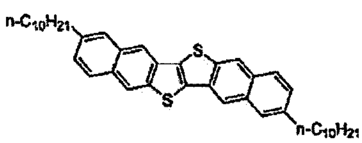

Compound N7

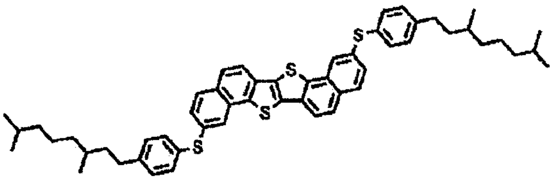

Compound P1

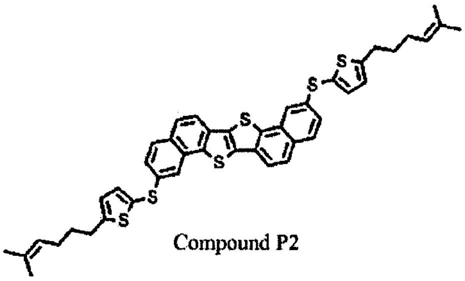

Compound P2

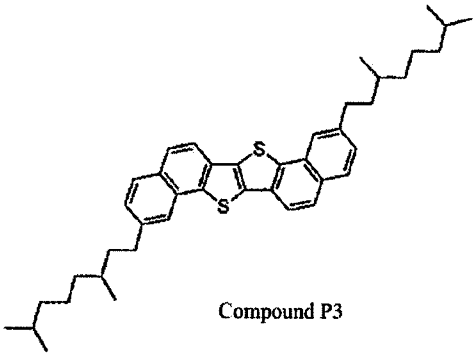

Compound P3

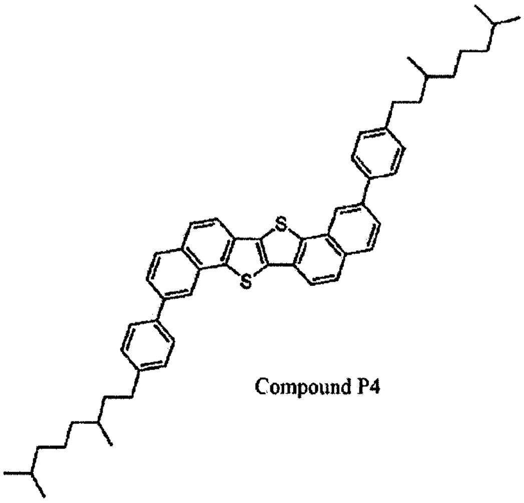

Compound P4

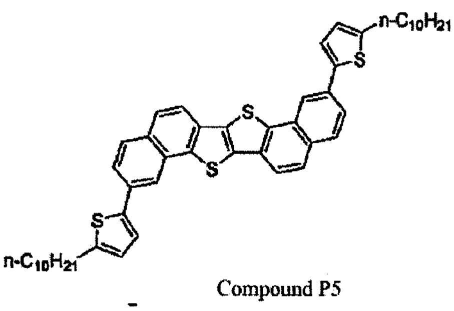

Compound P5

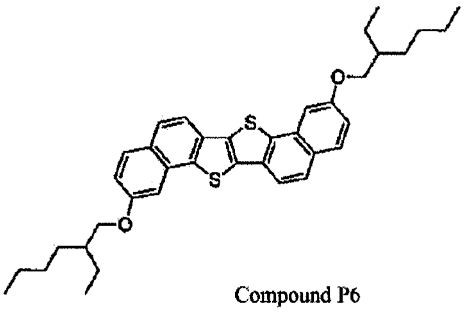

Compound P6

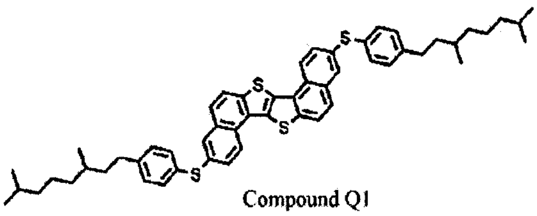

Compound Q1

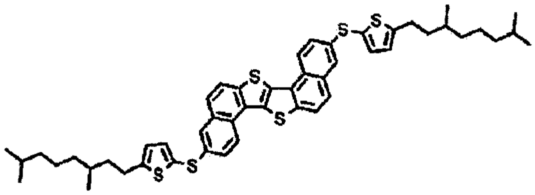

Compound Q2

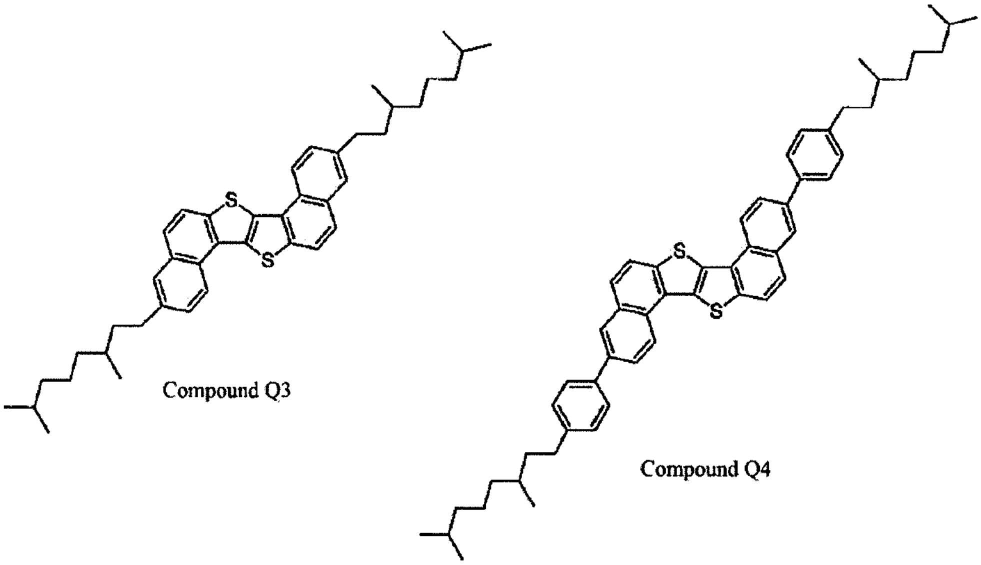

Compound Q3

Compound Q4

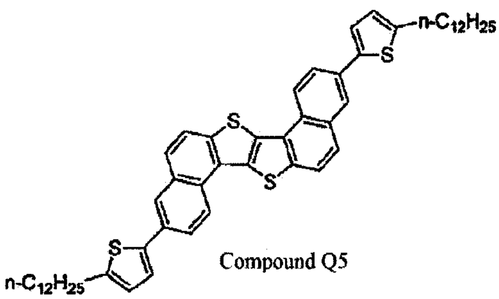

Compound Q5

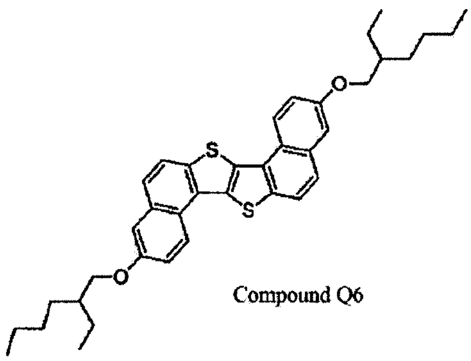

Compound Q6

From the viewpoint of improving the solubility in a solvent, it is preferable that the upper limits of the molecular weights of the compounds L, M, N, P, and Q are respectively the same as that of the compound C represented by Formula (C). Meanwhile, from the viewpoint of stable film quality of a thin film, the lower limits of the molecular weights thereof are respectively the same as that of the compound represented by Formula (D).

Specific examples of a compound R represented by Formula (R), a compound S represented by Formula (S), and a compound T represented by Formula (T) are respectively described in order.

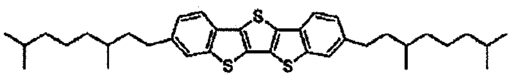

Compound R1

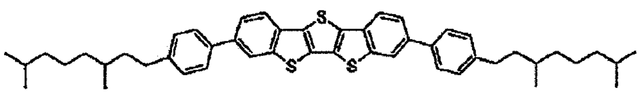

Compound R2

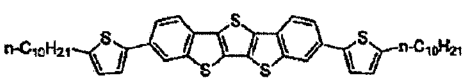

Compound R3

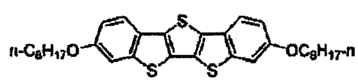

Compound R4

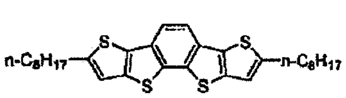

Compound S1

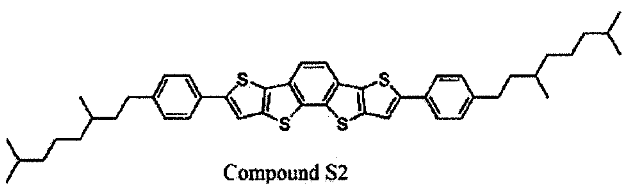

Compound S2

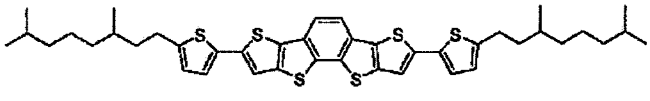

Compound S3

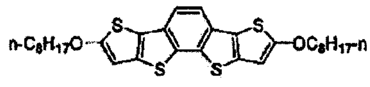

Compound S4

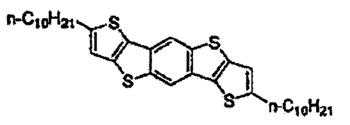

Compound T1

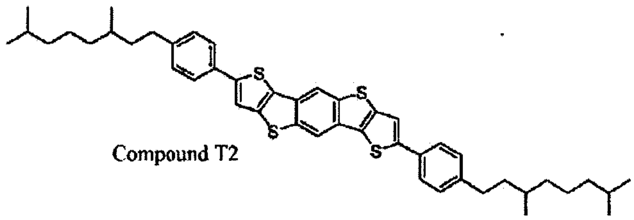

Compound T2

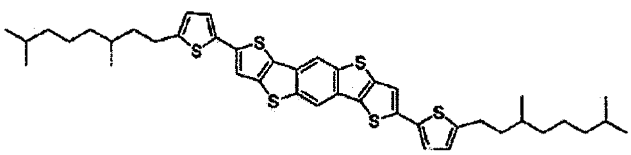

Compound T3

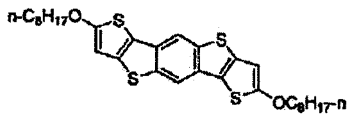

Compound T4

From the viewpoint of improving the solubility in a solvent, it is preferable that the upper limits of the molecular weights of the compounds R, S, and T are respectively the same as that of the compound C represented by Formula (C). Meanwhile, from the viewpoint of stable film quality of a thin film, the lower limits of the molecular weights thereof are respectively the same as that of the compound represented by Formula (D).

Examples of an organic polymer and a derivative thereof include polypyrrole and a derivative thereof, polydiketopyrrole and a derivative thereof, polythiophene and a derivative thereof, isothianaphthene such as polyisothianaphthene, thienylene vinylene such as polythienylene vinylene, poly(p-phenylenevinylene) such as poly(p-phenylenevinylene), polyaniline and a derivative thereof, polymers such as polyacetylene, polydiacetylene, polyazulene, polypyrene, polycarbazole, polyselenophene, polyfuran, poly(p-phenylene), polyindole, polypyridazine, polytellurophene, polynaphthalene, polyvinylcarbazole, polyphenylene sulfide, and polyvinylene sulfide, and a polymer of a condensed polycyclic aromatic compound.

The polythiophene and a derivative thereof are not particularly limited, and examples thereof include poly-3-hexylthiophene (P3HT) in which a hexyl group is introduced into polythiophene, polyethylene dioxythiophene, and poly(3,4-ethylenedioxythiophene)/polystyrenesulfonic acid (PEDOT/PSS).

Further, oligomers (such as oligothiophene) having repeating units which are the same as those of these polymers may also be exemplified.

Moreover, examples of the organic polymer include polymer compounds in which compounds represented by the following Formulae (C) to (T) have a repeating structure.

Examples of such polymers compound include $\pi$-conjugate polymers in which the compounds represented by Formulae (C) to (T) have a repeating structure through at least one or more arylene groups and heteroarylene groups (such as thiophene or bithiophene) and pendant type polymers in which the compounds represented by Formulae (C) to (T) are bonded to the polymer main chains through the side chains. Preferred examples of the polymer main chain include polyacrylate, polyvinyl, and polysiloxane and preferred examples of the side chain include an alkylene group and a polyethylene oxide group. In a case of the pendant type polymer, the polymer main chain may be formed by at least one of the substituent $R^C$, ..., or the substituent $R^T$ having a group derived from a polymerizable group to be polymerized.

The weight average molecular weight of these organic polymers is preferably 30000 or greater, more preferably 50000 or greater, and still more preferably 100000 or greater. When the weight average molecular weight is the above-described lower limit or greater, intermolecular interaction can be increased so that high mobility is obtained.

[Source electrode and drain electrode]

In the OTFT of the present invention, a source electrode is an electrode into which a current from the outside flows through wiring. Further, a drain electrode is an electrode that sends the current to the outside through the wiring and is typically provided in contact with the above-described semiconductor layer.

As materials of the source electrode and the drain electrode, conductive materials used for organic thin-film transistors of the related art can be used, and examples thereof include the conductive materials described in the section of the gate electrode above.

The source electrode and the drain electrode can be respectively formed according to the same method as the method of forming the above-described gate electrode.

The above-described photolithography method, a lift-off method or an etching method can be employed.

Particularly, since the gate insulating layer has excellent resistance to an etching solution or a stripping solution, the source electrode and the drain electrode can be suitably formed even when an etching method is employed. The etching method is a method of removing unnecessary portions by etching after a film is formed using a conductive material. When patterning is performed according to the etching method, it is possible to prevent peeling of a conductive material remaining on a base at the time of removing a resist and to prevent re-attachment of resist residues or the removed conductive material to the base. Accordingly, the shape of an electrode edge portion is excellent. From this viewpoint, the etching method is preferred than the lift-off method.

The lift-off method is a method of coating a portion of a base with a resist, forming a film thereon with a conductive material, and eluting or peeling the resist and the like using a solvent so that the conductive material on the resist is entirely removed, and then forming a film of the conductive material only on the portion which is not coated with the resist.

The thicknesses of the source material and the drain material are optional, but are respectively preferably 1 nm or greater and particularly preferably 10 nm or greater. Further, the thickness thereof is preferably 500 nm or less and particularly preferably 300 nm or less.

The space (channel length) between the source electrode and the drain electrode is optional, but is preferably 100 μm or less and particularly preferably 50 μm or less. Further, the channel width thereof is preferably 5000 μm or less and particularly preferably 1000 μm or less.

[Overcoat layer]

The OTFT of the present invention may have an overcoat layer. The overcoat layer is typically a layer formed on the surface of an OTFT as a protective layer. The overcoat layer may have a single-layer structure or a multi-layer structure.

The overcoat layer may be organic or inorganic.

The material forming an organic overcoat layer is not particularly limited, and examples thereof include organic polymers such as polystyrene, an acrylic resin, polyvinyl alcohol, polyolefin, polyimide, polyurethane, polyacetylene, and an epoxy resin, and derivatives obtained by introducing a crosslinkable group or a water-repellent group into these organic polymers. These organic polymers or derivatives thereof can be also used in combination with a crosslinking component, a fluorine compound, or a silicon compound.

The material forming an inorganic overcoat layer is not particularly limited, and examples thereof include metal oxides such as silicon oxide and aluminum oxide, and metal nitrides such as silicon nitride.

These materials may be used alone or in combination of optional two or more kinds thereof at an optional ratio.

A method of forming an overcoat layer is not limited and an overcoat layer can be formed according to known various methods.

For example, an organic overcoat layer can be formed using a method of coating an underlayer with a solution containing a material which becomes the overcoat layer, drying the layer, exposing the layer to light, and developing the layer to be patterned. Moreover, the patterning of the overcoat layer can be directly formed using a printing method or an ink-jet method. In addition, after the overcoat layer is patterned, the overcoat layer may be cross-linked by being exposed to light or heated.

Meanwhile, an inorganic overcoat layer can be formed using a dry method such as a sputtering method or a vapor deposition method or a wet method such as a sol-gel method.

[Other layers]

The OTFT of the present invention may be provided with other layers or members.

As other layers or members, a bank may be exemplified. A bank is used for the purpose of holding a discharge liquid in a predetermined position when a semiconductor layer or an overcoat layer is formed using an ink-jet method. For this reason, a bank typically has liquid repellency. Examples of forming a bank include a method of performing a liquid repellent treatment such as a fluorine plasma method after patterning is performed according to a photolithography method or the like and a method of curing a photosensitive composition or the like containing liquid repellent components such as a fluorine compound.

In a case of the organic thin-film transistor of the present invention, since a gate insulating layer is an organic layer, the latter method of curing a photosensitive composition containing liquid repellent components is preferable from

the viewpoint that the gate insulating layer is not affected by the liquid repellent treatment. In addition, a technique of allowing a base to have a contrast of liquid repellency without using a bank so that the base plays the same role as that of a bank may be used.

[Use of OTFT]

It is preferable that the OTFT of the present invention is mounted on a display panel for use. Examples of the display panel include a liquid crystal panel, an organic EL panel, and an electron paper panel.

Examples

Hereinafter, the present invention will be described in detail based on examples, but the present invention is not limited to those examples.

[Synthesis Example]

The following P-1 to P-8 were prepared as block copolymers used to form microphase separation layers.

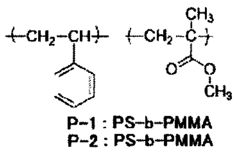

P-1 : PS-b-PMMA
P-2 : PS-b-PMMA

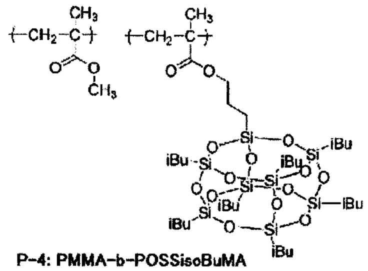

P-4: PMMA-b-POSSisoBuMA

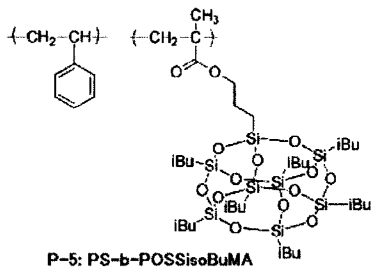

P-5: PS-b-POSSisoBuMA

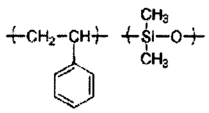

P-3: PS-b-PDMS

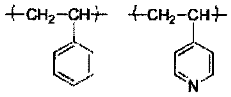

P-6: PS-b-P4VP

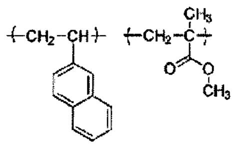

P-7: PVNp-b-PMMA

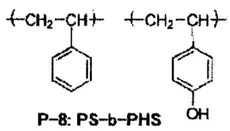

P-8: PS-b-PHS

P-1: PS-b-PMMA, manufactured by Polymer Source Inc. (catalog No. P4961)
Mn of polystyrene (PS): 25000
Mn of polymethylmethacrylate (PMMA): 26000
Dispersity: 1.06
P-2: PS-b-PMMA, manufactured by Polymer Source Inc. (catalog No. P4418)
Mn of polystyrene (PS): 18500
Mn of polymethylmethacrylate (PMMA): 18000
Dispersity: 1.06
P-3: PS-b-PDMS, manufactured by Polymer Source Inc. (catalog No. P8709)
Mn of PS: 22000
Mn of polydimethylsiloxane (PDMS): 21000
Dispersity: 1.08
P-4: PS-b-POSSisoBuMA, manufactured by Polymer Source Inc. (catalog No. P9793)
Mn of PMMA: 22000
Mn of POSSisoBuMA: 22500
Dispersity: 1.10
P-5: PS-b-POSSisoBuMA, manufactured by Polymer Source Inc. (catalog No. P14022)
Mn of PS: 6000
Mn of POSSisoBuMA: 23000
Dispersity: 1.6
P-6: PS-b-P4VP, manufactured by Polymer Source Inc. (catalog No. P9892)

Mn of PS: 195000
Mn of poly(4-vinylpyridine) (P4VP): 204000
Dispersity: 1.09
P-7: PVNp-b-PMMA, manufactured by Polymer Source Inc. (catalog No. P3400) Mn of polyvinyl naphthalene (PVNp): 61000
Mn of PMMA: 68000
Dispersity: 1.15
P-8: PS-b-PHS, manufactured by Polymer Source Inc. (catalog No. P8616)
Mn of PS: 9000
Mn of polyhydroxystyrene (PHS): 6000
Dispersity: 1.12

Further, the following BP-1, BP-4, BP-5, BP-6, and BP-2 were synthesized as block polymers used to form microphase separation layers according to a conventional method.

BP-1

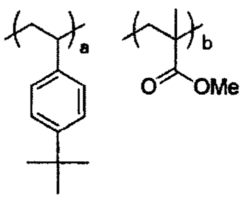

(BP-1A): a=47wt%, b=53wt%, Mn=19700, Mw/Mn=1.05

BP-4

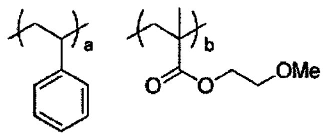

(BP-4A): a=45wt%, b=55wt%, Mn=18000 Mw/Mn=1.07

BP-5

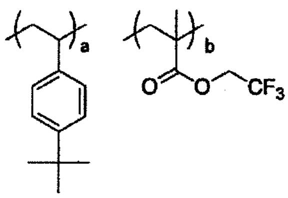

(BP-5A): a=51wt%, b=49wt%, Mn=17600, Mw/Mn=1.11

BP-6

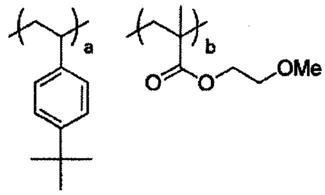

(BP-6A): a=48wt%, b=52wt%, Mn=18000, Mw/Mn=1.08

CBP-2

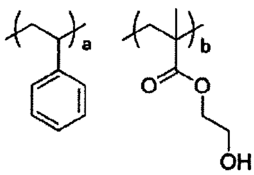

(CBP-2A): a=47wt%, b=53wt%, Mn=18200, Mw/Mn=1.11

Moreover, block polymers BBP-1 and BBP-2 including a repeating unit that contained a crosslinkable group were synthesized as block polymers used to form microphase separation layers according to a conventional method. Further, in BBP-1, a constituent component in which the content thereof in a copolymer is represented by b1 and a constituent component in which the content thereof in a copolymer is represented by b2 are randomly linked to each other at a molar ratio of 10:1 to form a random polymer, and this random polymer forms one block. The same applies to BBP-2.

BBP−1

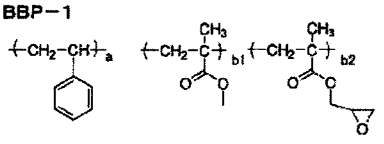

(BBP-1): a=49wt%, b1+b2=51wt%, b1:b2=10:1, Mn=40000, Mw/Mn=1.09

BBP−2

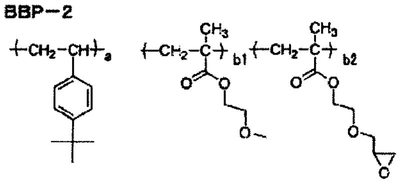

(BBP-1): a=49wt%, b1+b2=51wt%, b1:b2=10:1, Mn=17200, Mw/Mn=1.10

Compounds serving as organic semiconductors used in respective examples are shown below.

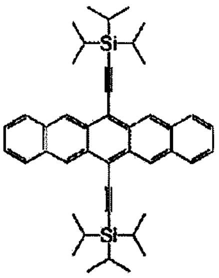

A6 (TIPS-pentacene)

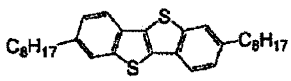

M3 (C8-BTBT)

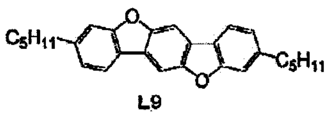

L9

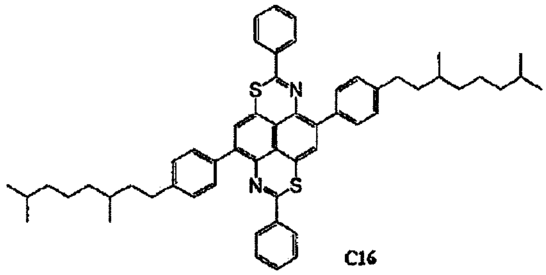

C16

The above-described compound L9 is a compound represented by Formula (L) and was synthesized according to a method described in Japan Society of Applied Physics Molecular Electronics an Bioelectronics Journal, 2011, 22, 9-12., and WO2009/148016A.

The above-described compound C16 is a compound represented by Formula (C) and was synthesized according to the following method of synthesizing the following compound C1.

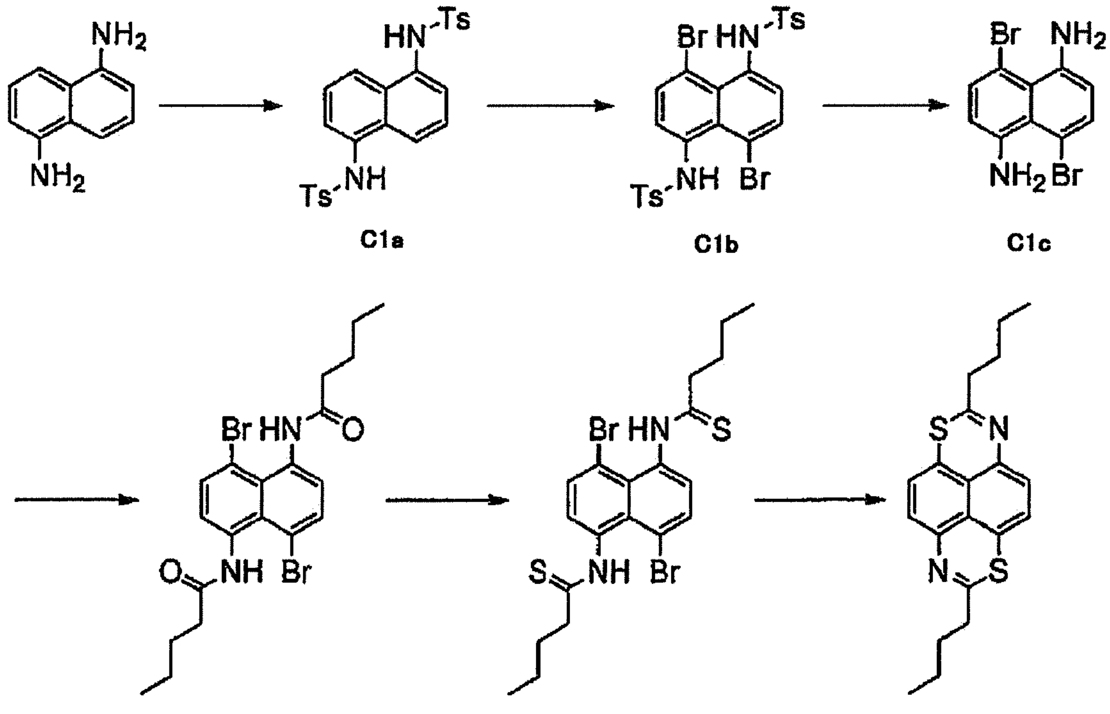

C1a C1b C1c

C1d C1e Compound C1

(Synthesis of compound C1a)

p-toluenesulfonyl chloride (34 g) was slowly added to a pyridine solution (125 mL) of 1,5-diaminonaphthalene (10 g), and the solution was stirred at room temperature for 2 hours. The reaction solution was poured into ice water,

and the precipitate was filtered under reduced pressure. The obtained crude crystals were washed with methanol, thereby obtaining a compound C1a (29 g).

(Synthesis of compound C1b)

A glacial acetic acid solution of the compound C1a (10 g) was heated and stirred at 95°C, and bromine (2 mL) diluted with 10 mL of glacial acetic acid was slowly added dropwise to the solution. The solution was reacted for 10 minutes and filtered after the solution was left to be cooled, thereby obtaining crude crystals in the form of a gray solid. The crude crystals were re-crystallized in nitrobenzene, thereby obtaining a compound C1b (6.8 g).

(Synthesis of compound C1c)

A concentrated sulfuric acid solution of the compound C1b (5 g) was stirred at room temperature for 24 hours. The reaction solution was poured into ice water, and the precipitated solid was filtered and collected. The solid was dispersed in ice water again, and neutralized in ammonia water, thereby obtaining a compound C1c (0.5 g).

(Synthesis of compound C1d)

Pentanoyl chloride (valeric acid chloride) (2.6 mL) was added dropwise to a pyridine solution of the compound C1c (2 g) at room temperature, and the solution was stirred for 2 hours. The reaction solution was poured into ice water, and a solid was filtered under reduced pressure. The solid was dispersed in methanol and the solution was stirred for 1 hour, and the solid was filtered, thereby obtaining a compound C1d (1.39 g).

(Synthesis of compound C1e)

The compound C1d (1.2 g) and a Lawesson's reagent (1.48 g) were added to a mixed solution of THF (360 mL) and toluene (72 mL), and then the solution was stirred for 3 hours while being heated and refluxed. Only THF was removed through evaporation to obtain a toluene solution, and then the solution was stirred at 60°C for 1 hour. Thereafter, insoluble matters were filtered, thereby obtaining a compound C1e (0.5 g).

(Synthesis of compound C1)

The compound C1e (0.4 g) and cesium carbonate (1.33 g) were allowed to react with each other in dimethylacetamide at 120°C for 2 hours. The reaction solution was poured into water, and the precipitate was filtered. The filtered solid was repeatedly re-crystallized in THF, and a target compound C1 (0.12 g) was synthesized. The obtained compound C1 was identified by 1H-NMR and a mass spectrum.

Further, a compound A6 (TIPS-pentacene) and a compound M3 (C8-BTBT) were synthesized according to a known method.

[Production Example 1] (1) Preparation of bottom-gate type OTFT

A bottom-gate bottom-contact type OTFT illustrated in Fig. 1A was prepared. A doped silicon substrate (also serving as a gate electrode 5) having a thickness of 1 mm was used as a substrate 6, and a gate insulating layer 2 was formed thereon.

The gate insulating layer 2 was formed in the following manner.

6.3 g of poly(4-vinylphenyl) (trade name: VP-8000, manufactured by Nippon Soda Co., Ltd., Mn: 11000, dispersity: 1.1) and 2.7 g of 2,2-bis(3,5-dihydroxymethyl-4-hydroxy)propane serving as a crosslinking agent were completely dissolved in 91 g of a solvent in which 1-butanol and ethanol were mixed at a mixed ratio of 1:1 at room temperature. The solution was filtered through a PTFE membrane filter having a diameter ($\phi$) of 0.2 $\mu$m. 0.18 g of diphenyliodonium hexafluorophosphate salt serving as an acid catalyst was added to the obtained filtrate, and the substrate 6 was coated with the solution and dried so that a film was formed thereon. Next, the film was heated at 100°C to form a cross-linked structure, and then the gate insulating layer 2 having a thickness of 0.7 $\mu$m was formed.

Subsequently, as a source electrode 3 and a drain electrode 4 illustrated in Fig. 1A, electrodes (gate width W = 100 mm, gate length L = 100 $\mu$m) formed of chromium and gold arranged in a comb shape were formed through vacuum vapor deposition using a mask.

In order to form a microphase separation layer on the gate insulating layer 2, a solution (coating solution) in which 10 mg of a block copolymer listed in Table 1 was dissolved in 1 g of PGMEA was prepared. The gate insulating layer 2 was spin-coated with the coating solution and dried so that a film was formed. This block copolymer layer was

heated at 180°C in a nitrogen stream until a microphase separation structure (lamellar phase separation structure) was formed. The thicknesses of all the obtained microphase separation layers (block copolymer layers) were in a range of 20 nm to 50 nm. In addition, when BBP-1 and BBP-2 were formed, diphenyliodonium hexafluorophosphate salt was added to the coating solution as an acid catalyst at a concentration of 1% by weight based on the solid content, and a crosslinking reaction was performed at the same time with heating for forming the above-described microphase separation layer. Moreover, the microphase separation layer is not illustrated in Fig. 1A.

Next, the microphase separation layer, the source electrode, and the drain electrode were spin-coated with a solution in which 5 mg of an organic semiconductor listed in the following Table 1 was dissolved in 1 mL of toluene such that the microphase separation layer, the source electrode, and the drain electrode were covered, and then an OTFT illustrated in Fig. 1A was prepared. The thickness of the organic semiconductor was 150 nm.

[Test Example 1] Evaluation of microphase separation layer

In the production of the OTFT in Production Example 1 described above, after the microphase separation layer was formed, the microphase separation layer was observed using SU8000 (manufactured by Hitachi-Technologies Corporation) and the pitch of the lamellar phase separation was evaluated based on the following evaluation criteria.

(Evaluation criteria of lamellar phase separation layer)

A: The pitch of the lamellar phase separation is 10 nm or greater and less than 20 nm.
B: The pitch of the lamellar phase separation is 20 nm or greater and less than 40 nm.
C: The pitch of the lamellar phase separation is 40 nm or greater.
D: The lamellar phase separation is not observed.

[Test Example 2] Evaluation of crystal grain size and crystal orientation of organic semiconductor layer

The organic semiconductor layer of the OTFT obtained in Production Example 1 was observed using an AFM and the crystal grain size of the organic semiconductor was evaluated based on the following evaluation criteria. The evaluation was also performed supplementarily using a polarized microscope (crossed-Nicol condition).

(Evaluation criteria of crystal grain size of organic semiconductor layer)

A: The crystal grain size is grown to 100 nm or greater.
B: The observed crystal grain size is 10 nm or greater and less than 100 nm in both cases.
C: The observed crystal grain size is less than 10 nm in both cases.
D: Crystals are not observed.

Further, the organic semiconductor layer of the OTFT obtained in Production Example 1 was observed using a polarized microscope, and the crystal orientation of the organic semiconductor was evaluated based on the following evaluation criteria.

(Evaluation criteria of crystal orientation of organic semiconductor layer)

A: The crystals are oriented in one direction.
B: Some crystals are oriented in one direction.
C: The crystals are not oriented.

[Test Example 3] Evaluation of performance of OTFT

The performance of the OTFT obtained in Production Example 1 was examined by evaluating the carrier mobility and the on/off ratio of the OTFT according to the following method.

(Evaluation of carrier mobility)

A voltage of -40 V was applied to a space between the source electrode and the drain electrode so that the gate voltage was changed to be in a range of 40 V to -40 V, and a carrier mobility μ was calculated using the following equation representing a drain current Id.

$$Id = (w/2L)\mu Ci(Vg - Vth)^2$$

(In the equation, L represents the gate length, w represents the gate width, Ci represents the capacity per unit area of the insulating layer, Vg represents the gate voltage, and Vth represents the threshold voltage)

(Evaluation criteria of on/off ratio)

The expression (maximum value of |Id|)/(minimum value of |Id|) was set as the On/Off ratio when the voltage applied to the space between the source electrode and the drain electrode was fixed to -40 V and the Vg was swept from 40 V to -40 V.

The results are listed in the following Table 1.

[Table 1-1]

Table 1 (No. 1)

| | Organic semiconductor | Block copolymer | | Evaluation results | | | | |
|---|---|---|---|---|---|---|---|---|
| | | Type | ΔSP | Lamellar phase separation | Crystal grain size | Crystal orientation | Mobility μ | on/off ratio |
| Example 1 | TIPS-pentacene | P-1 | 0.3 | C | B | B | 0.4 | $2 \times 10^6$ |
| Example 2 | TIPS-pentacene | P-2 | 0.3 | B | A | B | 0.5 | $4 \times 10^6$ |
| Example 3 | TIPS-pentacene | P-3 | | B | A | B | 0.6 | $5 \times 10^6$ |
| Example 4 | TIPS-pentacene | P-4 | | B | B | B | 0.4 | $3 \times 10^6$ |
| Example 5 | TIPS-pentacene | P-5 | | B | A | B | 0.5 | $4 \times 10^6$ |
| Example 6 | TIPS-pentacene | P-6 | | C | B | B | 0.3 | $2 \times 10^6$ |
| Example 7 | TIPS-pentacene | P-7 | 1.5 | C | A | B | 0.3 | $2 \times 10^6$ |
| Example 8 | TIPS-pentacene | I P-8 | 2.8 | B | B | B | 0.4 | $3 \times 10^6$ |
| Example 9 | TIPS-pentacene | BP-1A | 1.3 | A | A | A | 0.8 | $7 \times 10^6$ |
| Example 10 | TIPS-pentacene | BP-4A | 0.6 | A | A | A | 1.0 | $1 \times 10^7$ |
| Example 11 | TIPS-pentacene | BP-5A | 1.3 | A | A | A | 0.9 | $9 \times 10^6$ |

(continued)

| | Organic semiconductor | Block copolymer | | Evaluation results | | | | |
|---|---|---|---|---|---|---|---|---|
| | | Type | ΔSP | Lamellar phase separation | Crystal grain size | Crystal orientation | Mobility μ | on/off ratio |
| Example 12 | TIPS-pentacene | BP-6A | 2.2 | A | A | A | 1.2 | $1 \times 10^7$ |
| Example 13 | TIPS-pentacene | CBP-2A | 4.8 | A | A | A | 0.7 | $6 \times 10^6$ |
| Example 14 | TIPS-pentacene | BBP-1 | 0.3 | B | A | B | 0.6 | $5 \times 10^6$ |
| Example 15 | TIPS-pentacene | BBP-2 | 2.2 | A | A | A | 1.2 | $2 \times 10^7$ |
| Comparative Example 1 | TIPS-pentacene | None | | None | C | C | 0.1 | $6 \times 10^5$ |
| Example 16 | C8-BTBT | P-1 | 0.3 | C | B | B | 0.6 | $3 \times 10^6$ |
| Example 17 | C8-BTBT | P-2 | 0.3 | B | A | B | 0.8 | $5 \times 10^6$ |
| Example 18 | C8-BTBT | P-3 | | B | A | B | 0.9 | $6 \times 10^6$ |
| Example 19 | C8-BTBT | P-4 | | B | B | B | 0.7 | $5 \times 10^6$ |
| Example 20 | C8-BTBT | P-5 | | B | A | B | 0.5 | $5 \times 10^6$ |
| Example 21 | C8-BTBT | P-6 | | C | B | B | 0.3 | $2 \times 10^6$ |
| Example 22 | C8-BTBT | P-7 | | C | A | B | 0.3 | $3 \times 10^6$ |
| Example 23 | C8-BTBT | P-8 | | B | B | B | 0.4 | $4 \times 10^6$ |
| Example 24 | C8-BTBT | BP-1A | 1.3 | A | A | A | 1.3 | $2 \times 10^7$ |
| Example 25 | C8-BTBT | BP-4A | 0.6 | A | A | A | 1.4 | $2 \times 10^7$ |
| Example 26 | C8-BTBT | BP-5A | 1.3 | A | A | A | 1.2 | $1 \times 10^7$ |
| Example 27 | C8-BTBT | BP-6A | 2.2 | A | A | A | 1.5 | $2 \times 10^7$ |
| Example 28 | C8-BTBT | CBP-2A | 4.8 | A | A | A | 1.0 | $9 \times 10^6$ |
| Example 29 | C8-BTBT | BBP-1 | 0.3 | B | A | B | 0.9 | $8 \times 10^6$ |
| Example 30 | C8-BTBT | BBP-2 | 2.2 | A | A | A | 1.3 | $2 \times 10^7$ |
| Comparative Example 2 | C8-BTBT | None | | None | C | C | 0.1 | $3 \times 10^5$ |

[Table 1-2]

Table 1 (No. 2)

| | Organic semiconductor | Block copolymer | | Evaluation results | | | | |
|---|---|---|---|---|---|---|---|---|
| | | Type | ΔSP | Lamellar phase separation | Crystal grain size | Crystal orientation | Mobility μ | on/off ratio |
| Example 31 | L9 | P-1 | 0.3 | C | B | B | 0.7 | $4 \times 10^6$ |
| Example 32 | L9 | P-2 | 0.3 | B | A | B | 0.9 | $6 \times 10^6$ |
| Example 33 | L9 | P-3 | | B | A | B | 0.8 | $7 \times 10^6$ |
| Example 34 | L9 | P-4 | | B | B | B | 0.8 | $5 \times 10^6$ |
| Example 35 | L9 | P-5 | | B | A | B | 0.9 | $5 \times 10^6$ |
| Example 36 | L9 | P-6 | | C | B | B | 0.7 | $3 \times 10^6$ |
| Example 37 | L9 | P-7 | | C | A | B | 0.8 | $4 \times 10^6$ |
| Example 38 | L9 | P-8 | | B | B | B | 0.7 | $4 \times 10^6$ |
| Example 39 | L9 | BP-1A | 1.3 | A | A | A | 1.4 | $2 \times 10^7$ |
| Example 40 | L9 | BP-4A | 0.6 | A | A | A | 1.5 | $3 \times 10^7$ |
| Example 41 | L9 | BP-5A | 1.3 | A | A | A | 1.4 | $2 \times 10^7$ |
| Example 42 | L9 | BP-6A | 2.2 | A | A | A | 1.6 | $3 \times 10^7$ |
| Example 43 | L9 | CBP-2A | 4.8 | A | A | A | 1.1 | $9 \times 10^6$ |
| Example 44 | L9 | BBP-1 | 0.3 | B | A | B | 1.0 | $8 \times 10^6$ |
| Example 45 | L9 | BBP-2 | 2.2 | A | A | A | 1.4 | $2 \times 10^7$ |
| Comparative Example 3 | L9 | None | | None | C | C | 0.3 | $1 \times 10^6$ |
| Example 46 | C16 | P-1 | 0.3 | C | B | B | 0.8 | $5 \times 10^6$ |
| Example 47 | C16 | P-2 | 0.3 | B | A | B | 1.0 | $6 \times 10^6$ |
| Example 48 | C16 | P-3 | | B | A | B | 0.9 | $7 \times 10^6$ |

(continued)

| | Organic semiconductor | Block copolymer | | Evaluation results | | | | |
|---|---|---|---|---|---|---|---|---|
| | | Type | ΔSP | Lamellar phase separation | Crystal grain size | Crystal orientation | Mobility μ | on/off ratio |
| Example 49 | C16 | P-4 | | B | B | B | 0.9 | $6 \times 10^6$ |
| Example 50 | C16 | P-5 | | B | A | B | 1.0 | $6 \times 10^6$ |
| Example 51 | C16 | P-6 | | C | B | B | 0.8 | $5 \times 10^6$ |
| Example 52 | C16 | P-7 | | C | A | B | 0.9 | $6 \times 10^6$ |
| Example 53 | C16 | P-8 | | B | B | B | 0.9 | $5 \times 10^6$ |
| Example 54 | C16 | BP-1A | 1.3 | A | A | A | 1.5 | $3 \times 10^7$ |
| Example 55 | C16 | BP-4A | 0.6 | A | A | A | 1.6 | $3 \times 10^7$ |
| Example 56 | C16 | BP-5A | 1.3 | A | A | A | 1.5 | $2 \times 10^7$ |
| Example 57 | C16 | BP-6A | 2.2 | A | A | A | 1.6 | $4 \times 10^7$ |
| Example 58 | C16 | CBP-2A | 4.8 | A | A | A | 1.1 | $9 \times 10^6$ |
| Example 59 | C16 | BBP-1 | 0.3 | B | A | B | 1.0 | $8 \times 10^6$ |
| Example 60 | C16 | BBP-2 | 2.2 | A | A | A | 1.4 | $3 \times 10^7$ |
| Comparative Example 4 | C16 | None | | None | C | C | 0.5 | $2 \times 10^6$ |

[Production Example 2] (2) Preparation of bottom-gate type OTFT

An OTFT in which an underlayer was formed, as an underlayer of a microphase separation layer, on a gate insulating layer was prepared. More specifically, in the OTFT using P-2 as a block copolymer in Production Example 1 described above, an OTFT on which a random polymer RP-1 layer having a monomer component, which was the same as P-2, as a constituent component was formed as the underlayer of the microphase separation layer was prepared. The RP-1 layer was formed by preparing a coating solution in which 10 mg of RP-1 was dissolved in 1 g of PGMEA and performing spin coating.

Similarly, in the OTFT using BBP-1 as a block copolymer in Production Example I described above, an OTFT on which a random polymer BRP-1 layer having a monomer component, which was the same as BBP-1, as a constituent component was formed as the underlayer of the microphase separation layer was prepared. The BRP-1 layer was formed by preparing a coating solution in which 10 mg of BRP-1 was dissolved in 1 g of PGMEA and performing spin coating.

Similarly, in the OTFT using BP-6A as a block copolymer in Production Example 1 described above, an OTFT on which a random polymer RP-2 layer having a monomer component, which was the same as BP-6A, as a constituent component was formed as the underlayer of the microphase separation layer was prepared. The RP-2 layer was formed by preparing a coating solution in which 10 mg of RP-2 was dissolved in 1 g of PGMEA and performing spin coating.

Similarly, in the OTFT using BBP-2 as a block copolymer in Production Example 1 described above, an OTFT

on which a random polymer BRP-2 layer having a monomer component, which was the same as BBP-2, as a constituent component was formed as the underlayer of the microphase separation layer was prepared. The BRP-2 layer was formed by preparing a coating solution in which 10 mg of BRP-2 was dissolved in 1 g of PGMEA and performing spin coating.

In addition, when the underlayers using BBP-1 and BBP-2 were formed, diphenyliodonium hexafluorophosphate salt was added to the coating solution as an acid catalyst at a concentration of 1% by weight based on the solid content, and the solution was applied for film formation, and then a cross-linked structure was formed by heating the formed film at 100°C.

The thicknesses of the underlayers were 20 nm in both cases.

RP-1

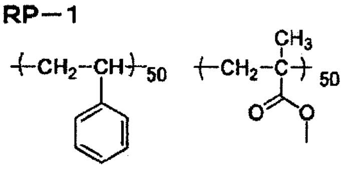

Random polymerization polymer, Mn=55000, Mw/Mn=1.85

BRP-1

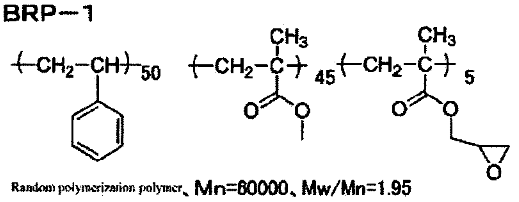

Random polymerization polymer, Mn=60000, Mw/Mn=1.95

RP-2

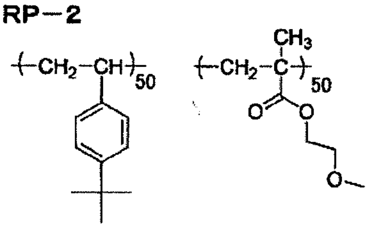

Random polymerization polymer, Mn=45000, Mw/Mn=1.87

BRP-2

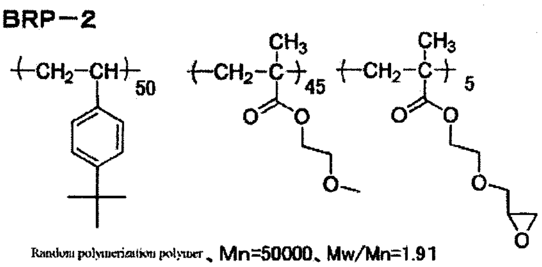

Random polymerization polymer, Mn=50000, Mw/Mn=1.91

The numerical values provided for repeating units of the above-described random polymers indicate the mass ratios of the repeating units.

In each of the obtained OTFTs, the state of the lamellar phase separation in the microphase separation layer, the crystal grain size and the crystal orientation of the organic semiconductor, and the mobility and the on/off ratio of each of the obtained OTFTs were evaluated in the same manner as those in Test Examples 1 to 3 described above. As a result, a difference in the crystal grain size and the crystal orientation of the organic semiconductor and a difference in the mobility and the on/off ratio of an OTFT between a case in which an underlayer was formed and a case in which an underlayer was not formed were not recognized.

When an OTFT was produced by replacing the organic semiconductor with A26, A27, C1, C4, C7, D1, E2, F2, F5, F10, G12, G14, H10, H11, J2, J3, K2, K3, L2, L5, L6, L8, L15, M8, N4, P3, Q3, R1, S1, and T1 exemplified in the above and the performance thereof was evaluated in the same manner as described above, the same effects as described above were obtained.

[Production Example 3] (3) Preparation of bottom-gate type OTFT

OTFTs were prepared by replacing the gate insulating layer in Production Example 1 with a layer formed of polyvinylphenol (VP-8000, manufactured by Nippon Soda Co., Ltd.), replacing the gate insulating layer in Production Example 1 with a layer formed of polysilsesquinoxane (OX-SQ, HDXOX-SQ, NDX, manufactured by Toagosei Company, Limited), replacing the gate insulating layer in Production Example 1 with a layer formed of CYTOP (CTL-809M, manufactured by Asahi Glass Co., Ltd.), and replacing the gate insulating layer in Production Example 1 with a layer formed of $SiO_2$ (used as the gate insulating layer 2 by changing the surface having a surface roughness of 0.3 μm of a Si substrate into $SiO_2$ through thermal oxidation in place of an organic polymer that forms the gate insulating layer 2).

In each of the obtained OTFTs, the state of the lamellar phase separation in the microphase separation layer, the crystal grain size and the crystal orientation of the organic semiconductor, and the mobility and the on/off ratio of each of the obtained OTFTs were evaluated in the same manner as those in Test Examples 1 to 3 described above. As a result, a change in the crystal grain size and the crystal orientation of the organic semiconductor and a change in the mobility and the on/off ratio of an OTFT caused by the difference of the gate insulating layer were not recognized.

[Production Example 4] (4) Preparation and evaluation of bottom-gate type OTFT

In the OTFT using P-2 as a block copolymer in Production Example 1, an OTFT obtained by replacing the gate insulating layer with the layer formed of RP-1 described above was prepared.
Similarly, in the OTFT using BBP-1 as a block copolymer in Production Example 1, an OTFT obtained by replacing the gate insulating layer with the BRP-1 layer described above was prepared.
Similarly, in the OTFT using BP-6A as a block copolymer in Production Example 1, an OTFT obtained by replacing the gate insulating layer with the RP-2 layer described above was prepared.
Similarly, in the OTFT using BBP-2 as a block copolymer in Production Example 1, an OTFT obtained by replacing the gate insulating layer with the BRP-2 layer described above was prepared.
In addition, when the gate insulating layers using BBP-1 and BBP-2 were formed, diphenyliodonium hexafluorophosphate salt was added to the coating solution as an acid catalyst at a concentration of 1% by weight based on the solid content, and the solution was applied for film formation, and then a cross-linked structure was formed by heating the formed film at 100°C.
In each of the obtained OTFTs, the state of the lamellar phase separation in the microphase separation layer, the crystal grain size and the crystal orientation of the organic semiconductor, and the mobility and the on/off ratio of each of OTFT were evaluated in the same manner as those in Test Examples 1 to 3 described above. As a result, the same results as those (results listed in Table 1) in Test Examples 1 to 3 were obtained.

[Production Example 5] (5) Preparation of bottom-gate type OTFT

In the OTFT using P-2 as a block copolymer in Production Example 1, an OTFT in which the gate insulating layer was formed using P-2 and the microphase separation layer formed of P-2 was not provided was prepared (that is, an OTFT in which the organic semiconductor layer was formed on the gate insulating layer formed of P-2).
Similarly, in the OTFT using BBP-1 as a block copolymer in Production Example 1, an OTFT in which the gate insulating layer was formed using BBP-1 and the microphase separation layer formed of BBP-1 was not provided was prepared (that is, an OTFT in which the organic semiconductor layer was formed on the gate insulating layer formed of BBP-1).
Similarly, in the OTFT using BP-6A as a block copolymer in Production Example 1, an OTFT in which the gate insulating layer was formed using BP-6A and the microphase separation layer formed of BP-6A was not provided was prepared (that is, an OTFT in which the organic semiconductor layer was formed on the gate insulating layer formed of BP-6A).
Similarly, in the OTFT using BBP-2 as a block copolymer in Production Example 1, an OTFT in which the gate insulating layer was formed using BBP-2 and the microphase separation layer formed of BBP-2 was not provided was prepared (that is, an OTFT in which the organic semiconductor layer was formed on the gate insulating layer formed of BBP-2).
In addition, when the gate insulating layers using BBP-1 and BBP-2 were formed, diphenyliodonium hexafluorophosphate salt was added to the coating solution as an acid catalyst at a concentration of 1% by weight based on the solid content, and the solution was applied for film formation, and then a cross-linked structure was formed by heating the formed film at 100°C.
In each of the obtained OTFTs, the state of the lamellar phase separation in the microphase separation layer, the crystal grain size and the crystal orientation of the organic semiconductor, and the mobility and the on/off ratio of each of OTFT were evaluated in the same manner as those in Test Examples 1 to 3 described above. As a result, the same results as those (results listed in Table 1) in Test Examples 1 to 3 were obtained.

[Production Example 6] Preparation of top-gate type OTFT

A top-gate bottom-contact type OTFT illustrated in Fig. 1C was prepared. A glass substrate (OA10, manufactured by NEC Corning) obtained by being washed with water and dried was used as a substrate 6. A resist layer was provided on the glass substrate and then a source electrode 3 and a drain electrode 4 respectively having a thickness of 100 nm were prepared through vapor deposition. The gate width W was set to 100 mm and the gate length L was set to 100 μm. In order to remove the resist layer and form a microphase separation layer, a solution in which 10 mg of a block copolymer listed in Table 2 was dissolved in 1 g of PGMEA was prepared. The substrate 6 was spin-coated with this solution so that a film was formed thereon. This block copolymer layer was heated at 180°C in a nitrogen stream until a microphase separation structure was formed. The thicknesses of all the obtained microphase separation layers (block copolymer layers) were in a range of 20 nm to 50 nm. In addition, when BBP-1 and BBP-2 were formed, diphenyliodonium hexafluorophosphate salt was added to the solution (coating solution) as an acid catalyst at a concentration of 1% by weight based on the solid content, and a crosslinking reaction was performed at the time of the above-described heating.

Moreover, the microphase separation layer is not illustrated in Fig. 1C.

The microphase separation layer, the source electrode, and the drain electrode were spin-coated with a solution in which 5 mg of the organic semiconductor listed in Table 2 was dissolved in 1 mL of toluene such that the microphase separation layer, the source electrode, and the drain electrode were covered, and a film was formed thereon. In this manner, the organic semiconductor having a thickness of 150 nm was formed.

Next, the gate insulating layer was formed such that the organic semiconductor layer was covered. More specifically, 6.3 g of poly(4-vinylphenyl) (trade name: VP-8000, manufactured by Nippon Soda Co., Ltd., Mn: 11000, dispersity: 1.1) and 2.7 g of 2,2-bis(3,5-dihydroxymethyl-4-hydroxy)propane serving as a crosslinking agent were completely dissolved in 91 g of a solvent in which 1-butanol and ethanol were mixed at a mixed ratio of 1:1 at room temperature. The solution was filtered through a PTFE membrane filter having a diameter ($\phi$) of 0.2 $\mu$m. 0.18 g of diphenyliodonium hexafluorophosphate salt serving as an acid catalyst was added to the obtained filtrate, and the organic semiconductor layer was coated with the solution and dried so that a film was formed thereon. Next, the film was heated at 100°C to form a cross-linked structure, and then the gate insulating layer 2 having a thickness of 0.7 $\mu$m was formed.

Next, the gate insulating layer was coated with a Ag fine particle water dispersion liquid according to an ink-jet method and then dried, thereby forming a gate electrode having a thickness of 200 nm.

In formation of the above-described top-gate bottom-contact type OTFT, after the microphase separation layer was formed, the pitch of the microphase separation layer was evaluated in the same manner as in Test example 1. Further, after the organic semiconductor layer was formed, the crystal grain size and the crystal orientation of the organic semiconductor layer were evaluated in the same manner as in Test Example 2. Moreover, in the obtained top-gate bottom-contact type OTFT, the state of the lamellar phase separation in the microphase separation layer, the crystal grain size and the crystal orientation of the organic semiconductor, and the mobility and the on/off ratio of each OTFT were evaluated in the same manner as those in Test Example 3 described above. The results are listed in the following Table 2.

[Table 2-1]

Table 2 (No. 1)

| | Organic semiconductor | Block copolymer | | Evaluation results | | | | |
|---|---|---|---|---|---|---|---|---|
| | | Type | ΔSP | Lamellar phase separation | Crystal grain size | Crystal orientation | Mobility $\mu$ | on/off ratio |
| Example 101 | TIPS-pentacene | P-1 | 0.3 | C | B | B | 0.2 | $1 \times 10^6$ |
| Example 102 | TIPS-pentacene | P-2 | 0.3 | B | A | B | 0.4 | $3 \times 10^6$ |
| Example 103 | TIPS-pentacene | P-3 | | B | A | B | 0.4 | $3 \times 10^6$ |
| Example 104 | TIPS-pentacene | P-4 | | B | B | B | 0.3 | $2 \times 10^6$ |
| Example 105 | TIPS-pentacene | P-5 | | B | A | B | 0.4 | $4 \times 10^6$ |
| Example 106 | TIPS-pentacene | P-6 | | C | B | B | 0.2 | $2 \times 10^6$ |
| Example 107 | TIPS-pentacene | P-7 | | C | A | B | 0.3 | $2 \times 10^6$ |
| Example 108 | TIPS-pentacene | P-8 | | B | B | B | 0.3 | $3 \times 10^6$ |
| Example 109 | TIPS-pentacene | BP-1A | I 1.3 | A | A | A | 0.7 | $9 \times 10^6$ |

(continued)

| | Organic semiconductor | Block copolymer | | Evaluation results | | | | |
|---|---|---|---|---|---|---|---|---|
| | | Type | ΔSP | Lamellar phase separation | Crystal grain size | Crystal orientation | Mobility μ | on/off ratio |
| Example 110 | TIPS-pentacene | BP-4A | 0.6 | A | A | A | 1.0 | $1 \times 10^7$ |
| Example 111 | TIPS-pentacene | BP-5A | 1.3 | A | A | A | 0.7 | $8 \times 10^6$ |
| Example 112 | TIPS-pentacene | BP-6A | 2.2 | A | A | A | 1.0 | $1 \times 10^7$ |
| Example 113 | TIPS-pentacene | CBP-2A | 4.8 | A | A | A | 0.6 | $6 \times 10^6$ |
| Example 114 | TIPS-pentacene | BBP-1 | 0.3 | B | A | B | 0.5 | $5 \times 10^6$ |
| Example 115 | TIPS-pentacene | BBP-2 | 2.2 | A | A | A | 1.1 | $1 \times 10^7$ |
| Comparative Example 101 | TIPS-pentacene | None | | None | C | C | 0.05 | $3 \times 10^5$ |
| Example 116 | C8-BTBT | P-1 | | C | B | B | 0.4 | $2 \times 10^6$ |
| Example 117 | C8-BTBT | P-2 | | B | A | B | 0.6 | $4 \times 10^6$ |
| Example 118 | C8-BTBT | P-3 | | B | A | B | 0.7 | $5 \times 10^6$ |
| Example 119 | C8-BTBT | P-4 | | B | B | B | 0.5 | $4 x 10^6$ |
| Example 120 | C8-BTBT | P-5 | | B | A | B | 0.5 | $3 \times 10^6$ |
| Example 121 | C8-BTBT | P-6 | | C | B | B | 0.3 | $2 \times 10^6$ |
| Example 122 | C8-BTBT | P-7 | | C | A | B | 0.4 | $2 \times 10^6$ |
| Example 123 | C8-BTBT | P-8 | | B | B | B | 0.4 | $4 \times 10^6$ |
| Example 124 | C8-BTBT | BP-1A | 1.3 | A | A | A | 1.1 | $1 \times 10^7$ |
| Example 125 | C8-BTBT | BP-4A | 0.6 | A | A | A | 1.2 | $1 \times 10^7$ |
| Example 126 | C8-BTBT | BP-5A | 1.3 | A | A | A | 1.0 | $1 \times 10^7$ |
| Example 127 | C8-BTBT | BP-6A | 2.2 | A | A | A | 1.3 | $2 \times 10^7$ |
| Example 128 | C8-BTBT | CBP-2A | 4.8 | A | A | A | 1.0 | $8 \times 10^6$ |
| Example 129 | C8-BTBT | BBP-1 | 0.3 | B | A | B | 0.8 | $7 \times 10^6$ |

(continued)

| | Organic semiconductor | Block copolymer | | Evaluation results | | | | |
|---|---|---|---|---|---|---|---|---|
| | | Type | ΔSP | Lamellar phase separation | Crystal grain size | Crystal orientation | Mobility μ | on/off ratio |
| Example 130 | C8-BTBT | BBP-2 | 2.2 | A | A | A | 1.2 | $2 \times 10^7$ |
| Comparative Example 102 | C8-BTBT | None | | None | C | C | 0.07 | $1 \times 10^5$ |

[Table 2-2]

Table 2 (No. 2)

| | Organic semiconductor | Block copolymer | | Evaluation results | | | | |
|---|---|---|---|---|---|---|---|---|
| | | Type | ΔSP | Lamellar phase separation | Crystal grain size | Crystal orientation | Mobility μ | on/off ratio |
| Example 131 | L9 | P-1 | 0.3 | C | B | B | 0.5 | $3 \times 10^6$ |
| Example 132 | L9 | P-2 | 0.3 | B | A | B | 0.7 | $6 \times 10^6$ |
| Example 133 | L9 | P-3 | | B | A | B | 0.7 | $7 \times 10^6$ |
| Example 134 | L9 | P-4 | | B | B | B | 0.6 | $5 \times 10^6$ |
| Example 135 | L9 | P-5 | | B | A | B | 0.7 | $5 \times 10^6$ |
| Example 136 | L9 | P-6 | | C | B | B | 0.5 | $3 \times 10^6$ |
| Example 137 | L9 | P-7 | | C | A | B | 0.6 | $4 \times 10^6$ |
| Example 138 | L9 | P-8 | | B | B | B | 0.6 | $4 \times 10^6$ |
| Example 139 | L9 | BP-1A | 1.3 | A | A | A | 1.2 | $2 \times 10^7$ |
| Example 140 | L9 | BP-4A | 0.6 | A | A | A | 1.3 | $2 \times 10^7$ |
| Example 141 | L9 | BP-5A | 1.3 | A | A | A | 1.2 | $2 \times 10^7$ |
| Example 142 | L9 | BP-6A | 2.2 | A | A | A | 1.4 | $3 \times 10^7$ |
| Example 143 | L9 | CBP-2A | 4.8 | A | A | A | 1.0 | $8 \times 10^6$ |
| Example 144 | L9 | BBP-1 | 0.3 | B | A | B | 0.8 | $8 \times 10^6$ |

(continued)

| | Organic semiconductor | Block copolymer | | Evaluation results | | | | |
|---|---|---|---|---|---|---|---|---|
| | | Type | ΔSP | Lamellar phase separation | Crystal grain size | Crystal orientation | Mobility μ | on/off ratio |
| Example 145 | L9 | BBP-2 | 2.2 | A | A | A | 1.3 | $2 \times 10^7$ |
| Comparative Example 103 | L9 | None | | None | C | C | 0.1 | $1 \times 10^6$ |
| Example 146 | C16 | P-1 | 0.3 | C | B | B | 0.6 | $4 \times 10^6$ |
| Example 147 | C16 | P-2 | 0.3 | B | A | B | 0.8 | $6 \times 10^6$ |
| Example 148 | C16 | P-3 | | B | A | B | 0.8 | $6 \times 10^6$ |
| Example 149 | C16 | P-4 | | B | B | B | 0.7 | $5 \times 10^6$ |
| Example 150 | C16 | P-5 | | B | A | B | 0.8 | $6 \times 10^6$ |
| Example 151 | C16 | P-6 | | C | B | B | 0.7 | $5 \times 10^6$ |
| Example 152 | C16 | P-7 | | C | A | B | 0.7 | $5 \times 10^6$ |
| Example 153 | C16 | P-8 | | B | B | B | 0.7 | $4 \times 10^6$ |
| Example 154 | C16 | BP-1A | 1.3 | A | A | A | 1.3 | $2 \times 10^7$ |
| Example 155 | C16 | BP-4A | 0.6 | A | A | A | 1.4 | $3 \times 10^7$ |
| Example 156 | C16 | BP-5A | 1.3 | A | A | A | 1.3 | $2 \times 10^7$ |
| Example 157 | C16 | BP-6A | 2.2 | A | A | A | 1.4 | $3 \times 10^7$ |
| Example 158 | C16 | CBP-2A | 4.8 | A | A | A | 1.0 | $8 \times 10^6$ |
| Example 159 | C16 | BBP-1 | 0.3 | B | A | B | 0.9 | $8 \times 10^6$ |
| Example 160 | C16 | BBP-2 | 2.2 | A | A | A | 1.3 | $3 \times 10^7$ |
| Comparative Example 104 | C16 | None | | None | C | C | 0.3 | $1 \times 10^6$ |

[Production Example 7] (2) Preparation of top-gate type OTFT

A top-gate type OTFT in which an underlayer was formed, as an underlayer of a microphase separation layer, on a substrate was prepared. More specifically, in the OTFT using P-2 as a block copolymer in Production Example 6 described above, an OTFT on which a random polymer RP-1 layer having a monomer component, which was the same as P-2, as a constituent component was formed as the underlayer of the microphase separation layer was prepared.

The RP-1 layer was formed by preparing a coating solution in which 10 mg of RP-1 was dissolved in 1 g of PGMEA and performing spin coating.

Similarly, in the OTFT using BBP-1 as a block copolymer in Production Example 6 described above, an OTFT on which a random polymer BRP-1 layer having a monomer component, which was the same as BBP-1, as a constituent component was formed as the underlayer of the microphase separation layer was prepared. The BRP-1 layer was formed by preparing a coating solution in which 10 mg of BRP-1 was dissolved in 1 g of PGMEA and performing spin coating.

Similarly, in the OTFT using BP-6A as a block copolymer in Production Example 6 described above, an OTFT on which a random polymer RP-2 layer having a monomer component, which was the same as BP-6A, as a constituent component was formed as the underlayer of the microphase separation layer was prepared. The RP-2 layer was formed by preparing a coating solution in which 10 mg of RP-2 was dissolved in 1 g of PGMEA and performing spin coating.

Similarly, in the OTFT using BBP-2 as a block copolymer in Production Example 1 described above, an OTFT on which a random polymer BRP-2 layer having a monomer component, which was the same as BBP-2, as a constituent component was formed as the underlayer of the microphase separation layer was prepared. The BRP-2 layer was formed by preparing a coating solution in which 10 mg of BRP-2 was dissolved in 1 g of PGMEA and performing spin coating.

In addition, when the underlayers using BBP-1 and BBP-2 were formed, diphenyliodonium hexafluorophosphate salt was added to the coating solution as an acid catalyst at a concentration of 1% by weight based on the solid content, and the solution was applied for film formation, and then a cross-linked structure was formed by heating the formed film at 100°C.

In each of the obtained OTFTs, the state of the lamellar phase separation in the microphase separation layer, the crystal grain size and the crystal orientation of the organic semiconductor, and the mobility and the on/off ratio of each OTFT were evaluated in the same manner as those in Test Examples 1 to 3 described above. As a result, a difference in the crystal grain size and the crystal orientation of the organic semiconductor and a difference in the mobility and the on/off ratio of an OTFT between a case in which an underlayer was formed and a case in which an underlayer was not formed were not recognized.

As described above, it was understood that a higher-performance organic thin-film transistor can be obtained by providing the organic semiconductor layer in contact with the microphase separation layer.

The present invention has been described with reference to the embodiments, but the detailed description of the invention is not limited unless otherwise noted and the present invention should be broadly interpreted without departing from the spirit and the scope described in the aspects of the invention.

The present application claims priority based on Japanese Patent Application No. 2014-40901 filed in Japan on March 3, 2014 and the contents of which are incorporated herein by reference.

Explanation of References

1: organic semiconductor layer
2: gate insulating layer
3: source electrode
4: drain electrode
5: gate electrode
6: substrate

**Claims**

**1.** An organic thin-film transistor comprising:

on a substrate,
a gate electrode;
an organic semiconductor layer;
a gate insulating layer provided between the gate electrode and the organic semiconductor layer; and
a source electrode and a drain electrode provided in contact with the organic semiconductor layer and connected to each other through the organic semiconductor layer,

wherein the organic semiconductor layer is provided in contact with a layer formed by microphase separation of a

block copolymer.

2. The organic thin-film transistor according to claim 1,

wherein the organic thin-film transistor has a bottom-gate form, and
the layer formed by microphase separation of the block copolymer is provided between the gate insulating layer and the organic semiconductor layer.

3. The organic thin-film transistor according to claim 1,

wherein the organic thin-film transistor has a bottom-gate form, and
the gate insulating layer is the layer formed by microphase separation of the block copolymer.

4. The organic thin-film transistor according to claim 2,

wherein the organic thin-film transistor has a bottom-gate form, and
the gate insulating layer includes a random polymer having a monomer component which is the same as a monomer component constituting the block copolymer, as a constituent component.

5. The organic thin-film transistor according to claim 4, wherein the random polymer in the gate insulating layer has a cross-linked structure.

6. The organic thin-film transistor according to claim 1,

wherein the organic thin-film transistor has a top-gate form, and
the layer formed by microphase separation of the block copolymer is provided on the substrate.

7. The organic thin-film transistor according to any one of claims 1, 2, and 6, wherein an underlayer is provided on a side of the layer formed by microphase separation of the block copolymer opposite to a side where the organic semiconductor layer is provided.

8. The organic thin-film transistor according to claim 7, wherein the underlayer includes a random polymer having a monomer component which is the same as a monomer component constituting the block copolymer, as a constituent component.

9. The organic thin-film transistor according to claim 8, wherein the random polymer in the underlayer has a cross-linked structure.

10. The organic thin-film transistor according to any one of claims 1 to 9, wherein the microphase separation is lamellar phase separation.

11. The organic thin-film transistor according to claim 10, wherein the pitch size of the lamellar phase separation is 20 nm or less.

12. The organic thin-film transistor according to any one of claims 1 to 11, wherein the dispersity of the block copolymer is 1.20 or less.

13. The organic thin-film transistor according to any one of claims 1 to 12, wherein the number average molecular weight of the block copolymer is 25000 or less.

14. The organic thin-film transistor according to any one of claims 1 to 12, wherein the number average molecular weight of the block copolymer is 20000 or less.

15. The organic thin-film transistor according to any one of claims 1 to 14, wherein the block copolymer is at least one block copolymer selected from a styrene-(meth)acrylate ester block copolymer, a styrene-(meth)acrylate block copolymer, a styrene-dialkylsiloxane block copolymer, a styrene-alkylarylsiloxane block copolymer, a styrene-diarylsiloxane block copolymer, a styrene-silsesquioxane-substituted alkyl (meth)acrylate block copolymer, a (meth)acrylate ester-silsesquioxane-substituted alkyl (meth)acrylate block copolymer, a styrene-vinylpyridine block copolymer, a styrene-hydroxystyrene block copolymer, a styrene-ethylene oxide block copolymer, and a vinylnaphthalene-(meth)acrylate ester block copolymer.

**16.** The organic thin-film transistor according to any one of claims 1 to 14, wherein the block copolymer includes a block formed of a repeating unit represented by the following Formula (I) and a block formed of a repeating unit represented by the following Formula (II),

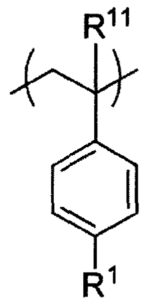

(I)

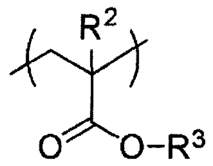

(II)

in Formula (I), $R^1$ represents a hydrogen atom, an alkyl group, an alkenyl group, an alkynyl group, a cycloalkyl group, an aryl group, or an aralkyl group, and $R^{11}$ represents a hydrogen atom or an alkyl group, and
in Formula (II), $R^2$ represents a hydrogen atom, an alkyl group, or a cycloalkyl group, and $R^3$ represents an alkyl group or a cycloalkyl group.

**17.** The organic thin-film transistor according to claim 16, wherein the block formed of the repeating unit represented by Formula (II) is a block formed of a repeating unit represented by any of the following Formulae (II-1), (II-2), and (II-3),

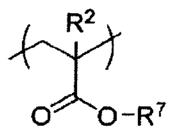

(II-1)

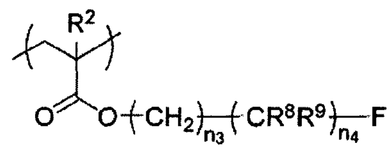

(II-2)

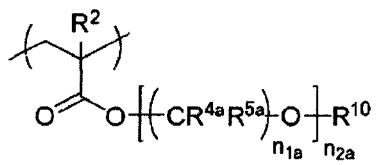

(II-3)

in Formulae (II-1), (II-2), and (III-3), $R^2$ has the same definition as that for $R^2$ in Formula (II), $R^{4a}$ and $R^{5a}$ represent a hydrogen atom or a methyl group, $R^7$ represents an unsubstituted alkyl group having 1 to 12 carbon atoms or an unsubstituted cycloalkyl group having 3 to 12 carbon atoms, $R^8$ and $R^9$ represent a hydrogen atom or a fluorine atom and at least one of $R^8$ or $R^9$ represents a fluorine atom in this case, $R^{10}$ represents a hydrogen atom, an alkyl group, a cycloalkyl group, or an aryl group, $n_{1a}$ represents an integer of 2 to 4, $n_{2a}$ represents an integer of 1 to 6, $n_3$ represents 1 or 2, and $n_4$ represents an integer of 1 to 8.

**18.** The organic thin-film transistor according to claim 16 or 17, wherein an absolute value of a difference between an SP value of the repeating unit represented by Formula (I) and an SP value of the repeating unit represented by Formula (II) is in a range of 0.5 $MPa^{1/2}$ to 4.0 $MPa^{1/2}$.

**19.** The organic thin-film transistor according to any one of claims 15 to 18,

wherein the block copolymer includes a crosslinkable group-containing monomer component, and
the block copolymer in the microphase separation layer has a cross-linked structure.

FIG. 1A

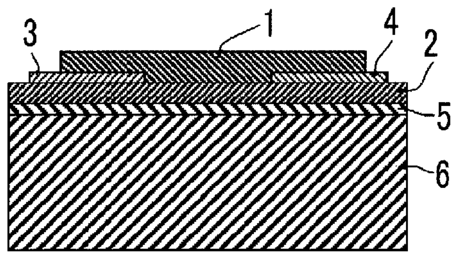


FIG. 1B

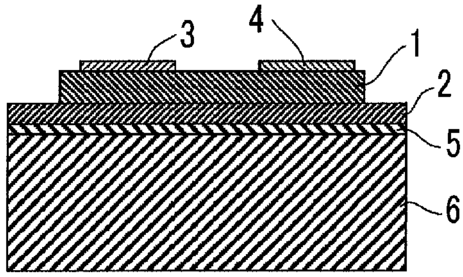


FIG. 1C

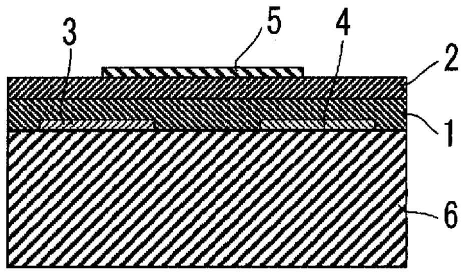


FIG. 1D

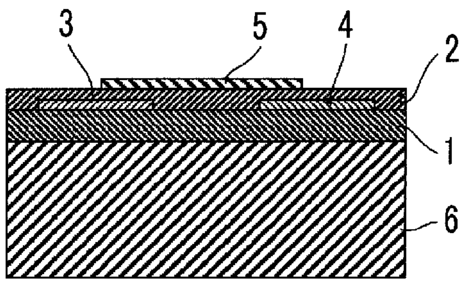

## INTERNATIONAL SEARCH REPORT

International application No.
PCT/JP2015/055709

A. CLASSIFICATION OF SUBJECT MATTER
*H01L29/786*(2006.01)i, *H01L21/312*(2006.01)i, *H01L21/336*(2006.01)i, *H01L51/05*(2006.01)i, *H01L51/30*(2006.01)i

According to International Patent Classification (IPC) or to both national classification and IPC

B. FIELDS SEARCHED

Minimum documentation searched (classification system followed by classification symbols)
H01L29/786, H01L21/312, H01L21/336, H01L51/05, H01L51/30

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2009-522802 A (Technion Research & Development Foundation Ltd.), 11 June 2009 (11.06.2009), paragraphs [0055] to [0111]; fig. 3 to 16<br>& US 2009/0008634 A1 & WO 2007/080575 A1<br>& EP 1977462 A1 & CN 101401224 A<br>& KR 10-2009-0034791 A | 1-3,7,10-18<br>4-6,8,9,19 |
| A | JP 2007-208255 A (International Business Machines Corp.), 16 August 2007 (16.08.2007), claims<br>& US 2007/0175859 A1 & US 2009/0297778 A1<br>& CN 101013662 A & TW 200802421 A | 1-19 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 14 May 2015 (14.05.15) | 26 May 2015 (26.05.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (July 2009)

INTERNATIONAL SEARCH REPORT

International application No.
PCT/JP2015/055709

C (Continuation). DOCUMENTS CONSIDERED TO BE RELEVANT

| Category* | Citation of document, with indication, where appropriate, of the relevant passages | Relevant to claim No. |
|---|---|---|
| A | JP 2001-189466 A (Toshiba Corp.), 10 July 2001 (10.07.2001), claims (Family: none) | 1-19 |
| A | JP 2006-179905 A (Palo Alto Research Center Inc.), 06 July 2006 (06.07.2006), claims & US 2006/0131563 A1 | 1-19 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008258610 A
- JP 2012036078 A
- JP 2009067999 A
- JP 2013214649 A
- JP 2011186069 A
- JP 2010285518 A
- JP 2012163946 A
- JP 2005354012 A
- JP 2006303465 A
- WO 2009148016 A
- JP 2014040901 A


### Non-patent literature cited in the description


- *Int. J. Thermophys,* 2008, vol. 29, 568-585
- *Japan Society of Applied Physics Molecular Electronics an Bioelectronics Journal,* 2011, vol. 22, 9-12